(19) Europäisches Patentamt
European Patent Office
Office européen des brevets

(11) EP 1 193 553 A2

(12) **EUROPEAN PATENT APPLICATION**

(43) Date of publication:
**03.04.2002 Bulletin 2002/14**

(51) Int Cl.[7]: **G03F 1/14**, G03F 7/20

(21) Application number: **01123043.0**

(22) Date of filing: **26.09.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **27.09.2000 JP 2000293784**

(71) Applicant: **MITSUBISHI DENKI KABUSHIKI KAISHA**
**Tokyo 100-8310 (JP)**

(72) Inventors:
- **Kitayama, Toyoki**
**Chiyoda-ku, Tokyo 100-8310 (JP)**
- **Itoga, Kenji**
**Chiyoda-ku, Tokyo 100-8310 (JP)**
- **Marumoto, Kenji**
**Chiyoda-ku, Tokyo 100-8310 (JP)**
- **Fujino, Atsuko**
**Chiyoda-ku, Tokyo 100-8310 (JP)**
- **Kumada, Teruhiko**
**Chiyoda-ku, Tokyo 100-8310 (JP)**

(74) Representative: **Sajda, Wolf E., Dipl.-Phys. et al**
**MEISSNER, BOLTE & PARTNER**
**Postfach 86 06 24**
**81633 München (DE)**

(54) **Exposure method, exposure apparatus, x-ray mask, semiconductor device and microstructure**

(57) An exposure method, an exposure apparatus, an X-ray mask and a resist for achieving enhanced resolution and throughput compared with those having been accomplished are provided and further a semiconductor device and a microstructure manufactured by using them are provided. According to the exposure method, X rays (2) emitted from an X-ray source (1) are radiated to a resist film (10) via an X-ray mask (8). A material constituting the resist film (10) is selected to have an average wavelength of X rays absorbed by the resist film (10) that is equal to or smaller than an average wavelength of X rays (2) radiated to the resist film (10).

FIG.1

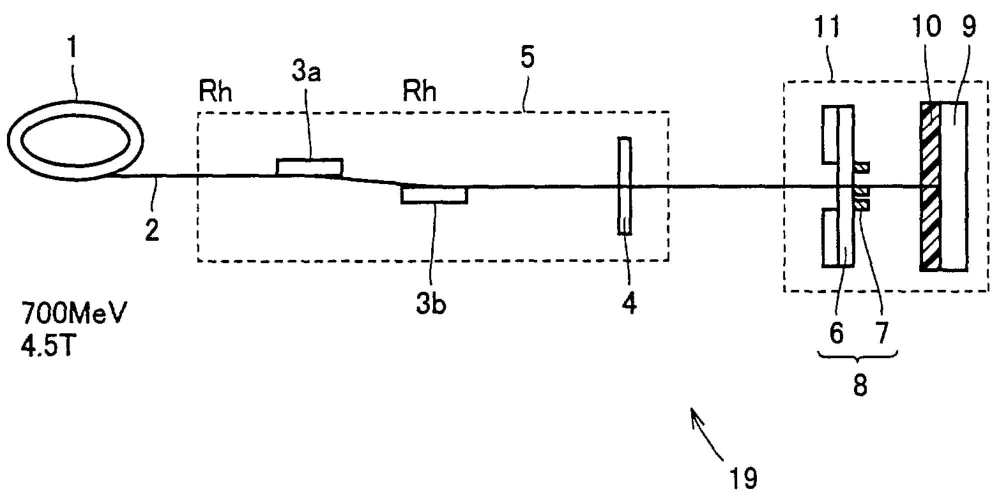


EP 1 193 553 A2

## Description

### BACKGROUND OF THE INVENTION

#### Field of the Invention

The present invention relates to an exposure method, an exposure apparatus, an X-ray mask, a resist, a semiconductor device, and a microstructure. In particular, the invention relates to an exposure method, an exposure apparatus, an X-ray mask, and a resist that use X rays to achieve enhancement in resolution and throughput, and relates to a semiconductor device and a microstructure produced by means of them.

#### Description of the Background Art

In recent years, with growing demands for higher integration and finer scale of semiconductor devices, the need to form finer patterns of semiconductor integrated circuits has been increasing. Then, an X-ray exposure technique is attracting attention that uses, for exposure light in a lithography process, X rays having a shorter wavelength than that of the conventionally employed exposure light.

Fig. 41 is a road map showing a summary of lithography techniques applied to respective design rule generations particularly concerning the lithography technique (source: International Technology Road Map for Semiconductors; (1999) p. 154, International SEMATECH). Referring to Fig. 41, the vertical axis indicates design rule (in nm) and the horizontal axis indicates year (year of grace). Fig. 41 shows, regarding technology applied to each design rule, the period of study on the technology and when the technology will be put into a practical use. The road map shown in Fig. 41 was defined in collaboration between semiconductor device industries in the United States, Europe, Japan, Korea and Taiwan. Referring to Fig. 41, XRL applied to the design rules of 100 nm and 70 nm corresponds to the X-ray exposure technique mentioned above. It is seen from Fig. 41 that the semiconductor device industries have a common understanding that the X-ray exposure technique is applicable to the design rule of approximately up to 70 nm.

A structure of an X-ray exposure apparatus having been studied is shown in Fig 42. Fig. 42 schematically shows the conventional X-ray exposure apparatus. Referring to Fig. 42, the X-ray exposure apparatus includes a synchrotron radiation source 101 for radiating light including X rays, an X-ray mirror 103 for removing a short-wavelength region component of the radiated light, a window 104 made of beryllium for removing a long-wavelength region component, and a stepper including an X-ray mask 108 and a vertical XY stage on which a semiconductor wafer 109 is mounted. A beam line 105 including X-ray mirror 103 and window 104 conveys the radiated light. X-ray mask 108 includes a membrane 106 and an X-ray absorber 107 which is mounted on the membrane 106 and on which a circuit pattern to be transferred is formed.

The light generated from synchrotron radiation source 101 passes through X-ray mirror 103 and window 104 made of beryllium to reach X-ray mask 108. The radiated light then passes through X-ray mask 108 to cause the circuit pattern formed on X-ray absorber 107 to be transferred to a resist 110 applied onto semiconductor wafer 109.

For this conventional X-ray exposure apparatus, it has been considered to use X rays having a wavelength longer than $7 \times 10^{-10}$ m (0.7 nm) as exposure light. One reason why use of the X rays in this wavelength region has been considered is that candidates for the material for membrane 106 of X-ray mask 108 are conventionally boron-doped silicon (B-doped Si), silicon nitride (SiN), silicon carbide (SiC) and the like that are materials containing silicon. In other words, silicon has an absorption edge of approximately $7 \times 10^{-10}$ m and accordingly the membrane containing silicon exhibits a low transmission factor for X rays in the wavelength region shorter than $7 \times 10^{-10}$ m.

Then, the conventional X-ray exposure apparatus cuts off X rays in the wavelength region shorter than $7 \times 10^{-10}$ m in order to obtain X rays of $7 \times 10^{-10}$ m or longer. X rays are cut off by a method for example using an X-ray mirror made of gold, platinum or the like and having an incident angle of at least 88° to reflect X rays, or using an X-ray mirror made of silicon carbide (SiC) and having an incident angle of approximately 89° to reflect X rays.

Moreover, X rays in a long-wavelength region that are not used for X-ray exposure are usually cut off by a beryllium (Be) film for example. It is proposed to use supplementary means like a thermal elimination filter and a protection film for preventing oxidation of the beryllium film. Proposed materials for the thermal elimination filter and protection film are silicon nitride (SiN) and diamond thin film.

For a material constituting window 104, beryllium, silicon nitride and diamond for example are proposed as described above. Further, for a material constituting an X-ray reflection surface of the X-ray mirror, gold, platinum, silicon carbide and molten quartz for example are proposed. These materials are employed on the precondition that X rays having a wavelength of $7 \times 10^{-10}$ m or longer (peak wavelength: approximately $8 \times 10^{-10}$ m) are used as exposure light. Fig. 43 shows spectra of exposure light for conventional representative X-ray exposure systems. Specifically, Fig. 43 is a graph showing spectra of exposure light directed onto a resist surface in conventional representative X-ray exposure systems (graph showing a relation between radiation intensity and wavelength for each wavelength of exposure light). It is seen that for each of systems A, B and C, X rays (exposure light) radiated onto the resist surface have a peak wavelength of at least $7 \times 10^{-10}$ m. The conventional X-ray exposure systems are detailed by Hiroaki Sumitani in "X-ray Exposure System," Electronic Materials, supplementary volume, November 1997, pp. 76-82.

The inventor of the present invention has found that an exposure process with a resolution higher than conventionally obtained ones is achieved by using an X-ray mirror material having a high reflectance for a shorter wavelength region than the region which has been employed as well as a membrane material for an X-ray mask having a high transmission factor for the short-wavelength region, and accordingly filed a patent application, Japanese Patent Laying-Open No. 2000-338299 relevant to the present application (2000-338299 application is hereinafter referred to as relevant application).

Fig. 44 shows a relation between intensity of X rays radiated to a resist and wavelength (spectrum of X rays radiated to the resist) for an X-ray exposure apparatus described in the relevant application. Fig. 44 also shows a spectrum of X rays radiated to a resist for a comparative X-ray exposure apparatus. Fig. 44 is thus a graph showing a relation between intensity of X rays radiated to a resist and wavelength for each of the X-ray exposure apparatus described in the relevant application and the comparative X-ray exposure apparatus.

Data shown in Fig. 44 are obtained through simulation on the following preconditions. The X-ray exposure apparatuses for Fig. 44 are similar in basic structure to the exposure apparatus shown in Fig. 42. Conditions common to both data are that acceleration energy of the synchrotron radiation source is 700 MeV, deflection magnetic field intensity is 4.5 T, critical wavelength of radiated light is $8.46 \times 10^{-10}$ m, peak wavelength is $3.5 \times 10^{-10}$ m, thickness of the window made of beryllium is 18 μm, two X-ray mirrors are used and the incident angle of X rays to X-ray mirrors is 89°. For the X-ray exposure apparatus described in the relevant application, rhodium (Rh) is used as a material for a surface of the X-ray mirror reflecting X rays (reflection surface) and diamond is used as a material for the membrane. For the comparative X-ray exposure apparatus (indicated by SiC, SiC 8.51 98.7 in Fig. 44), silicon carbide (SiC) is used as a material for the reflection surface of the X-ray mirror and silicon carbide (SiC) is also used as a material for the membrane, and the membrane of SiC is 2 μm in thickness.

Data indicated by Rh, Dia, 5.83 211.1 in Fig. 44 is for the X-ray exposure apparatus described in the relevant application. Here, Rh means that the surface of the X-ray mirror reflecting X rays (reflection surface) is constituted of rhodium (Rh), and Dia means that the membrane of the X-ray mask is made of diamond. The membrane has a thickness of 4 μm. 5.83 represents that X rays directed to the resist have an average wavelength of $5.83 \times 10^{-10}$ m, and 211.1 represents that X rays directed to the resist have a total intensity of 211.1 (A.U).

It is seen from Fig. 44 that X rays of $7 \times 10^{-10}$ m or longer in wavelength are radiated to the resist by the comparative X-ray exposure apparatus while X rays up to approximately $4 \times 10^{-10}$ m are radiated to the resist by the X-ray exposure apparatus described in the relevant application. As shown in Fig. 44, the average wavelength of X rays radiated to the resist by the comparative X-ray exposure apparatus is $8.51 \times 10^{-10}$ m while that is $5.83 \times 10^{-10}$ m for the X-ray exposure apparatus of the relevant application as described above. In other words, the X-ray exposure apparatus disclosed in the relevant application could enhance the resolution of a transferred pattern by the percentage (about 68.5%) of the shortened average wavelength of radiated X rays relative to the longer average wavelength of the comparative X-ray exposure apparatus.

However, the inventor has found through a further study that the resolution is not enhanced exactly by such a percentage of the shortened average wavelength of the radiated X rays for the reasons as described below.

As detailed later, a main factor determining the resolution of a transferred pattern is not the resolution of an optical image of X rays radiated to the resist but the resolution of an optical image of X rays absorbed by the resist. All of the X rays radiated to the resist are not absorbed by the resist. Then, if X rays having a shorter wavelength are radiated to the resist while X rays actually absorbed by the resist do not have a shorter wavelength, it would be difficult to surely enhance the resolution of the transferred pattern. For a more detailed explanation of this, a spectrum of X rays absorbed by the resist is determined through simulation for each of two apparatuses as shown in Fig. 45. Fig. 45 is a graph showing a relation between intensity of X rays absorbed by the resist and wavelength for each of the X-ray exposure apparatus of the relevant application and the comparative X-ray exposure apparatus. The simulation shown in Fig. 45 is conducted on the precondition that PMMA ($C_5H_8O_2$) is used for the resist. PMMA is used as a representative material for a conventional organic resist composed of carbon, oxygen, nitrogen, hydrogen and the like. It is noted that the data shown in Fig. 45 are shown basically in a similar method to that of Fig. 44.

Referring to Fig. 45, X rays absorbed by the resist of the X-ray exposure apparatus described in the relevant application have an average wavelength of $6.93 \times 10^{-10}$ m while that of the comparative X-ray exposure apparatus is $9.16 \times 10^{-10}$ m. Namely, for both X-ray exposure apparatuses, the average wavelength of X rays absorbed by the resist shown in Fig. 45 is longer than that radiated to the resist shown in Fig. 44. Moreover, the wavelength of X rays absorbed by the resist of the X-ray exposure apparatus of the relevant application is shorter than that of the comparative X-ray exposure apparatus by the degree smaller than the degree by which the wavelength of X rays radiated to the resist of the X-ray exposure apparatus of the relevant application is shorter than that of the comparative X-ray exposure apparatus. It is accordingly understood that the resolution is enhanced by a smaller degree than that expected on the basis of the average wavelength of X rays radiated to the resist.

The X rays radiated to the resist of the X-ray exposure apparatus of the relevant application have a shorter average wavelength and a higher total intensity than those of the conventional comparative X-ray exposure apparatus. When X rays in a short-wavelength region are used as exposure light, generally shorter wavelength provides higher transmittance and smaller amount of X rays absorbed by the resist. Then, as shown in Fig. 45, the total intensity of X rays absorbed by the resist of the X-ray exposure apparatus of the relevant application is 9.01 while that of the comparative X-ray exposure apparatus is 10.82. Namely, the X-ray exposure apparatus of the relevant application is lower than the comparative X-ray exposure apparatus in total intensity of X rays absorbed by the resist. Such a reduction of total intensity leads to a longer time (exposure time) required for obtaining a necessary exposure amount. Consequently, the throughput of the exposure process decreases. In addition, the reduction of total intensity also leads to reduction in X-ray sensitivity of the resist.

SUMMARY OF THE INVENTION

One object of the present invention is to provide an exposure method, an exposure apparatus, an X-ray mask and a resist to achieve enhancement in resolution and throughput, as well as a semiconductor device and a microstructure manufactured by means of them.

According to an exposure method in a first aspect of the present invention, X rays emitted from an X-ray source are radiated to a resist film via an X-ray mask. A material constituting the resist film is selected to allow an average wavelength of X rays absorbed by the resist film to be equal to or smaller than an average wavelength of X rays radiated to the resist film.

The inventor has attained the present invention through studies on photoreaction mechanism of the resist in an X-ray exposure process as discussed below. The resist reacts to high energy radiation such as X rays. Here, a direct reaction of any chemical component of the resist to the radiation is not predominant in the entire exposure process, which is different from an ordinary radiation exposure process. When the resist reacts to the high energy radiation like X rays, the high energy radiation to the resist causes components of the resist to generate photoelectrons, Auger electrons, secondary radiation and the like. The chemical component of the resist then reacts to the secondary energy of the photoelectrons and the like, which is predominant in the exposure process. In other words, in this mechanism, the chemical component does not directly react to the high energy radiation by internal excitation, and the chemical component of the resist reacts to the secondary energy of photoelectrons and the like as described above. Accordingly, for the exposure by ordinary radiation, the chemical component directly reacts to the radiation and thus there is a wavelength selectivity for the exposure radiation. For the exposure process by the high energy radiation such as X rays, there is almost no such a wavelength selectivity.

In the exposure process by high energy radiation, the amount of secondary energy is determined by the amount of energy absorbed by the resist. Namely, what is directly involved in formation of pattern on the resist is not the wavelength spectrum of radiation to the resist, but the amount of energy of X rays radiated to and absorbed by the resist. (The resolution of a transferred pattern could be governed by the wavelength of X rays, among X rays radiated to the resist, in a wavelength region absorbed by the resist by the greatest amount as well as the amount of absorbed energy. A greater amount of energy absorbed by the resist provides a higher sensitivity of the resist.)

Then, the resolution of a pattern transferred to the resist by X-ray exposure can be enhanced by allowing the resist to selectively absorb X rays in short wavelength region among X rays radiated to the resist in the exposure process by X rays and thus using X rays in short wavelength region to achieve exposure with high sensitivity. Specifically, an average wavelength of X rays absorbed by the resist is made equal to or smaller than an average wavelength of X rays radiated to the resist. Consequently, a higher resolution of the transfer pattern can be obtained compared with that obtained by radiating X rays of the same spectrum to the resist.

According to an exposure method in a second aspect of the present invention, X rays emitted from an X-ray source are radiated to a resist film via an X-ray mask. A material constituting the resist film is selected to include an element having an absorption edge in a region of wavelength of X rays radiated to the resist film.

Then, the element included in the resist film chiefly absorbs X rays in a region of wavelength shorter than that of the absorption edge. X rays among those radiated to the resist film that are in short wavelength region can selectively be absorbed by the resist film. Consequently, exposure with high sensitivity by using X rays in short wavelength region is possible so that the resolution of a pattern transferred to the resist film by X-ray exposure can be improved.

According to the exposure method in the second aspect, preferably the wavelength region in which the absorption edge of the element is present is from $2 \times 10^{-10}$ m to $7 \times 10^{-10}$ m.

In this case, X rays in a short wavelength region having a wavelength shorter than about 0.75 nm ($7.5 \times 10^{-10}$ m) which is employed by the conventional X-ray exposure can be absorbed by the resist so that an improved resolution can be possible of a pattern transferred to the resist. The reason why the range of the wavelength is from $2 \times 10^{-10}$ m to $7 \times 10^{-10}$ m is as follows. When the wavelength of X rays is shorter than $2 \times 10^{-10}$ m, the sensitivity of the resist to X rays deteriorates and transmittance of an X-ray absorber of the X-ray mask for X-ray increases so that contrast of the pattern transferred to the resist film deteriorates. In order to achieve a higher resolution and a higher throughput than conventional ones, it would be effective to use X rays in the region of wavelength shorter than $7 \times 10^{-10}$ m, instead of the conventional wavelength region exceeding $7 \times 10^{-10}$ m. Moreover, according to the exposure method in the second aspect, more preferably the wavelength region in which the absorption edge of the element is present is from $2 \times 10^{-10}$ m to $6 \times 10^{-10}$ m. Still more preferably, the wavelength region is from $3 \times 10^{-10}$ m to $5 \times 10^{-10}$ m.

According to the exposure method in the first or second aspect of the invention, the X rays emitted from the X-ray source may be reflected by an X-ray mirror and thereafter radiated to reach the resist film. Preferably, a material constituting a surface of the X-ray mirror that reflects the X rays includes at least one selected from the group consisting of beryllium (Be), titanium (Ti), silver (Ag), ruthenium (Ru), rhodium (Rh), palladium (Pd), iron (Fe), cobalt (Co), nickel (Ni), copper (Cu), manganese (Mn), chromium (Cr), hafnium (Hf), tantalum (Ta), tungsten (W), rhenium (Re), osmium (Os), iridium (Ir), alloys, nitrides, carbides and borides of foregoing elements, diamond, diamond like carbon, and boron nitride.

In this case, use of such an X-ray mirror makes it possible to obtain X rays in a region of wavelength equal to or less than $7 \times 10^{-10}$ m which is shorter than the conventional one. An enhanced resolution of a transferred pattern can thus be ensured as the X rays in the short wavelength region are radiated to the resist film.

According to the exposure method in the first or second aspect of the invention, the X rays emitted from the X-ray source may be reflected by an X-ray mirror and thereafter radiated to reach the resist film. Preferably, a material constituting a surface of the X-ray mirror that reflects the X rays includes one selected from the group consisting of gold (Au), platinum (Pt) and alloy of them. The angle of incidence of X rays on the reflection surface of the X-ray mirror is preferably at least 89°.

In this case, gold may be used for the material constituting the surface of the X-ray mirror reflecting X rays (reflection surface) and the angle of incidence of 89° may be used to allow X rays to be emitted from the X-ray mirror, the X rays being in a region of wavelength equal to or shorter than $7 \times 10^{-10}$ m which is shorter than the conventional one. Accordingly, X rays having shorter wavelength than the conventional one can be radiated to the resist film and the resolution of the transferred pattern can surely be enhanced.

According to the exposure method in the first or second aspect of the invention, the X-ray mask may include a membrane and an X-ray absorber film formed on the membrane. Preferably, the membrane includes diamond or boron nitride.

In this case, the diamond and boron nitride have a superior transmitting property for X rays in short wavelength region such as the one equal to or smaller than $7 \times 10^{-10}$ m. Then, such X rays in the short wavelength region can be radiated surely to the resist. In other words, X rays in the short wavelength region can effectively be used to improve the throughput of the exposure process. In addition, as the diamond and boron nitride have a sufficient rigidity which contributes to improvement in accuracy of a transfer pattern of the X-ray mask.

According to the exposure method in the first or second aspect of the invention, the X-ray mask may include a membrane and an X-ray absorber film formed on the membrane. Preferably, the resist film includes silicon (Si), the X-ray absorber film includes tungsten (W) or tantalum (Ta), and the membrane includes diamond.

In this case, the resist film includes silicon having X-ray absorption peak in short wavelength region equal to or smaller than $7 \times 10^{-10}$ m so that X rays in the short wavelength region can surely be absorbed by the resist film. The X rays in the short wavelength region can effectively be used for the exposure process to surely enhance the resolution of the transfer pattern.

The membrane material as described above has a sufficiently smaller absorptivity for X rays in short wavelength region than that for X rays in long wavelength region. Then, the membrane material can be selected as described above to reduce the amount of X rays in the short wavelength region absorbed by the membrane so that the throughput of the exposure process can be improved.

In addition, materials for the membrane, X-ray absorber film and resist can be selected as described above to improve the contrast of the pattern transferred to the resist. With a required contrast maintained, the thickness of the X-ray absorber film can be reduced as compared with a combination of materials other than those described above. The aspect ratio of the transfer pattern on the X-ray absorber film of the X-ray mask can be decreased. As a result, it is possible to prevent defect in a pattern formed by etching of the X-ray absorber film and improve dimension accuracy of the pattern. Accordingly the accuracy of the pattern transferred to the resist film can be improved.

The materials for the membrane and the like described above have proven performances for film deposition and etching processes and the X-ray mask can thus be produced easily with a high accuracy.

According to the exposure method in the first or second aspect, preferably the X rays emitted from the X-ray source are transmitted through at least one filter made of beryllium before radiated to reach the resist film. The total thickness of the filter in the direction of travel of the X rays is preferably at least 50 μm.

For a conventional X-ray exposure apparatus, beryllium is used as vacuum partition (window transmitting X rays for separation of ultra-high vacuum and exposure ambient in a beam line where a synchrotron radiation source and X-ray mirrors are provided). For the beryllium used as the vacuum partition, it has been considered preferable to make the thickness of the beryllium film as thin as possible for the purpose of reducing attenuation of X rays. Then, the conventional beryllium film (beryllium window) is approximately 20 μm in thickness. However, the inventor has confirmed that an increased thickness of the beryllium film can shorten the average wavelength of X rays radiated to the resist. In other words, according to the present invention, the thickness of the beryllium film is particularly increased to shorten the average wavelength of X rays radiated to the resist. Then, X rays in short wavelength region can surely be used for the exposure process. The thickness of the beryllium window serving as the vacuum partition may be increased to 50 μm or greater or another filter formed of a beryllium film may be provided to transmit X rays therethrough in addition to the beryllium window. In this case, the effects described above can be achieved if the sum of the thickness of the beryllium window and the thickness of the additional filter is at least 50 μm.

According to the exposure method in the first or second aspect, preferably the X rays emitted from the X-ray source are transmitted through at least one filter made of beryllium before being radiated to reach the resist film. The X-ray mask preferably includes a membrane including diamond and an X-ray absorber film formed on the membrane. Preferably, the sum of the thickness of the filter in the direction of travel of the X rays and the thickness of the membrane multiplied by 10 is at least 50 μm.

When the total thickness of the filter made of beryllium is 50 μm or greater, X rays in the short wavelength region can surely be radiated to the resist. In addition, when the thickness of the membrane is 5 μm or greater, X rays in the short wavelength region can also be radiated to the resist. Here, the thickness of the membrane is multiplied by 10 to use the resultant value as an evaluation value of the membrane. Then, the influence of the evaluation value of the membrane on the average wavelength of X rays absorbed by the resist and the influence of the thickness of the filter on the average wavelength of X rays absorbed by the resist are almost equivalent to each other, supposing that other conditions are the same. When an exposure apparatus includes a filter made of beryllium and an X-ray mask having a membrane containing diamond, X rays in the short wavelength region can surely be used for exposure by satisfying the conditions above.

According to an exposure method in a third aspect of the invention, X rays emitted from an X-ray source are radiated to a resist film via an X-ray mask. The X-ray mask includes a membrane and an X-ray absorber film formed on the membrane. A material constituting the resist and a material constituting the membrane are selected to allow absorption peak wavelength of X rays absorbed by the resist film to be smaller than absorption peak wavelength of X rays absorbed by the material constituting the membrane.

In this way, it is possible to efficiently absorb X rays in the short wavelength region by the resist film, among X rays transmitted through the membrane of the X-ray mask to be radiated to the resist film. Namely, the X rays in the short wavelength region can surely be used as exposure light so that the resolution of a transferred pattern can be improved.

According to the exposure method in the third aspect, the X rays emitted from the X-ray source may be transmitted through at least one filter before being radiated to reach the resist film. A material constituting the filter may be selected to allow absorption peak wavelength of X rays absorbed by the resist film to be smaller than absorption peak wavelength of X rays absorbed by the material constituting the filter.

In this case, it is possible to efficiently absorb X rays in the short wavelength region by the resist film, among X rays transmitted through the filter to be radiated to the resist film. Namely, the X rays in the short wavelength region can surely be used as exposure light so that the resolution of a transferred pattern can be improved and the throughput of the exposure process can be enhanced.

According to the exposure method in the third aspect, the filter may include beryllium and the total thickness of the filter in the direction of travel of the X rays is preferably at least 50 μm.

As explained above, the thickness of the filter containing beryllium can be increased to shorten the average wavelength of X rays radiated to the resist film. Then, according to the present invention, the beryllium is particularly increased in thickness to shorten the average wavelength of X rays radiated to the resist so that X rays in the short wavelength region can surely be used for the exposure process. One filter or a plurality of filters may be used if the total thickness is at least 50 μm to achieve similar effects.

According to the exposure method in the third aspect, the X rays may be transmitted through a transmission film including diamond or boron nitride before radiated to the resist. The material constituting the membrane preferably includes diamond or boron nitride and the sum of the thickness of the transmission film and the thickness of the membrane in the direction of travel of the X rays is preferably at least 5 μm.

In order to have the average wavelength of X rays absorbed by the resist that is included in a region of wavelength shorter than the conventional one, the thickness of the membrane including the diamond or boron nitride is effectively at least 5 μm as discussed above. In this case, similar effects can be obtained by transmitting the X rays radiated to the resist through the film having a thickness of at least 5 μm and including diamond or boron nitride. Accordingly, the membrane and the transmission film can be constituted to include diamond or boron nitride as described above having the total thickness of at least 5 μm, and thus X rays in the short wavelength region can surely be used for exposure. It is merely required that the total thickness satisfies the condition above. Then, the degree of freedom in setting the thicknesses of the membrane and transmission film can be extended. (For example, if a desirable thickness of the transmission film is small, the thickness of the membrane may be increased accordingly by a corresponding thickness.) Consequently, the structure of the exposure apparatus can have an expanded degree of freedom.

According to the exposure method in the third aspect, the X rays emitted from the X-ray source may be reflected by an X-ray mirror and thereafter radiated to reach the resist film. A material constituting a surface of the X-ray mirror that reflects the X rays may be selected to allow absorption peak wavelength of X rays absorbed by the resist film to be smaller than absorption peak wavelength of X rays absorbed by the material constituting the X-ray reflection surface of the X-ray mirror.

In this case, the resist can efficiently absorb X rays, among X rays reflected by the X-ray reflection surface of the X-ray mirror, in the short wavelength region less absorbed by the reflection surface and shorter than wavelength of absorption peak at the reflection surface of the X-ray mirrors. Namely, X rays in the short wavelength region can surely be used as exposure light to enhance the resolution of a transferred pattern.

According to the exposure method in the third aspect, a material constituting the surface of the X-ray mirror that reflects the X rays may include at least one selected from the group consisting of beryllium, titanium, silver, ruthenium, rhodium, palladium, iron, cobalt, nickel, copper, manganese, chromium, hafnium, tantalum, tungsten, rhenium, osmium, iridium, alloys, nitrides, carbides, borides of foregoing elements, diamond, diamond like carbon and boron nitride.

In this case, use of such a material for the X-ray mirror makes it possible to obtain X rays in a region of wavelength equal to or less than $7 \times 10^{-10}$ m which is shorter than the conventional one. An enhanced resolution of a transferred pattern can thus be ensured as the X rays in the short wavelength region are radiated to the resist film.

According to the exposure method in the third aspect, the material constituting the X-ray reflection surface of the X-ray mirror may include one selected from the group consisting of gold, platinum and alloys thereof. Preferably, the angle of incidence of X rays on the X-ray reflection surface of the X-ray mirror is at least 89°.

The X-ray mirror having the reflection surface made of gold and the like can be used under the condition that the incident angle is 89° or greater so that the average wavelength of X rays radiated to the resist can be decreased to be in a region of short wavelength equal to or smaller than $7 \times 10^{-10}$ m. In addition, the great incident angle of 89° can increase the intensity of X rays emitted from the X-ray mirror. Accordingly, the throughput of the exposure process can be improved.

According to the exposure method in the third aspect, preferably a material constituting the resist film and a material constituting the X-ray absorber film are selected to have absorption peak wavelength of X rays absorbed by the resist film that is located in a wavelength region where absorption peak of X rays absorbed by the material constituting the X-ray absorber film is present.

Here, the X-ray absorber film of the X-ray mask should surely absorb X rays involved in exposure. As described above, absorption peak of X rays absorbed by the resist film and absorption peak of X rays absorbed by the material constituting the X-ray absorber film are in the same wavelength region. (Respective wavelength regions of resist-absorbed X rays and X-ray absorber film-absorbed X rays respectively with a relatively high intensity in which respective peak wavelengths are included partially or totally overlap.) Then, X rays in the wavelength region to be used for the exposure process (X rays in the wavelength region nearly the same as that including chief absorption peak wavelength of the material included in the resist film) can surely be absorbed by the X-ray absorber film and thus the contrast of transferred pattern to the resist can be enhanced.

If the peak wavelength of X rays absorbed by the X-ray absorber film is present in a wavelength region which is absolutely different from that of peak wavelength of X rays absorbed by the resist film, it would be required to have a sufficiently thick X-ray absorber film for achieving a predetermined contrast. According to the present invention, the thickness of the X-ray absorber film can be decreased with a predetermined contrast maintained. As a result, etching for producing a transfer pattern on the X-ray absorber film can be simplified. Moreover, since the thickness of the X-ray absorber film can be decreased, the internal stress of the X-ray absorber film can relatively be reduced. It is then possible to prevent the X-ray mask from deforming due to the internal stress of the X-ray absorber film. The accuracy of the shape of the X-ray mask can thus be improved to enhance dimension accuracy of a transferred pattern.

According to an exposure method in a fourth aspect of the invention, X rays emitted from an X-ray source are radiated to a resist film via an X-ray mask. The X-ray mask includes a membrane and an X-ray absorber film formed on the membrane. A material constituting the resist film and a material constituting the X-ray absorber film are selected to have absorption peak wavelength of X rays absorbed by the resist film that is located in a wavelength region where absorption peak of X rays absorbed by the material constituting the X-ray absorber film is present.

X rays in the wavelength region involved in the exposure process (X rays in the wavelength region almost the same as that of chief absorption peak wavelength of the material included in the resist film) can surely be absorbed by the X-ray absorber film. Then, an enhanced contrast of the resist can be obtained.

If the peak wavelength of X rays absorbed by the X-ray absorber film is present in a wavelength region which is absolutely different from that of peak wavelength of X rays absorbed by the resist film, it would be required to have a sufficiently thick X-ray absorber film for achieving a predetermined contrast. According to the present invention, the thickness of the X-ray absorber film can be decreased with a predetermined contrast maintained. As a result, etching for producing a transfer pattern on the X-ray absorber film can be simplified. Moreover, since the thickness of the X-ray absorber film can be decreased, the internal stress of the X-ray absorber film can relatively be reduced. It is then possible to prevent the X-ray mask from deforming due to the internal stress of the X-ray absorber film. The accuracy of the shape of the X-ray mask can thus be improved to enhance dimension accuracy of a transferred pattern.

According to the exposure method in the fourth aspect, preferably a material constituting the membrane is selected to allow absorption peak wavelength of X rays absorbed by the resist film to be smaller than absorption peak wavelength of X rays absorbed by the material constituting the membrane.

In this case, the resist film can efficiently absorb X rays in short wavelength region among X rays transmitted through the membrane of the X-ray mask and radiated to the resist film. Namely, X rays in the short wavelength region can surely and efficiently be used as exposure light so that the resolution of a transferred pattern can be enhanced.

X rays (involved in exposure process) in a wavelength region almost the same as that of absorption peak wavelength of the material contained in the resist film are surely absorbed by the X-ray absorber film, while X rays transmitted through a region where the X-ray absorber film is not provided (region where only the membrane is present) and then involved in the exposure process are attenuated by a reduced extent. The contrast of X rays radiated to the resist film can thus be enhanced.

According to the exposure method in the fourth aspect, X rays emitted from the X-ray source may be reflected by an X-ray mirror and thereafter radiated to reach the resist film. Preferably, a material constituting a surface of the X-ray mirror that reflects the X rays includes at least one selected from the group consisting of beryllium, titanium, silver, ruthenium, rhodium, palladium, iron, cobalt, nickel, copper, manganese, chromium, hafnium, tantalum, tungsten, rhenium, osmium, iridium, alloys, nitrides, carbides, borides of foregoing elements, diamond, diamond like carbon and boron nitride.

In this case, use of such an X-ray mirror makes it possible to radiate to the resist film X rays in a region of short wavelength equal to or less than $7 \times 10^{-10}$ m which is shorter than the conventional one. An enhanced resolution of a transferred pattern can thus be ensured.

According to the exposure method in the fourth aspect, X rays emitted from the X-ray source may be reflected by an X-ray mirror and thereafter radiated to reach the resist film. A material constituting the X-ray reflection surface of the X-ray mirror may include one selected from the group consisting of gold, platinum and alloys thereof. Preferably, the angle of incidence of X rays on the X-ray reflection surface of the X-ray mirror is at least 89°.

The X-ray mirror having the reflection surface made of gold and the like can be used under the condition that the incident angle is 89° or greater so that X rays in a region of short wavelength equal to or smaller than $7 \times 10^{-10}$ m, which is shorter than the conventional one, can be obtained. The resolution of a transferred pattern can surely be enhanced since X rays in the region of shorter wavelength than the conventional one can be radiated to the resist film.

According to the exposure method in the first, second, third or fourth aspect, preferably the surface of the X-ray mirror reflecting X rays has a surface roughness of $6 \times 10^{-10}$ m or less by rms value.

The surface roughness of the X-ray reflection surface of the X-ray mirror defined in the numerical range above can reduce the attenuation factor of X rays due to scattering of X rays on the reflection surface. In this way, it is possible to prevent X rays in short wavelength region from attenuating due to scattering on the reflection surface and thus surely use the X rays in the short wavelength region as exposure light. Moreover, the scattering of X rays is prevented so that a required intensity of radiated X rays can be secured to prevent deterioration of the throughput of the exposure process.

According to the exposure method in the fourth aspect, the membrane may include diamond or boron nitride.

Diamond and boron nitride are excellent in transmittance for X rays in a region of short wavelength equal to or smaller than $7 \times 10^{-10}$ m. Then, such X rays in the short wavelength region can surely be radiated to the resist. In other words, the X rays in the short wavelength region can effectively be used to enhance the throughput of the exposure process. In addition, diamond and boron nitride have a sufficient rigidity so that the accuracy of a transfer pattern of the X-ray mask can also be enhanced.

According to the exposure method in the first, second, third or fourth aspect, the thickness of the membrane is preferably at least 5 μm.

In this case, X rays of a wavelength equal to or greater than $7 \times 10^{-10}$ m (X rays in long wavelength region) can sufficiently be absorbed by the membrane. On the other hand, X rays of a wavelength smaller than $7 \times 10^{-10}$ m (X rays in short wavelength region) are more likely transmitted through the membrane than the X rays in the long wavelength region. Accordingly, an average wavelength of X rays transmitted through the membrane and radiated to the resist film can be decreased. Namely, the average wavelength of X rays radiated to the resist film can surely be reduced ($7 \times 10^{-10}$ m or less). The resolution of a transferred pattern can thus be improved.

According to the exposure method in the fourth aspect, the resist film preferably includes silicon, the X-ray absorber film preferably includes tungsten or tantalum, and the membrane preferably includes diamond.

The resist film including silicon having absorption peak of X rays in a region of short wavelength equal to or smaller than $7 \times 10^{-10}$ m can surely absorb X rays in the short wavelength region. Then, the X rays in the short wavelength region can effectively be used for the exposure process to enhance the resolution of a transferred pattern.

In addition, the material for the membrane of the X-ray mask can be selected as described above to reduce the amount of X rays in short wavelength region absorbed by the membrane so that the throughput of the exposure process is enhanced.

Moreover, the materials for the membrane, X-ray absorber film and resist can be selected as described above to enhance the contrast of a pattern transferred to the resist. Then, with a required contrast maintained, the thickness of the X-ray absorber film can be decreased compared with a combination of other materials. Accordingly, the aspect ratio of a transfer pattern on the X-ray absorber film of the X-ray mask can be reduced to prevent defect of the pattern formed by etching of the X-ray absorber film in manufacturing of the X-ray absorber film and enhance the dimension accuracy of the pattern. Consequently, the accuracy of the pattern transferred to the resist film can be enhanced.

The materials discussed above have proven performances for film deposition and etching process and thus the X-ray mask can easily be fabricated with a high accuracy.

According to the exposure method in the first, second, third or fourth aspect, the resist film may include at least one element selected from the group consisting of bromine (Br), silicon (Si), phosphorus (P), sulfur (S), chlorine (C$\ell$), fluorine (F) and iodine (I).

The above elements included in the resist film particularly absorb X rays in short wavelength region among X rays radiated to the resist film. Accordingly, the average wavelength of X rays absorbed by the resist film can be decreased. Here, the wavelength of X rays absorbed by the resist is a critical factor for determination of the resolution of a pattern transferred to the resist film. Then, the transferred pattern can have an enhanced resolution.

According to the exposure method in the first, second, third, or fourth aspect, the resist film includes an element selected from the group consisting of bromine, silicon, phosphorus, sulfur, chlorine, fluorine and iodine and the total content of the element is at least 20 % by mass.

The intensity of X rays in short wavelength region absorbed by the resist film can be made sufficiently high. Then, the resolution of a transferred pattern can surely be enhanced.

According to the exposure method in the first, second, third, or fourth aspect, a solvent containing hydrocarbon having at least one selected from the group consisting of bromine, silicon, phosphorus, sulfur and chlorine may remain in the resist film.

In this case, the element absorbing X rays in short wavelength region is contained in the solvent, not in the resin constituting the resist film and accordingly the resist resin may not contain the element above. Accordingly the degree of freedom of resist design can be expanded. When X rays are radiated to the resist film, X rays in short wavelength region are absorbed by the element such as chlorine and the like in the solvent and the solvent emits photoelectrons and Auger electrons into the resist film. The secondary energy of the photoelectrons and the like causes chemical components of the resist to react to radiation. Then, exposure by means of X rays in short wavelength region can be carried out even if the element as described above is not contained in the resist resin.

According to the exposure method in the first, second, third or fourth aspect, preferably absorption peak wavelength of X rays absorbed by the resist film is $7 \times 10^{-10}$ m or smaller.

X rays in a region of wavelength exceeding $7 \times 10^{-10}$ m have been utilized for exposure. On the other hand, according to the present invention, X rays of a wavelength equal to or shorter than $7 \times 10^{-10}$ m can effectively be used as exposure light. Use of the X rays in such a wavelength region can surely enhance the resolution of a transferred pattern compared with the resolution having been accomplished.

According to an exposure method in a fifth aspect of the present invention, X rays emitted from an X-ray source are radiated to a resist film via an X-ray mask and at least one transmission film. The X-ray mask includes a membrane transmitting the X rays therethrough. A material constituting the transmission film and a material constituting the membrane include diamond or boron nitride. The sum of respective thicknesses of the transmission film and membrane in the direction of travel of the X rays is at least 5 μm.

Here, when X rays radiated to the resist film are transmitted through the film containing diamond or boron nitride and having a thickness of at least 5 μm, X rays in long wavelength region are absorbed by the film. Then, the average wavelength of X rays radiated to and absorbed by the resist film can be reduced to be included in a region of shorter wavelength than the conventional one. Accordingly, the membrane and transmission film can be structured to include diamond or boron nitride and have the total thickness of at least 5 μm so as to use X rays in short wavelength region for exposure.

When the total thickness of the membrane and the transmission film meets the above-described condition, respective thicknesses of the membrane and transmission film can arbitrarily be defined. Then, the degree of freedom for setting respective thicknesses of the membrane and transmission film can be expanded. As a result, the degree of freedom of the structure of an exposure apparatus can be increased.

According to an exposure method in a sixth embodiment of the present invention, X rays emitted from an X-ray source are radiated to a resist film via an X-ray mask and at least one filter. The filter includes beryllium and the total thickness of the filter in the direction of travel of the X rays is at least 50 μm.

The inventor has found that the thickness of a vacuum partition (window) made of beryllium and the thickness of the filter through which X rays serving as exposure light are transmitted can be increased to shorten an average wavelength of X rays radiated to the resist. Namely, according to the present invention, the thickness of beryllium is particularly increased to decrease the average wavelength of X rays radiated to the resist. Then, X rays in short wavelength region can surely be used for the exposure process. The thickness of the beryllium window serving as a vacuum partition can be increased to at least 50 μm or additional filter formed of another beryllium film may be provided to transmit X rays therethrough. In this case, the sum of respective thicknesses of the beryllium window and the additional filter can be at least 50 μm to achieve the above-described effects.

According to an exposure method in a seventh aspect of the present invention, X rays emitted from an X-ray source are radiated to a resist film via an X-ray mask and at least one filter. The filter includes beryllium. The X-ray mask includes a membrane containing diamond. The sum of the thickness of the filter and the thickness of the membrane multiplied by 10 in the direction of travel of the X rays is at least 50 μm.

As discussed above, when the total thickness of the filter made of beryllium is 50 μm or greater, X rays in the short wavelength region can surely be radiated to the resist. In addition, when the thickness of the membrane made of diamond is 5 μm or greater, X rays in the short wavelength region can also be radiated to the resist. Here, the thickness of the membrane is multiplied by 10 to use the resultant value as an evaluation value of the membrane. Then, the influence of the evaluation value of the membrane on the average wavelength of X rays radiated to the resist and the influence of the thickness of the filter on the average wavelength of X rays radiated to the resist are almost equivalent to each other. When an exposure apparatus includes a filter made of beryllium and an X-ray mask having a membrane containing diamond, X rays in the short wavelength region can surely be used for exposure by satisfying the conditions above.

According to an exposure method in an eighth aspect of the present invention, X rays emitted from an X-ray source are radiated to a resist film via an X-ray mask. A solvent containing hydrocarbon including at least one selected from the group consisting of bromine, silicon, phosphorus, sulfur and chlorine remains in the resist film.

The elements such as chlorine as described above have a high absorptivity for X rays in short wavelength region (region of wavelength equal to or smaller than $7 \times 10^{-10}$ m). Then, the resist film can contain such elements to enhance the intensity of X rays in the short wavelength region absorbed by the resist film. The average wavelength of X rays absorbed by the resist film that is a main factor determining the resolution of a transferred pattern can be decreased. Consequently, the resolution of the transferred pattern can be enhanced.

The element absorbing X rays in short wavelength region is contained in the solvent, not in the resin constituting the resist film and accordingly the resist resin may not contain the element above. Accordingly the degree of freedom of resist design can be expanded.

A semiconductor device according to a ninth aspect of the invention is manufactured by the exposure method in any of the first to the eighth aspects of the invention described above.

The exposure method providing a higher resolution of a transferred pattern than the conventional one can thus be used to obtain the semiconductor device with its structure further reduced in size. For this semiconductor device, the size can further be reduced and the integration can be improved compared with conventional ones.

A microstructure according to tenth aspect of the present invention is manufactured by the exposure method in any of the first to the eighth aspects of the invention described above.

The exposure method providing a higher resolution of a transferred pattern than the conventional one can thus be used to obtain the microstructure with its structure further reduced in size.

According to an exposure method in an eleventh aspect of the invention, X rays emitted from an X-ray source are reflected by an X-ray mirror and thereafter radiated to a resist film via a filter and an X-ray mask. A material constituting a surface of the X-ray mirror that reflects the X rays includes rhodium. The filter is 30 μm in thickness and includes beryllium. The X-ray mask includes a membrane made of diamond and an X-ray absorber film formed on the membrane and including heavy metal. The membrane is 5 μm in thickness. The resist film includes at least one element selected from the group consisting of bromine, silicon, phosphorus, sulfur, chlorine, fluorine and iodine.

Accordingly, X rays in short wavelength region can be radiated to the resist film and an average wavelength of X rays absorbed by the resist film can be made shorter than an average wavelength of X rays radiated to the resist film. Namely, the wavelength of X rays absorbed by the resist which is a dominant factor for the resolution of a transferred pattern can be decreased so that the resolution of the transferred pattern can be improved. The present invention can be applied to manufacturing processes of a semiconductor device and a microstructure to readily obtain the semiconductor device and microstructure having structures having finer sizes compared with conventional ones can be obtained in an easy manner.

An exposure apparatus in a twelfth aspect of the present invention includes an X-ray mirror. A material constituting a surface of the X-ray mirror that reflects X rays includes at least one elected from the group consisting of hafnium, tantalum, tungsten, rhenium, osmium, iridium, alloys, nitrides, carbides and borides of foregoing elements.

The X-ray mirror can provide X rays in a region of wavelength equal to or smaller than $7 \times 10^{-10}$ m which is shorter than the conventional one. The X rays in the short wavelength region can thus be radiated to a resist film to enhance the resolution of a transferred pattern.

The exposure apparatus in the twelfth aspect may further include an X-ray mask and at least one transmission film transmitting X rays therethrough. The X-ray mask may include a membrane transmitting X rays therethrough. A material constituting the transmission film and a material constituting the membrane may include diamond or boron nitride. The sum of respective thicknesses of the transmission film and membrane in the direction of travel of X rays may be at least 5 μm.

Here, when X rays radiated to the resist film are transmitted through the film containing diamond or boron nitride and having a thickness of at least 5 μm, X rays in long wavelength region are absorbed by the film. Then, the average wavelength of X rays radiated to and absorbed by the resist film can be reduced to be included in a region of shorter wavelength than the conventional one. Accordingly, the membrane and transmission film can be structured to include diamond or boron nitride and have the total thickness of at least 5 μm so as to use X rays in short wavelength region for exposure.

When the total thickness of the membrane and the transmission film meets the above-described condition, respective thicknesses of the membrane and transmission film can arbitrarily be defined. Then, the degree of freedom for setting respective thicknesses of the membrane and transmission film can be expanded. As a result, the degree of freedom of the structure of an exposure apparatus can be increased.

An exposure apparatus in a thirteenth aspect of the invention includes an X-ray mask and at least one transmission film transmitting X rays therethrough. The X-ray mask includes a membrane transmitting X rays therethrough. A material constituting the transmission film and a material constituting the membrane include diamond or boron nitride. The sum of respective thicknesses of the transmission film and membrane in the direction of travel of X rays is at least 5 μm.

X rays in long wavelength region are absorbed by the film including diamond or boron nitride and having a thickness of at least 5 μm. Then, the average wavelength of X rays radiated to and absorbed by the resist film can be reduced to be shorter than conventional one. Namely, X rays in the short wavelength region can be used for exposure.

When the total thickness of the membrane and the transmission film meets the above-described condition, respective thicknesses of the membrane and transmission film can arbitrarily be defined. Then, the degree of freedom for setting respective thicknesses of the membrane and transmission film can be expanded.

The exposure apparatus in the twelfth or thirteenth aspect of the invention may further include a filter transmitting X rays therethrough. The filter may include beryllium and the total thickness of the filter in the direction of travel of the X rays may be at least 50 μm.

As explained above, the thickness of the filter containing beryllium can be increased to shorten the average wavelength of X rays radiated to the resist film. Then, according to the present invention, the beryllium is particularly increased in thickness to shorten the average wavelength of X rays radiated to the resist so that X rays in the short wavelength region can surely be used for the exposure process. One filter or a plurality of filters may be used if the total thickness is at least 50 μm to achieve similar effects.

An exposure apparatus in a fourteenth aspect of the present invention includes at least one filter transmitting X rays therethrough. The filter includes beryllium and the total thickness of the filter in the direction of travel of the X rays is at least 50 μm.

According to the present invention, the thickness of the beryllium can particularly be increased to shorten the average wavelength of X rays radiated to the resist film. Then, X rays in short wavelength region can surely be used for the exposure process. One filter or a plurality of filters can be used, if the total thickness of the filter is at least 50 μm, to achieve similar effects.

An exposure apparatus in a fifteenth aspect of the invention includes at least one filter transmitting X rays and an X-ray mask. The filter includes beryllium and the X-ray mask includes a membrane made of diamond and transmitting X rays therethrough. The sum of a thickness of the filter and a thickness of the membrane multiplied by 10 in the direction of travel of the X rays is at least 50 μm.

When the total thickness of the filter made of beryllium is 50 μm or greater, X rays in the short wavelength region can surely be radiated to the resist. In addition, when the thickness of the membrane made of diamond is 5 μm or greater, X rays in the short wavelength region can also be radiated to the resist. Here, the thickness of the membrane is multiplied by 10 to use the resultant value as an evaluation value of the membrane. Then, the influence of the evaluation value of the membrane on the average wavelength of X rays radiated to the resist and the influence of the thickness of the filter on the average wavelength of X rays radiated to the resist are almost equivalent to each other. When the exposure apparatus includes a filter made of beryllium and an X-ray mask having a membrane containing diamond, X rays in the short wavelength region can surely be used for exposure by satisfying the conditions above.

An exposure apparatus in a sixteenth aspect of the present invention includes an X-ray mask and at least one transmission film transmitting X rays therethrough. The X-ray mask includes a membrane transmitting X rays therethrough. A material constituting the transmission film includes at least one selected from the group consisting of beryllium, diamond and boron nitride. A material constituting the membrane includes diamond or boron nitride. Suppose that respective evaluation values of diamond and boron nitride are calculated by multiplying by ten respective thicknesses, in the direction of travel of the X rays, constituted respectively of diamond and boron nitride of the transmission film and the membrane, and an evaluation value of beryllium is thickness, in the direction of travel of the X rays, constituted of beryllium of the transmission film. Then, the sum of the evaluation values for the materials constituting the transmission film and the membrane in the direction of travel of the X rays is at least 50.

In terms of capability of decreasing the average wavelength of X rays, diamond or boron nitride of 1 μm in thickness and beryllium of 10 μm in thickness are almost equivalent to each other. Then, the thickness of the portion constituted by diamond or boron nitride multiplied by 10 and then used as the evaluation value indicates the thickness of beryllium equivalent to diamond or boron nitride (beryllium-based thickness). If the sum of beryllium-based thickness of diamond and boron nitride and the evaluation value of beryllium (thickness of beryllium) in the direction of travel of X rays is at least 50, X rays in short wavelength region can surely be radiated to the resist.

A semiconductor device in a seventeenth aspect of the invention is manufactured by the exposure apparatus in any of the twelfth to sixteenth aspects.

The exposure apparatus capable of providing an enhanced resolution of a transferred pattern can be used for a manufacturing process of the semiconductor device to obtain the semiconductor device having a finer structure.

A microstructure in an eighteenth aspect of the invention is manufactured by the exposure apparatus in any of the twelfth to sixteenth aspects.

The exposure apparatus capable of providing an enhanced resolution of a transferred pattern can be used for a manufacturing process of the microstructure to allow the microstructure to have a finer structure.

An X-ray mask in a nineteenth aspect of the invention includes a membrane made of diamond or boron nitride, and the membrane has a thickness of at least 5 μm.

Diamond and boron nitride are excellent in transmittance for X rays in a region of short wavelength equal to or smaller than $7 \times 10^{-10}$ m. Then, the exposure mask of the present invention can be used for the X-ray exposure process to surely radiate such X rays in the short wavelength region to the resist. The X rays in the short wavelength region can effectively be used to enhance the throughput of the exposure process. In addition, diamond and boron nitride have a sufficient rigidity so that the mechanical strength of the X-ray mask can be improved. Accordingly, a high accuracy of a pattern formed on the X-ray mask can be maintained to improve dimension accuracy of the pattern transferred in the exposure process.

The thickness of the membrane can be at least 5 μm to sufficiently absorb X rays with a wavelength of $7 \times 10^{-10}$ m or longer (X rays in long wavelength region). On the other hand, X rays with a wavelength shorter than $7 \times 10^{-10}$ m (X rays in short wavelength region) are more likely to be transmitted through the membrane than the X rays in the long wavelength region. Then, the average wavelength of X rays transmitted through the membrane and radiated to the resist can be reduced to be in the short wavelength region. Namely, the X-ray mask of the present invention can be used to surely decrease the average wavelength of X rays radiated to the resist film (wavelength of $7 \times 10^{-10}$ m or smaller). A transferred pattern can thus be enhanced in resolution.

An exposure method in a twentieth aspect of the invention uses the X-ray mask in the nineteenth aspect described above.

Then, X rays in the region of short wavelength equal to or smaller than $7 \times 10^{-10}$ m can be used for the exposure process.

An exposure apparatus in a twenty-first aspect of the invention uses the X-ray mask in the nineteenth aspect described above.

X rays in the region of short wavelength equal to or smaller than $7 \times 10^{-10}$ m can thus be used by the exposure apparatus in the exposure process.

A resist in a twenty-second aspect of the invention includes an element selected from the group consisting of bromine, silicon, phosphorus, sulfur, chlorine, fluorine and iodine, and the total content of the element is at least 20 % by mass.

The element included in the resist particularly absorbs X rays in the short wavelength region among X rays radiated to the resist. The content of the element can be 20 % by mass to have a sufficiently high intensity of X rays in the short wavelength region absorbed by the resist. Then, according to an exposure method using the resist of the present invention, the average wavelength of X rays absorbed by the resist can be decreased. Here, the wavelength of X rays absorbed by the resist is a critical factor for determination of the resolution of a pattern transferred to the resist. Accordingly, the transferred pattern can be enhanced in resolution.

A resist in a twenty-third aspect of the invention includes a solvent containing hydrocarbon including at least one selected from the group consisting of bromine, silicon, phosphorus, sulfur and chlorine.

The element absorbing X rays in the short wavelength region is included in the solvent, not in resin itself constituting the resist. Then, the resin constituting the resist may not include the element above. Accordingly, the degree of design freedom of the resist can be expanded.

An exposure method in a twenty-fourth aspect of the invention uses the resist in the twenty-second or twenty-third aspect.

X rays in the short wavelength region can thus be absorbed surely by the resist and accordingly used as exposure light. The resolution of a pattern transferred to the resist can thus be improved.

The foregoing and other objects, features, aspects and advantages of the present invention will become more apparent from the following detailed description of the present invention when taken in conjunction with the accompanying drawings.

## BRIEF DESCRIPTION OF THE DRAWINGS

Fig. 1 schematically shows an X-ray exposure apparatus according to a first embodiment of the present invention.

Fig. 2 is a graph showing a relation between the intensity of X rays absorbed by a resist and X-ray wavelength obtained by an exposure method of the present invention.

Fig. 3 is a graph showing a relation between the intensity of X rays absorbed by a resist and X-ray wavelength obtained by an exposure system presented as a comparative example.

Fig. 4 is a graph showing a relation between the intensity of X rays absorbed by a resist and X-ray wavelength obtained by an exposure method according to a second embodiment of the present invention.

Fig. 5 is a graph showing a relation between average wavelength of X rays radiated to a resist and average wavelength absorbed by resists of various types.

Fig. 6 is a graph showing a relation between the thickness of a membrane and the intensity of X rays absorbed by a resist.

Fig. 7 is a graph showing a relation between the thickness of a membrane (diamond) and the intensity of X rays absorbed by a resist represented by a relative value.

Fig. 8 is a graph showing a relation between the intensity of X rays absorbed by a resist and X-ray wavelength for resists of various types according to an exposure method of a fifth embodiment of the present invention.

Fig. 9 is a graph showing a relation between the intensity of X rays radiated to a resist and the wavelength for respective materials constituting a reflection surface of an X-ray mirror according to an exposure method of a sixth embodiment of the present invention.

Fig. 10 is a graph showing g a relation between the intensity of X rays absorbed by a resist and the wavelength for respective materials constituting the reflection surface of the X-ray mirror according to the exposure method of the sixth embodiment of the present invention.

Fig. 11 is a graph showing a relation between the intensity of X rays radiated to a resist and the X-ray wavelength for materials constituting the reflection surface of the X-ray mirror that are changed according to an exposure method of a seventh embodiment of the present invention.

Fig. 12 is a graph showing a relation between the intensity of X rays absorbed by a resist and the X-ray wavelength for materials constituting the reflection surface of the X-ray mirror that are changed according to the exposure method of the seventh embodiment of the present invention.

Fig. 13 is a graph showing a relation between the intensity of X rays radiated to a resist and the X-ray wavelength for respective materials constituting the reflection surface of the X-ray mirror according to an exposure method of an eighth embodiment of the present invention.

Fig. 14 is a graph showing a relation between the intensity of X rays absorbed by a resist and the X-ray wavelength for respective materials constituting the reflection surface of the X-ray mirror according to the exposure method of the eighth embodiment of the present invention.

Fig. 15 is a graph showing a relation between the intensity of X rays radiated to a resist and the wavelength when the thickness of a membrane made of diamond is changed according to an exposure method of a tenth embodiment of the present invention.

Fig. 16 is a graph showing a relation between the intensity of X rays absorbed by a resist and the X-ray wavelength for various resists according to an exposure method of an eleventh embodiment of the present invention.

Fig. 17 is a graph showing a relation between the intensity of X rays radiated to a resist and the X-ray wavelength when the incident angle for the X-ray mirror is changed.

Fig. 18 is a graph showing a relation between the intensity of X rays absorbed by a resist and the X-ray wavelength when the incident angle for the X-ray mirror is changed.

Fig. 19 is a graph showing a relation between the intensity of X rays radiated to a resist and the X-ray wavelength when the incident angle for the X-ray mirror is changed according to an exposure method of a twelfth embodiment of the present invention.

Fig. 20 is a graph showing a relation between the intensity of X rays absorbed by a resist and the X-ray wavelength when the incident angle for the X-ray mirror is changed according to the exposure method of the twelfth embodiment of the present invention.

Fig. 21 is a graph showing a relation between the intensity of X rays radiated to a resist and the wavelength according to an exposure method of a fourteenth embodiment of the present invention.

Fig. 22 is a graph showing a relation between the intensity of X rays absorbed by a resist and the wavelength according to the exposure method of the fourteenth embodiment of the present invention.

Fig. 23 is a graph showing a relation between the intensity of X rays radiated to a resist and the X-ray wavelength when the incident angle for an X-ray mirror is changed according to an exposure method of a fifteenth embodiment of the present invention.

Fig. 24 is a graph showing a relation between the intensity of X rays absorbed by a resist and the X-ray wavelength when the incident angle for the X-ray mirror is changed according to the exposure method of the fifteenth embodiment of the present invention.

Fig. 25 is a graph showing a relation between the thickness of a membrane made of diamond and the average wavelength of X rays absorbed by a resist according to an exposure method of a sixteenth embodiment of the present invention.

Fig. 26 is a graph showing a relation between the thickness of a membrane and the average wavelength of X rays absorbed by a resist according to an exposure method of a seventeenth embodiment of the present invention.

Fig. 27 is a graph showing a relation between the thickness of a filter made of beryllium and the average wavelength of X rays absorbed by a resist according to an exposure method of an eighteenth embodiment of the present invention.

Fig. 28 is a graph showing a relation between the surface roughness of an X-ray mirror and the intensity of X rays absorbed by a resist according to an exposure method of a nineteenth embodiment of the present invention.

Fig. 29 is a graph showing a relation between the surface roughness of the X-ray mirror and the average wavelength of X rays absorbed by a resist according to the exposure method of the nineteenth embodiment of the present invention.

Fig. 30 is a graph showing a relation between the intensity of X rays absorbed by a resist and the X-ray wavelength for case 1 according to an exposure method of a twentieth embodiment of the present invention.

Fig. 31 is a graph showing a relation between the intensity of X rays absorbed by a resist and the X-ray wavelength for case 2 according to the exposure method of the twentieth embodiment of the present invention.

Fig. 32 is a graph showing a relation between the thickness of a membrane of an X-ray mask and the intensity of X rays absorbed by a resist according to an exposure method of a twenty-first embodiment of the present invention.

Fig. 33 is a graph showing a relation between the thickness of the membrane and the average wavelength of X rays absorbed by a resist according to the exposure method of the twenty-first embodiment of the present invention.

Fig. 34 is a graph showing a relation between the thickness of an SiC membrane and contrast.

Fig. 35 is a graph showing a relation between the thickness of a membrane made of diamond and mask contrast according to an exposure method of a twenty-second embodiment of the present invention.

Fig. 36 is a graph showing a relation between the thickness of a membrane and contrast according to an exposure method of a twenty-third embodiment of the present invention.

Fig. 37 is a graph showing a relation between the thickness of a membrane and contrast according to an exposure method of a first modification of the twenty-third embodiment of the present invention.

Fig. 38 schematically shows a wavelength sweeper for the X-ray exposure apparatus according to the present invention.

Fig. 39 schematically shows an exposure method of a twenty-fifth embodiment of the present invention.

Fig. 40 schematically shows an exposure apparatus for carrying out an exposure method of a twenty-sixth embodiment of the present invention.

Fig. 41 is a road map showing a summary of lithography techniques applied to respective design rule generations concerning semiconductor technique and particularly concerning the lithography technique.

Fig. 42 schematically shows a conventional X-ray exposure apparatus.

Fig. 43 is a graph showing spectra of exposure light radiated to a resist surface in conventional representative X-ray exposure systems (graph showing a relation between radiation intensity and wavelength for each wavelength of exposure light).

Fig. 44 is a graph showing a relation between intensity of X rays radiated to a resist and wavelength for each of the X-ray exposure apparatus described in the relevant application and a comparative X-ray exposure apparatus.

Fig. 45 is a graph showing a relation between intensity of X rays absorbed by the resist and wavelength for each of the X-ray exposure apparatus of the relevant application and the comparative X-ray exposure apparatus.

DESCRIPTION OF THE PREFERRED EMBODIMENTS

Embodiments of the present invention are hereinafter described in conjunction with the drawings where the same or corresponding components are denoted by the same reference character and description thereof is not repeated.

First Embodiment

A first embodiment of an X-ray exposure apparatus according to the present invention is described with reference to Fig 1.

Referring to Fig. 1, X-ray exposure apparatus 19 includes a synchrotron radiation source 1 as an X-ray source, X-ray mirrors 3a and 3b for reflecting light 2 including X rays radiated from synchrotron radiation source 1, a window 4 made of beryllium for serving as a vacuum partition between a vacuum vessel (conduit) where X-ray mirrors 3a and 3b are arranged and the outside thereof, and an X-ray mask 8. Radiated light 2 from synchrotron radiation source 1 is reflected from X-ray mirrors 3a and 3b, transmitted through window 4 and X-ray mask 8 and then directed to a resist 10. An X-ray absorber film 7 having a pattern to be transferred is formed on a membrane 6 of X-ray mask 8. A substrate 9 to which resist 10 is applied is arranged opposite X-ray mask 8. The conduit of radiated light 2 that includes X-ray mirrors 3a and 3b and window 4 is called beam line 5. Radiated light 2 (X rays) directed by beam line 5 illuminates resist 10 applied to substrate 9 through X-ray mask 8 provided in a stepper 11. In other words, radiated light 2 from synchrotron radiation source 1 is directed to resist 10 through X-ray mirrors 3a and 3b, window 4 and X-ray mask 8 and accordingly the transfer pattern formed by X-ray absorber 7 of X-ray mask 8 is transferred by X rays to resist 10.

Synchrotron radiation source 1 has an acceleration energy of 700 MeV and a deflection magnetic field intensity of 4.5 T. X-ray mirrors 3a and 3b each have a surface reflecting radiated light 2 (reflection surface) constituted of rhodium (Rh). The radiated light is incident on the reflection surface of X-ray mirrors 3a and 3b at an angle of 89°. One of the X-ray mirrors 3a and 3b is used for horizontally collecting light and the other thereof is used for vertically expanding light. As described above, X-ray mirrors 3a and 3b are held inside the vacuum vessel. Window 4 made of beryllium is provided for dividing the inside of the vacuum vessel and the outside thereof and for taking out radiated light 2 from synchrotron radiation source 1 from beam line 5. Window 4 is 30 μm in thickness. The thickness of window 4 may be 50 μm or greater.

X-ray mask 8 includes membrane 6 made of diamond and X-ray absorber film 7. Membrane 6 is 5 μm in thickness. X-ray absorber film 7 includes heavy metal such as tungsten and tantalum. Resist 10 applied onto substrate 9 includes at least one element selected from the group consisting of bromine, silicon, phosphorus, sulfur, chlorine, fluorine and iodine.

The element(s) included in resist 10 absorbs X rays particularly in a short-wavelength region among X rays radiated to resist 10 as described later. Consequently, the average wavelength of X rays absorbed by resist 10 can be made shorter. The wavelength of X rays absorbed by resist 10 is a significant factor determining the resolution of the pattern transferred to resist 10. The pattern transferred to resist 10 thus has a higher resolution. Then, an exposure method according to the present invention using the exposure apparatus of the invention as shown in Fig. 1 can be applied to a manufacturing process of a semiconductor device to achieve a finer scale and a higher integration of the resultant semiconductor device. In addition, the exposure method of the invention using the exposure apparatus shown in Fig. 1 can be applied to a manufacturing process of a microstructure to produce the microstructure having a finer size and a complicated structure.

Diamond used as a material for membrane 6 is excellent in transmittance for X rays in a short-wavelength region of $7 \times 10^{-10}$ m or shorter. Accordingly, membrane 6 made of diamond exhibits a relatively high absorbance for X rays having a longer wavelength than that of X rays chiefly absorbed by resist 10 while membrane 6 exhibits a less or almost no absorbance for X rays in a short-wavelength region used for exposure. (Peak wavelength of X rays absorbed by resist 10 is shorter than that absorbed by diamond which is a material constituting membrane 6.) X rays in the short-wavelength region at membrane 6 can be prevented from attenuating. Consequently, X rays in the short-wavelength region can surely be radiated to resist 10. Boron nitride may alternatively be used as a material for membrane 6.

The peak wavelength of X rays absorbed by beryllium which is used as a material for window 4 serving as a filter is longer than the peak wavelength of X rays absorbed by resist 10. Then, X rays in the short-wavelength region can be prevented from attenuating at window 4 and thus X rays in the short-wavelength region can surely be used as exposure light.

Preferably, the surfaces of X-ray mirrors 3a and 3b reflecting X rays are each constituted of a material including at least one selected from the group consisting of beryllium, titanium, silver, ruthenium, rhodium, paradigm, iron, cobalt, nickel, copper, manganese, chromium, hafnium, tantalum, tungsten, rhenium, osmium, iridium, alloys, nitrides, carbides and borides of these elements, diamond, diamond like carbon, and boron nitride. The peak wavelength of X rays absorbed by these materials is longer than the peak wavelength of X rays in the short-wavelength region absorbed by resist 10. These materials can be used for X-ray mirrors 3a and 3b to obtain X rays in a region of shorter wavelength than conventional one, for example, $7 \times 10^{-10}$ m or shorter, and thus the resolution of the transferred pattern can surely be enhanced.

If the material constituting the surfaces of X-ray mirrors 3a and 3b reflecting X rays includes at least one selected from the group consisting of hafnium, tantalum, tungsten, rhenium, osmium, iridium, alloys, nitrides, carbides and borides of these elements and the angle of incidence of X rays on X-ray mirrors 3a and 3b is large, for example, 89°, X rays in a shorter wavelength region can be radiated to resist 10. Then, the resolution of the pattern transferred to the resist can further be enhanced.

In order to confirm effects of the present invention, the average wavelength of absorbed rays and the amount of absorbed X rays when different types of resists were used were determined through simulations. Combinations of exposure apparatuses (exposure systems) and resists for a conventional example, reference examples and the present invention that were examined are shown in Table 1 below.

Table 1

| | | resist | |
|---|---|---|---|
| | | resist of present invention (resist containing S/Cl) | conventional resist (PMMA) |
| exposure system | exposure system of present invention (Rh mirror, diamond membrane) | present invention | reference example 2 |
| | conventional exposure system (SiC mirror, SiC membrane) | reference example 1 | conventional example |

As shown in Table 1, for the conventional example, the exposure apparatus using the SiC mirrors and SiC membrane as shown in Fig. 42 (conventional exposure system) and PMMA ($C_5H_8O_2$) which is a conventional resist are used. For reference example 1, the conventional exposure system is used and the resist of the present invention is applied thereto and a simulation is conducted accordingly. For reference example 2, the exposure apparatus using the rhodium mirrors and diamond membrane shown in Fig. 1 (exposure system of the present invention) and PMMA which is the conventional resist are used. Results of the simulations are shown in Table 2.

Table 2

| | exposure system | conditions: X-ray mirror material X-ray mask membrane material/membrane thickness | radiation energy (MeV) average wavelength of X rays radiated to resist ($1 \times 10^{-10}$m) | calculated item | PMMA | bromine (Br) | silicon (Si) | phosphorus (P) | sulfur (S) | chlorine (Cl) | fluorine (F) | iodine (I) |
|---|---|---|---|---|---|---|---|---|---|---|---|---|
| conventional example | conventional exposure system | SiC mirror SiC thin film/2 μm | 66.23 8.23 | average resist-absorbed wavelength ($1 \times 10^{-10}$m) | 8.72 | - | - | - | - | - | - | - |
| | | | | amount of resist-absorbed X rays (relative value) | 6.60 | - | - | - | - | - | - | - |
| reference 1 | | | | average resist-absorbed wavelength ($1 \times 10^{-10}$m) | - | 7.88 | 8.69 | 8.63 | 8.69 | 8.69 | 8.66 | 8.54 |
| | | | | amount of resist-absorbed X rays (relative value) | - | 16.13 | 5.58 | 4.48 | 5.58 | 6.28 | 12.03 | 21.15 |
| reference 2 | exposure system of present invention | Rh mirror diamond/5 μm | 167.32 5.58 | average resist-absorbed wavelength ($1 \times 10^{-10}$m) | 6.46 | - | - | - | - | - | - | - |
| | | | | amount of resist-absorbed X rays (relative value) | 6.18 | - | - | - | - | - | - | - |
| present invention | | | | average resist-absorbed wavelength ($1 \times 10^{-10}$m) | - | 5.87 | 5.25 | 5.29 | 5.25 | 5.70 | 6.40 | 6.22 |
| | | | | amount of resist-absorbed X rays (relative value) | - | 36.23 | 14.13 | 19.75 | 14.13 | 8.88 | 12.00 | 25.14 |

The simulations shown in Table 1 were conducted on the conditions that the energy of the synchrotron radiation source was 700 MeV, deflection magnetic field was 4.5 T, the angle of incidence of X rays on the X-ray mirror was 89°, two X-ray mirrors were used, the window made of beryllium was 30 μm in thickness, and the resist was 1.0 g/cm$^3$ in density. As a model of any material such as silicon except for PMMA for the resist, a pure substance having a density of 1.0 g/cm$^3$ was used.

The vertical axis of Figs. 2 and 3 represents X-ray absorption intensity for each wavelength for each of various types of resists. It is noted that, for embodiments hereinafter described, when graphs having the horizontal axis representing wavelength and the vertical axis representing X-ray absorption intensity or radiation intensity are used, the vertical axis always represents X-ray absorption intensity or radiation intensity for each wavelength. Representations in Figs. 2 and 3 are as follows. For example, "F (1.0) 1.0 μm" shown in the top line of Fig. 2 represents that fluorine is used as a material for the resist (F), the density of fluorine is 1.0 g/cm$^3$ (1.0), and the resist is applied onto a substrate to a thickness of 1.0 μm (1.0 μm).

As seen from Table 2 and Figs. 2 and 3, for the conventional exposure system, chiefly X rays of at least $7 \times 10^{-10}$ m(7Å) in wavelength are used. According to the exposure method of the present invention, chiefly X rays from approximately $4 \times 10^{-10}$ m to $7 \times 10^{-10}$ m in a short-wavelength region are used. Moreover, for the present invention, absorption peak wavelength of X rays absorbed by the resist 10 is $7 \times 10^{-10}$ m or shorter.

Referring to Table 2, for the conventional example, the average wavelength of X rays absorbed by the resist of PMMA is $8.72 \times 10^{-10}$ m. For reference example 2 using the exposure system of the present invention and the conventional resist of PMMA, the average wavelength of X rays absorbed by the resist (average resist-absorbed wavelength) is $6.46 \times 10^{-10}$ m, which is shorter than that for the conventional example. It is understood accordingly that effects are observed to some extent when only the exposure system is the one according to the present invention.

The present invention further exhibits that a resist containing an element such as bromine, silicon and the like absorbs X rays having a shorter average wavelength than that for reference example 2. For example, when a resist containing bromine (Br) (pure substance of bromine of 1.0 g/cm$^3$ in density in a simulation) is used, the average resist-absorbed wavelength is $5.87 \times 10^{-10}$ m which is still shorter than the average wavelength of X rays absorbed by the resist (average resist-absorbed wavelength) of PMMA for reference example 2.

The amount of X rays absorbed by the resist (resist-absorbed X-ray amount) is 6.18 for reference example 2 while that is 36.23 for the present invention using the resist containing bromine, which is more than five times as great as that for reference example 2. As clearly seen from Table 2 and Fig. 3, the average resist-absorbed wavelength is longer than the average wavelength of X rays radiated to the resist for the conventional example and reference examples 1 and 2 except for the case in which the resist containing bromine is used, while the average resist-absorbed wavelength can be made shorter than the average wavelength of X rays radiated to the resist by using silicon, phosphorus, sulfur or chlorine for the resist according to the present invention. In other words, it is possible for the resist to selectively absorb X rays in a short wavelength region by selecting materials constituting the resist to include silicon, phosphorus, sulfur or chlorine that are elements each having the absorption edge in the wavelength region of X rays radiated to the resist.

In this way, the wavelength of X rays absorbed by the resist is made shorter to effect exposure by means of X rays of shorter wavelength than that of X rays actually radiated to the resist. X-ray exposure with a higher resolution can thus be achieved. For example, sulfur provides the shortest average resist-absorbed wavelength, namely $5.25 \times 10^{-10}$ m, which is approximately 0.6 times as long as the average resist-absorbed wavelength of PMMA for the conventional example.

Preferably, the absorption edge of any element contained in the resist is in a wavelength region from $2 \times 10^{-10}$ m to $7 \times 10^{-10}$ m. More preferably, the wavelength region is from $2 \times 10^{-10}$ m to $6 \times 10^{-10}$ m, and still more preferably, the wavelength region is from $3 \times 10^{-10}$ m to $5 \times 10^{-10}$ m. When the lower limit of the wavelength region is $3 \times 10^{-10}$ m, a pattern transferred to the resist can have a further enhanced contrast (mask contrast). In addition, when the upper limit of the wavelength region is $5 \times 10^{-10}$ m, a shorter wavelength of X rays can be used for exposure which further enhances the resolution. Therefore, the wavelength region from $3 \times 10^{-10}$ m to $5 \times 10^{-10}$ m can enhance both of the two characteristics, i.e., contrast and resolving performance (resolution) in a well-balanced manner.

Reference example 1 is considered with reference to Fig. 3. When the conventional exposure system is used and X rays chiefly having a wavelength of at least $7 \times 10^{-10}$ m are radiated to the resist, the average resist-absorbed wavelength is almost the same as that of PMMA even when any resists containing phosphorus, sulfur and the like as those for the present invention are used. When the resist contains silicon, phosphorus, sulfur or chlorine, the resist-absorbed X-ray amount is smaller than that of PMMA. In other words, when the resist of the present invention is applied to the conventional exposure system, the average resist-absorbed wavelength is almost the same as that of the conventional resist of PMMA, and thus the effect of enhanced resolution cannot be achieved.

SiC is used as a material for the X-ray mirrors of the conventional example. When an exposure system uses any material such as platinum and gold for the X-ray mirrors, with a reduced angle of incidence of X rays on the X-ray mirrors and the conventional X rays having a wavelength of at least $7 \times 10^{-10}$ m, it would be difficult to remarkably enhance the resolution like the present invention does even if the resist of the present invention is used as shown by reference example 1.

Second Embodiment

For the exposure apparatus shown in Fig. 1 according to the present invention, nickel (Ni) can be used for a material constituting a surface (reflection surface) of X-ray mirrors 3a and 3b each that reflects X rays. A second embodiment of the exposure apparatus according to the present invention thus has the X-ray mirrors with the reflection surfaces made of nickel. Simulations were conducted to determine spectra of X rays absorbed by various types of resists. Results of the simulations are shown in Fig. 4. In Fig. 4, the vertical axis indicates the intensity of absorbed X rays for each wavelength.

The simulations were conducted on the conditions that the acceleration energy of synchrotron radiation source 1 (see Fig. 1) was 700 MeV, deflection magnetic field intensity was 4.5 T, the thickness of beryllium window 4 was 11 μm, and the thickness of membrane 6, which is made of diamond, of X-ray mask 8 was 2 μm. The X-ray reflection surfaces of X-ray mirrors 3a and 3b were constituted of nickel and the angle of incidence of X rays on X-ray mirrors 3a and 3b was 89°. A model material for the resist was a pure substance having the density 1 $g/cm^3$ as that of the first embodiment.

As shown in Fig. 4, the resists containing silicon, phosphorus, sulfur, chlorine and bromine (model material for each being a pure substance of 1.0 $g/cm^3$ in density) exhibit a sharp change of absorbed X-ray intensity in the region of wavelengths from 4 to $7 \times 10^{-10}$ m. This sharp change of absorbed X-ray intensity corresponds to the position of the absorption edge of each element.

The average wavelength of X rays radiated to the resist and the average wavelength of X rays absorbed by the resist (average resist-absorbed wavelength) are considered with reference to Fig. 5 in which the horizontal axis indicates materials for the resist such as phosphorus (P) and sulfur (S) and the like and the vertical axis indicates the average resist-absorbed wavelength.

Referring to Fig. 5, the average wavelength of X rays radiated to the resist is $5.85 \times 10^{-10}$ m. The average resist-absorbed wavelength for the conventional resist of PMMA is approximately $7.3 \times 10^{-10}$ m. Thus, for the conventional resist of PMMA, the average wavelength of X rays absorbed by the resist is longer than the average wavelength of radiated X rays. On the other hand, the average resist-absorbed wavelengths for respective resist materials, namely phosphorus (P), sulfur (S), silicon (Si), chlorine (Cℓ) and bromine (Br) are respectively 5.55, 5.7, 5.75, 6.15 and 6.15 (unit: $1\times 10^{-10}$ m). It is accordingly seen that the average resist-absorbed wavelength is shorter than the average wavelength of X rays radiated to the resist made of a material such as phosphorus, sulfur and silicon. When the resist is made of a material such as chlorine and bromine, the average resist-absorbed wavelength is longer than the average wavelength of X rays radiated to the resist. However, the average resist-absorbed wavelength is sufficiently shorter than that for the conventional resist of PMMA.

As seen from Fig. 4, each element chiefly absorbs X rays in a region of shorter wavelength than that of the absorption edge. Specifically, bromine having the absorption edge at $7.984 \times 10^{-10}$ m chiefly absorbs X rays in the region of wavelength of approximately $8 \times 10^{-10}$ m or shorter. Silicon having the absorption edge at $6.738 \times 10^{-10}$ m chiefly absorbs X rays in the region of wavelength of approximately $7 \times 10^{-10}$ m or shorter. Similarly, phosphorus having the absorption edge at $5.784 \times 10^{-10}$ m, sulfur having the absorption edge at $5.0185 \times 10^{-10}$ m and chlorine having the absorption edge at $4.3971 \times 10^{-10}$ m absorb X rays in respective regions of wavelength shorter than respective absorption edges.

According to the exposure method of the present invention, the amount of X rays absorbed by the resist (resist-absorbed X-ray amount) is greater than that of the conventional example like that of the first embodiment. Specifically, relative to the amount of X rays absorbed by the conventional resist of PMMA, respective amounts of X rays absorbed by respective resists of bromine, silicon, phosphorus, sulfur and chlorine are 6.06 times, 3.67 times, 2.96 times, 2.25 times and 1.65 times greater.

When resists are respectively made of fluorine and iodine, the shapes of absorption spectra of X rays absorbed by respective materials are almost identical to that of the absorption spectrum of X rays absorbed by the conventional resist of PMMA. The amount of X rays absorbed by the resist of fluorine is 1.9 times as great as that of the PMMA resist and that absorbed by the resist of iodine is 3.7 times as great as that of the PMMA. Namely, exposure with a higher sensitivity than that of the conventional PMMA is possible by using fluorine and iodine as the resist material.

Third Embodiment

The exposure apparatus of the first embodiment according to the present invention was used and the thickness of the membrane of X-ray mask 8 was varied to determine the intensity of X rays absorbed by resist 10 through simulations. Results of the simulations are shown in Fig. 6. For the data shown in Fig. 6, Fig. 7 shows the relative intensity of X rays absorbed by the resist for each membrane thickness. The relative intensity is indicated on the basis of the intensity 1 of absorbed X rays when the membrane is 2 μm-thick

Referring to Figs. 6 and 7, when PMMA is used for the resist and the membrane is increased in thickness from 2 μm to 20 μm, the intensity of X rays absorbed by the resist drops sharply to the intensity which is 0.14 times as high as the intensity for the thickness of 2 μm. On the other hand, when sulfur (S) is used for the resist according to the present invention and the membrane is similarly increased in thickness from 2 μm to 20 μm, the intensity of X rays absorbed by the resist decreases to the intensity 0.32 times as high as the intensity for the membrane thickness of 2 μm. When phosphorus (P) is used for the resist and the membrane thickness is increased from 2 μm to 20 μm, the intensity decreases to the intensity 0.31 times as high as the intensity for the membrane thickness of 2 μm. Accordingly, when the resist of the present invention is used, the degree of decrease in the intensity of X rays absorbed by the resist when a membrane of greater thickness is used is smaller than that for the conventional resist of PMMA. Then, the resist of the present invention can be used to perform a sufficient exposure in a shorter period of time even when the membrane thickness is increased, compared with the conventional resist of PMMA or the like.

Here, the thickness of the membrane is taken into consideration. However, similar results are obtained when the thickness of window 4 is varied. Specifically, when the resist of the present invention is used and window 4 is increased in thickness, the intensity of X rays absorbed by the resist can be greater than that for the conventional resist of PMMA. Then, it is possible to prevent the exposure time from increasing when the thickness of window 4 made of beryllium increases. If the thickness of window 4 is the same, the exposure time can be shortened. In this way, the exposure process can provide a higher process rate (throughput) than that of the conventional process.

In Figs. 6 and 7, Br represents that bromine (Br) is used as a material for the resist and Rh represents that rhodium (Rh) is used as a material for X-ray mirrors.

Fourth Embodiment

The exposure apparatus of the first embodiment according to the present invention and having a resist containing iodine was used to form a line and space (L/S) pattern. The exposure apparatus (exposure system) here was basically the same as that shown in Fig. 1 except that the thickness of window 4 was 30 μm and a 0.6 μm-thick filter made of tantalum (Ta) and a 0.6 μm-thick filter made of gold (Au) were provided in the beam line of X rays as filters passing X rays. X rays passing through window 4 made of beryllium and the filters made of tantalum and gold respectively were radiated to resist 10 containing iodine through X-ray mask 8. The membrane of X-ray mask 8 was made of diamond and the thickness thereof was 4 μm. Gold was used as a material for X-ray absorber 7.

In this case, the amount of X rays absorbed by the resist was 10 times as great as that by the conventional resist of PMMA. Exposure was conducted with a distance of 10 μm between substrate 9 and mask 8 (10 μm-gap exposure), and accordingly an L/S pattern with the interval of 28 nm could be formed. This is possibly because iodine has the absorption edge in the wavelength region of $2.5 \times 10^{-10}$ m. The average resist-absorbed wavelength and mask contrast were calculated and respective results were $2.01 \times 10^{-10}$ m and 3.00.

Fifth Embodiment

According to an exposure method of a fifth embodiment of the present invention, the absorption spectrum of X rays for each of various types of resists was determined through simulations. The simulations were conducted by using an exposure apparatus which is basically the same as that shown in Fig. 1, on the conditions that acceleration energy of synchrotron radiation source 1 was 800 MeV, deflection magnetic field intensity was 4.5 T, and a 30 μm-thick beryllium film was used for window 4. A 100 μm-thick diamond film passing X rays was provided in the beam line of X rays. A 4 μm-thick diamond film was used for membrane 6 of X-ray mask 8. For comparison, the absorption spectrum of X rays for the conventional resist of PMMA ($C_5H_8O_2$) was also determined. Results are shown in Fig. 8.

Referring to Fig. 8, iodine (I) has the absorption edge in the region of wavelength near $2.8 \times 10^{-10}$ m. Then, the X-ray absorption intensity is approximately twice as great as that of other resist materials in the region of wavelength of approximately $2 \times 10^{-10}$ m. The average wavelength of X rays absorbed by the iodine resist was remarkably short, specifically $2.33 \times 10^{-10}$ m. The iodine resist can thus be used to transfer a pattern with a design rule of 35 nm or smaller, providing that the gap between the X-ray mask and substrate is 10 μm. When the gap between the X-ray mask and substrate is 5 μm, a pattern with a design rule of approximately 20 nm can be transferred.

Sixth Embodiment

According to an exposure method of a sixth embodiment of the present invention, a relation between the intensity of X rays radiated to the resist and the wavelength of X rays was examined by changing the material constituting a surface of the X-ray mirror that reflects X rays. An exposure apparatus examined here had a structure basically the same as that shown in Fig. 1. The acceleration energy of synchrotron radiation source 1 was 800 MeV, deflection magnetic field intensity was 4.5 T and the angle of incidence of X rays on X-ray mirrors 3a and 3b was 89°. The thickness of window 4 made of beryllium was 20 μm. Membrane 6 of X-ray mask 8 was made of diamond having a thickness of 20 μm. A model material for resist 10 was chlorine with a density of 1.0 g/$cm^3$ (hereinafter chlorine resist). In this system, for the X-ray reflection surfaces of X-ray mirrors 3a and 3b, all metallic elements in period 4 of the periodic table, alloys and compounds of the metallic elements in period 4 were examined. Results are shown in Figs. 9 and 10.

As shown in Figs. 9 and 10, for materials of chromium (Cr), manganese (Mn), iron (Fe), cobalt (Co), nickel (Ni) and copper (Cu), the average wavelength of X rays absorbed by the resist (average resist-absorbed wavelength) is shorter than the average wavelength of X rays radiated to the resist. Moreover, a sufficient amount of X rays is absorbed by the resist.

The metallic elements in period 4 examined here have no absorption edge in the region of wavelength ranging from $2 \times 10^{-10}$ m to $5 \times 10^{-10}$ m. Then, the angle of incidence of X rays on X-ray mirrors 3a and 3b is made larger than 89° (i.e., X rays are incident on the X-ray mirrors at a smaller angle) so that X rays of a shorter wavelength can be radiated to the resist. The increased angle of incidence of X rays on X-ray mirrors 3a and 3b can also improve reflectance of X rays. In this way, the transmission efficiency of X rays in the beam line can be enhanced. Accordingly, the enhanced X-ray transmission efficiency in the beam line as well as the X rays in a region of shorter wavelength radiated to the resist can provide enhancement in resolution and throughput at the same time.

Alloys of the metallic elements in period 4, oxides, nitrides and carbides thereof can also be used as a material for the X-ray reflection surface of the X-ray mirrors to achieve the above-described effects. When halides and sulfides of the metallic elements in period 4 are used, there are influences of the absorption edges of halogen and sulfur. In addition, when compounds, mixtures and alloys of the metallic elements in period 4 and elements which become volatile through decomposition are used for the material constituting the reflection surface of the X-ray mirror, the lifetime of the X-ray mirror could be shortened. In such a case, the lifetime of the X rays mirror must be managed accurately.

In Figs. 9 and 10, the indication of Ti 4.54 (89.0) in the top line in Fig. 9 for example represents that titanium (Ti) is used as a material constituting the reflection surface of the X-ray mirror, the density of the titanium is 4.54 g/$cm^3$ and the angle of incidence on the X-ray mirror is 89.0°.

## Seventh Embodiment

According to an exposure method of a seventh embodiment of the present invention, metallic elements in period 5 of the periodic table, alloys and compounds of such metallic elements were used for a material constituting the reflection surface of the X-ray mirror and accordingly a relation between the intensity and wavelength of X rays radiated to the resist was examined. The relation was examined by means of an exposure apparatus and under exposure conditions that were basically the same as those for the sixth embodiment of the present invention. Results are shown in Figs. 11 and 12.

It is seen from Fig. 11 that, when any of zirconium (Zr), niobium (Nb), molybdenum (Mo), ruthenium (Ru), rhodium (Rh), palladium (Pd), silver (Ag), cadmium (Cd), indium (In) and tin (Sn) is used for the material constituting the reflection surface of the X-ray mirror, X rays having the peak in the region of wavelength shorter than $6 \times 10^{-10}$ m can be radiated to the resist. Regarding X rays absorbed by a chlorine resist, the average wavelength of X rays absorbed by the resist is shorter than the average wavelength of X rays radiated to the resist. In particular, as shown in Fig. 12, the intensity of X rays absorbed by the resist is higher for ruthenium (Ru), rhodium (Rh), palladium (Pd) and silver (Ag). Then, these materials, namely ruthenium, rhodium, palladium and silver are especially suitable for the X-ray mirror material for the exposure method of the present invention.

The angle of incidence of X rays on the X-ray mirror in the simulation as described above is 89°. The incident angle of 89° or greater can further enhance the reflectance of the X-ray mirror with respect to X rays, which can enhance the intensity of X rays radiated to the resist. As a result, the time required for X-ray exposure can be shortened and thus a higher throughput can be achieved.

## Eighth Embodiment

According to an exposure method of an eighth embodiment of the present invention, elements in period 6 of the periodic table were used as a material constituting the reflection surface of the X-ray mirror, and accordingly a relation between the intensity and wavelength of X rays radiated to the resist was examined. Specifically, hafnium (Hf), tantalum (Ta), tungsten (W), rhenium (Re), osmium (Os), iridium (Ir), platinum (Pt), gold (Au) and lead (Pb) were used as such a material constituting the reflection surface of the X-ray mirror. The simulation was conducted by means of a system of an exposure apparatus basically similar to that of the seventh embodiment. Results are shown in Figs. 13 and 14.

Referring to Figs. 13 and 14, for all of the examined elements, the peak wavelength of X rays radiated to the resist is shorter than $5 \times 10^{-10}$ m. Further, the average wavelength of X rays absorbed by the resist is almost equal to or shorter than the average wavelength of X-ray radiated to the resist because of the wavelength selectivity of the chlorine resist. In particular, as shown in Fig. 14, for hafnium, tantalum, tungsten, rhenium, osmium, iridium, platinum and gold, a great amount of energy is absorbed by the resist. It is seen from this that these elements are suitable for the material constituting the reflection surface of the X-ray mirror for the exposure method of the present invention.

From the graph showing the relation between the intensity of X rays absorbed by the resist and the wavelength of X rays, it is understood that the average resist-absorbed wavelength can be decreased to approximately $3.66 \times 10^{-10}$ m when iridium is used for the material of the X-ray mirror, and the average resist-absorbed wavelength can be decreased to approximately $3.65 \times 10^{-10}$ m when osmium is used for the material constituting the reflection surface of the X-ray mirror.

Here, the relation is examined by setting the angle of incidence of X rays on the X-ray mirror at 89°. Elements in period 6 of the periodic table have no great absorption edge in the region of wavelength from 2 to $5 \times 10^{-10}$ m. Then, the reflectance for X rays can be enhanced by setting the incident angle at 89° or greater. In particular, when at least one material selected from the group consisting of gold, platinum, and alloys thereof is used for the material constituting the reflection surface of the X-ray mirror, a preferable incident angle is at least 89°. Consequently, X rays in a short-wavelength region can be radiated to the resist and the intensity of the X rays radiated to the resist can be enhanced. A higher throughput as well as a higher resolution can thus be achieved simultaneously.

Ninth Embodiment

According to an exposure method of a ninth embodiment of the present invention, elements in period 2 of the periodic table were used for the material constituting the reflection surface of the X-ray mirror. Specifically, diamond, diamond like carbon and boron nitride (BN) were used for the material constituting the reflection surface of the X-ray mirror. Conditions of the exposure method were basically similar to those of the eighth embodiment of the present invention. It has been found that the angle of incidence of X rays on the X-ray mirror can be 88.5° or greater to obtain X rays in a region of shorter wavelength like those obtained according to the sixth to eighth embodiments of the present invention. Then, the ninth embodiment makes it possible to use X rays in a region of shorter wavelength for the exposure process like the sixth to eighth embodiments.

According to the sixth to ninth embodiments of the present invention, the same material is used to constitute the reflection surfaces of two X-ray mirrors 3a and 3b shown in Fig. 1. However, different materials may be used, namely, rhodium constitutes the reflection surface of one X-ray mirror while cobalt constitutes the reflection surface of the other X-ray mirror. In any case, the materials of the sixth to the ninth embodiment of the present invention can be used to achieve similar effects.

Tenth Embodiment

According to an exposure method of a tenth embodiment of the present invention, the thickness of the membrane, which is made of diamond, of the X-ray mask was varied. Specifically, simulations were conducted by varying the thickness of the membrane made of diamond to determine the relation between the intensity and wavelength of X rays radiated to the resist. The simulations were conducted through exposure on the conditions basically similar to the exposure conditions as shown in Fig. 1. Here, the acceleration energy of synchrotron radiation source 1 was 800 MeV, deflection magnetic field intensity was 4.5 T and platinum was used for the material constituting the reflection surface of the X-ray mirror. Further, the angle of incidence of X rays on X-ray mirrors 3a and 3b was 89.5° and window 4 made of beryllium had a thickness of 30 μm. In such a system, the thickness of membrane 6 made of diamond was varied to 2 μm, 10 μm and 20 μm to find a resultant relation between the intensity and wavelength of X rays radiated to the resist. The resultant relation is shown in Fig. 15.

It is seen from Fig. 15 that as the thickness of the membrane made of diamond becomes greater, the membrane cuts off X rays in a region of long wavelength and accordingly X rays of shorter wavelength are radiated to the resist. In Fig. 15, "diamond 2 μm" means that a membrane made of diamond and having a thickness of 2 μm is used.

Eleventh Embodiment

According to an exposure method of an eleventh embodiment of the present invention, a relation between the amount of chlorine contained in the resist and the intensity of X rays absorbed by the resist was examined where an exposure apparatus basically similar to that of the first embodiment of the present invention was used. Here, the acceleration energy of the synchrotron radiation source was 800 MeV, the deflection magnetic field intensity was 4.5 T and platinum (Pt) was used for the material constituting the reflection surface of the X-ray mirror. The angle of incidence of X rays on the X-ray mirror was 89.5°. Two X-ray mirrors were employed. The membrane of the X-ray mask was made of diamond and the membrane was 20 μm in thickness. The window was made of beryllium and 30 μm in thickness. The exposure apparatus under these conditions was used to examine the relation between the intensity and wavelength of X rays absorbed by the resist which contains chlorine with its content varied. The resultant relation is shown in Fig. 16.

Referring to Fig. 16, the relation is shown between the intensity of X rays absorbed by a resist and the wavelength of X rays regarding conventional resists of PMMA ($C_5H_8O_2$) and ZEP ($C_{13}H_{15}ClO_2$). Further, there is shown the intensity of X rays for each wavelength that are absorbed by a resist of the present invention containing chlorine (Cl) instead of hydrogen (H) of the ZEP. In Fig. 16, "ZEP Cl 3 1.0 μm" shown in the third line, for example, means that three hydrogen atoms of ZEP in the resist are displaced with three chlorine atoms and the resist is applied onto the substrate to the thickness of 1.0 μm to radiate X rays to the resist. In order to confirm effects of chlorine, the intensity of X rays absorbed by a resist containing chlorine (density: 1.0 g/cm$^3$) and applied onto the substrate to the thickness of 1.0 μm was also determined through a simulation. In Fig. 16, "Cl (1.0) 1.0 μm" in the bottom line means that the chlorine is a pure substance having the density of 1.0 g/cm$^3$ and the resist is applied onto the substrate to the thickness of 1.0 μm.

In Fig. 16, the content of chlorine in the resists increases in the order of PMMA, ZEP, ZEP Cl 3, ZEP Cl 6, ZEP Cl 10, and Cl. It is seen that, as the content of chlorine increases, the intensity of X rays absorbed by the resist increases. In other words, it is advantageous for enhancement of the resist-absorbed X-ray intensity and improvement of sensitivity to increase the content of chlorine in the resist.

According to the present invention, the resist may contain, instead of chlorine as described above, bromine, silicon, phosphorus, sulfur, fluorine or iodine. Preferably, the content of any element in the resist is 20 % by mass or higher. Then, the effect of shorter wavelength of X rays absorbed by the resist can surely be achieved.

According to the exposure method of the eleventh embodiment of the present invention as shown in Fig. 16, the wavelength of X rays radiated to the resist is sufficiently short since the above-described system of the exposure apparatus is used. Then, the average wavelength of X rays absorbed by the resist is short enough ($4 \times 10^{-10}$ m or shorter) without depending on the amount of chlorine.

## Twelfth Embodiment

According to an exposure method of a twelfth embodiment of the present invention, effects obtained by varying the angle of incidence of X rays on the X-ray mirror were examined where an X-ray exposure apparatus employed was basically similar to that shown in Fig. 1. Specific exposure conditions were that the acceleration energy of synchrotron radiation source 1 was 800 MeV, deflection magnetic field intensity was 4.5 T, and nickel (Ni) was used for the material constituting the X-ray reflection surfaces of X-ray mirrors 3a and 3b. Two X-ray mirrors were used as shown in Fig. 1. Window 4 made of beryllium had a thickness of 20 μm. Membrane 6 of X-ray mask 8 was made of diamond and 20 μm in thickness. Resist 10 was simulated by means of chlorine with a density of 1.0 g/cm$^3$. In this system, the angle of incidence of X rays on the X-ray mirrors was varied to examine influences of the varied incident angle on the intensity of X rays radiated to the resist and the intensity of X rays absorbed by the resist. Results are shown in Figs. 17 and 18.

Indications in Figs. 17 and 18 are as follows. For example, "Ni8.85 (88.8) in the top line of Fig. 17 means that nickel (Ni) is used for the material constituting the reflection surfaces of the X-ray mirrors, the density of nickel is 8.85 (g/cm$^3$), and the angle of incidence of X rays on the X-ray mirrors is 88.8°.

As seen from Fig. 17, as the incident angle relative to the X-ray mirrors increases, namely, as the oblique incident angle relative to the X-ray mirrors decreases (X rays are incident at a smaller angle), the intensity of X rays radiated to the resist increases. Moreover, the average wavelength of radiated X rays decreases simultaneously.

It is also seen from Fig. 18 that, since X rays of longer wavelength are not absorbed by the resist, the average wavelength of X rays absorbed by the resist (average resist-absorbed wavelength) is equal to or shorter than the average wavelength of X rays radiated to the resist.

## Thirteenth Embodiment

According to an exposure method of a thirteenth embodiment of the present invention, rhodium (Rh) was used for the material constituting the reflection surface of the X-ray mirror, and effects of varied angle of incidence of X rays on the X-ray mirror were examined where an X-ray exposure apparatus basically similar to that of the twelfth embodiment was used except that the material constituting the reflection surface of the X-ray mirror was not nickel but rhodium. Using this system, it was examined how the intensity of X rays radiated to the resist and the intensity of X rays absorbed by the resist changed as the angle of incidence of X rays on the X-ray mirror was varied. Results are shown in Figs. 19 and 20.

Referring to Fig. 19, the graph is represented in a manner basically the same as that of Fig. 17. From Fig.

19, it is seen that, when rhodium is used for the material constituting the reflection surface of the X-ray mirror, a greater incident angle provides a higher intensity of X rays radiated to the resist as well as a shorter average wavelength of X rays radiated to the resist, as seen for the twelfth embodiment.

Referring to Fig. 19, X rays radiated to the resist have a spectrum with peaks respectively in two wavelength regions (two peaks). Referring to Fig. 20, X rays in a region of wavelength greater than $4.5 \times 10^{-10}$ m are absorbed by the resist by a relatively small amount. Consequently, the average wavelength of X rays absorbed by the resist (average resist-absorbed wavelength) is equal to or smaller than the average wavelength of X rays radiated to the resist shown in Fig. 19.

Fourteenth Embodiment

According to an exposure method of a fourteenth embodiment of the present invention, osmium (Os) was used for the material constituting the reflection surface of the X-ray mirror and effects of the angle of incidence of X rays on the X-ray mirror when the incident angle was varied were examined, where an X-ray exposure apparatus basically similar to that of the twelfth embodiment was used except that the material constituting the reflection surface of the X-ray mirror was osmium. Similarly to the twelfth and thirteenth embodiments of the present invention, the X-ray incident angle on the X-ray mirror was varied and a relation between the intensity of X rays radiated to the resist and the wavelength as well as a relation between the intensity of X rays absorbed by the resist and the wavelength of X rays were determined through simulations. Results are shown in Figs. 21 and 22.

Referring to Figs. 21 and 22, the graphs are represented in a manner basically similar to that of Figs. 19 and 20. As shown in Fig. 21, a greater angle of incidence of X rays on the X-ray mirror provides a higher intensity of X rays radiated to the resist and a shorter average wavelength of X rays radiated to the resist. As shown in Fig. 22, regarding X rays absorbed by the resist, X-ray components in a region of long wavelength are cut off and X rays with a wavelength of $4.5 \times 10^{-10}$ m or shorter are chiefly absorbed by the resist. As a result, the average wavelength of X rays absorbed by the resist (average resist-absorbed wavelength) is equal to or shorter than the average wavelength of X rays radiated to the resist shown in Fig. 21.

Fifteenth Embodiment

Using the exposure apparatus examined according to the fourteenth embodiment of the present invention described above, the thickness of the membrane, made of diamond, of the X-ray mask was defined as 2 μm to make a similar examination to that of the fourteenth embodiment (the thickness of the diamond membrane of the fourteenth embodiment was 20 μm). Results are shown in Figs. 23 and 24 corresponding respectively to Figs. 21 and 22.

Referring to Fig. 24, the average wavelength of X rays absorbed by the resist (average resist-absorbed wavelength) is approximately $6 \times 10^{-10}$ m. However, it is seen from Fig. 24 that a considerable amount of X rays having the wavelength of $7 \times 10^{-10}$ m or longer are absorbed by the resist. Further, Figs. 23 and 24 are compared to find that the average wavelength of X rays absorbed by the resist is somewhat longer than the average wavelength of X rays radiated to the resist. Then, a relatively large thickness of the membrane of the X-ray mask that is made of diamond is preferable, which is seen from comparison between the fourteenth and fifteenth embodiments of the present invention. Diamond provided as the membrane of the X-ray mask may be arranged at any position in the beam line to allow X rays to be transmitted like X rays transmitted through a filter.

Sixteenth Embodiment

According to an exposure method of a sixteenth embodiment of the present invention, the thickness of the membrane, made of diamond, of the X-ray mask was varied to examine how the average wavelength of X rays absorbed by the resist changed, where an X-ray exposure apparatus basically similar to that shown in Fig. 1 was used. The acceleration energy of the synchrotron radiation source was 700 MeV, the deflection magnetic field intensity was 4.5 T, the material constituting reflection surfaces of X-ray mirrors 3a and 3b was ruthenium (Ru) and the roughness of the reflection surfaces was $6 \times 10^{-10}$ m in rms value. The thickness of window 4 made of beryllium was 20 μm. Membrane 6 of X-ray mask 8 was made of diamond, and resist 10 contained 40 % by mass of chlorine. The thickness of membrane 6 made of diamond was varied to determine the average wavelength of X rays absorbed by the resist through simulations. Results are shown in Fig. 25. Here, the resist contains ZEP. Three hydrogen atoms of ZEP in the resist are displaced with three chlorine ($C\ell$) atoms.

It is seen from Fig. 25 that the increase in the thickness of the membrane causes the average wavelength of X rays absorbed by the resist to be shorter. Accordingly, enhancement of resolution by decreasing the average wavelength of X rays absorbed by the resist would effectively be achieved by increasing the thickness of the membrane made of diamond to some extent as understood from Fig 25.

Moreover, it is seen from Fig. 25 that the average wavelength of X rays absorbed by the resist decreases by a relatively large degree as the thickness of the membrane increases from 0 μm to 5 μm while the average wavelength of X rays absorbed by the resist decreases by a relatively small degree when the membrane is 5 μm or greater in thickness. (The average wavelength of absorbed X rays linearly decreases when the thickness of the membrane is 5 μm or greater.) In other words, the degree of decrease in the average wavelength of X rays absorbed by the resist is different between the thickness of the membrane greater than 5 μm and that smaller than 5 μm. The thickness of 5 μm or greater of the membrane makes it possible to decrease the average wavelength of X rays absorbed by the resist like the wavelength equal to or smaller than $7 \times 10^{-10}$ m.

Seventeenth Embodiment

An exposure apparatus basically similar to that of the sixteenth embodiment of the present invention was used and rhodium (Rh) was used for the material constituting the reflection surface of the X-ray mirror. In a similar manner to that of the sixteenth embodiment, a relation between the thickness of the membrane and the average wavelength of X rays absorbed by the resist was determined through simulations. Results are shown in Fig. 26. The X-ray exposure apparatus and an exposure method according to the seventeenth embodiment are similar to those examined for the sixteenth embodiment except for the material constituting the reflection surface of the X-ray mirror.

As shown in Fig. 26, a greater thickness of the membrane provides a shorter average wavelength of X rays absorbed by the resist, which is basically the same as the results obtained according to the sixteenth embodiment. Here, rhodium is used as a material constituting the reflection surface of the X-ray mirror. The average wavelength of X rays absorbed by the resist sharply drops when the thickness of the membrane is 0 to 5 μm, as found for the sixteenth embodiment of the present invention. Then, the thickness of the membrane equal to or greater than 5 μm can provides the average wavelength of X rays absorbed by the resist that is equal to or smaller than $7 \times 10^{-10}$ m.

Eighteenth Embodiment

According to an exposure method of an eighteenth embodiment of the present invention, a relation was examined between the thickness of the filter, which is a transmission film, made of beryllium allowing X rays to pass and the average wavelength of X rays absorbed by the resist. Here, an exposure apparatus and the exposure method used here were basically similar to those of the sixteenth embodiment of the present invention. Specifically, the acceleration energy of the synchrotron radiation source was 700 MeV, deflection magnetic field intensity was 4.5 T, two X-ray mirrors were used, the reflection surfaces of the X-ray mirrors that reflect X rays were made of ruthenium (Ru), and the reflection surfaces of the X-ray mirrors had a surface roughness of $6 \times 10^{-10}$ m in rms value. The filter made of beryllium was arranged on the beam line of X rays. The filter here includes a window made of beryllium. Membrane 6 of the X-ray mask was made of diamond and 4 μm in thickness. Resist contained 40 % by mass of chlorine. Resist is made of ZEP with three hydrogen atoms displaced with three chlorine atoms. Results are shown in Fig. 27.

Referring to Fig. 27, as the thickness of the beryllium filter increases, the average wavelength of X rays absorbed by the resist decreases. Then, it is seen from Fig. 27 that, enhancement of resolution by decreasing the average wavelength of X rays absorbed by the resist is effectively achieved by increasing the thickness of beryllium filter. Fig. 27 shows that, when the thickness of the beryllium filter is between 0 and 50 μm, the average wavelength of X rays absorbed by the resist sharply decreases as the beryllium filter increases in thickness. When the thickness of the filter is greater than 50 μm, the degree of change in the average wavelength of X rays absorbed by the resist is relatively small. The thickness of the beryllium filter equal to or greater than 50 μm can provide a sufficiently shorter average wavelength of X rays absorbed by the resist such as $7 \times 10^{-10}$ m or shorter. The thickness of the beryllium filter is preferably 100 μm or greater. In this way, the average wavelength of X rays absorbed by the resist can be approximately $6 \times 10^{-10}$ m or smaller.

Then, X rays in a short wavelength region can surely be used for the exposure process. The thickness of window 4 made of beryllium that serves as a vacuum partition may be increased to 50 μm or greater or at least one filter made of another beryllium film may be used in addition to window 4 to allow X rays to be transmitted through the filter. In this case, the total thickness of window 4 and the additional filter(s) that is 50 μm or greater can provide the above-described effects.

The material for the filter transmitting X rays may be any except for beryllium. For example, diamond or boron nitride may be used. Instead of diamond as a material constituting membrane 6 of the X-ray mask, boron nitride may be used. Regarding the filter and membrane serving as transmission films, the thickness, in the direction of travel of X rays, of the portion formed of diamond and boron nitride is multiplied by 10 to use the resultant value as evaluation value of diamond and boron nitride. The thickness, in the direction of travel of X rays, of the portion formed of beryllium is used as evaluation value of beryllium. In the direction of travel of X rays, the total evaluation value as described above of materials constituting the filter and membrane is preferably 50 or greater. Then, a sufficiently short average wavelength of X rays absorbed by the resist can be obtained as accomplished by the above-described method.

## Nineteenth Embodiment

According to an exposure method of a nineteenth embodiment of the present invention, a relation was examined between the surface roughness of the reflection surface of the X-ray mirror, the intensity of X rays absorbed by the resist (resist-absorbed X-ray intensity) and the average wavelength of X rays absorbed by the resist (average resist-absorbed wavelength). Here, an exposure apparatus used was basically the same as that of the eighteenth embodiment except that the surface roughness of the X-ray mirror having the reflection surface made of ruthenium was varied. The thickness of the window made of beryllium was 100 μm and a filter made of diamond was arranged on the beam line of X rays for transmitting X rays through the filter as well as through the window made of beryllium. The filter was 1 μm in thickness. The membrane of the X-ray mask was made of diamond and 20 μm in thickness. The resist used contains 40 % by mass of chlorine like that used for the eighteenth embodiment.

The present invention has one object of providing X-ray exposure with a high resolution using X rays of shorter wavelength than that for the conventional technique by optimizing materials for the mirror, filter, membrane of the X-ray mask, and resist. As generally known, when the surface of the mirror has a certain roughness, light of a shorter wavelength provides a smaller reflectance due to scattering on the surface of the X-ray mirror. This state is represented by the following Debye-Waller formula:

$$\text{reflection loss by roughness} = 1 - \exp(-(4\pi\sigma\sin\theta/\lambda)^2)$$

where σ represents rms roughness, θ represents angle formed by the reflection surface of the mirror and incident X rays and λ represents wavelength of X rays.

The above Debye-Waller formula was used to determine a relation between the surface roughness of the X-ray mirror and the intensity of X rays absorbed by the resist. Results are shown in Fig. 28.

As shown in Fig. 28, as the surface roughness of the X-ray mirror increases, the intensity of X rays absorbed by the resist decreases. There is a tendency that a smaller surface roughness provides a smaller rate of decrease in the intensity of X rays absorbed by the resist as the surface roughness increases. For the region of surface roughness of the X-ray mirror that exceeds $4 \times 10^{-10}$ m in rms value, the intensity of X rays absorbed by the resist remarkably decreases. The reduced intensity of X rays absorbed by the resist results in increase in the exposure time required for obtaining a predetermined exposure amount.

Moreover, according to the exposure method described above, a relation between the surface roughness of the X-ray mirror and the average wavelength of X rays absorbed by the resist was determined through simulations. Results are shown in Fig. 29.

Referring to Fig. 29, as the surface roughness of the X-ray mirror increases, the average wavelength of X rays absorbed by the resist increases. It is seen from Fig. 29 that, in the region of the surface roughness of the X-ray mirror that exceeds $6 \times 10^{-10}$ m in rms value, the rate of increase in the average wavelength of X rays absorbed by the resist increases. From Figs. 28 and 29, it is understood that the surface roughness of the X-ray mirror that has a considerably great value in rms value causes increase in the exposure time as well as increase in the average wavelength of X rays absorbed by the resist, resulting in difficulty in enhancement of resolution. Then, preferably the surface roughness of the X-ray mirror is $6 \times 10^{-10}$ m or smaller in rms value.

## Twentieth Embodiment

According to an exposure method of a twentieth embodiment of the present invention, influences of the average wavelength of radiation emitted from the synchrotron radiation source serving as the X-ray source on the intensity of X rays absorbed by the resist was examined. For Case 1, the acceleration energy of the synchrotron radiation source was 585 MeV and deflection magnetic field intensity was 3.29 T. In this case, light emitted from the synchrotron radiation source has an average wavelength of $7 \times 10^{-10}$ m. An exposure apparatus used here was basically the same as that of the first embodiment of the present invention. Two X-ray mirrors were used and the reflection surfaces of the X-ray mirrors were made of platinum. The window made of beryllium was 20 μm in thickness. The membrane of the X-ray mask was made of diamond and 20 μm in thickness. In this exposure apparatus, the resist simulated by chlorine (density: 1.0 g/cm$^3$) was used to determine a relation between the intensity of X rays absorbed by the resist and the wavelength of X rays through simulations. Results are shown in Fig. 30.

Fig. 30 also shows data for the conventional resist of PMMA presented for comparison. In Fig. 30, "PMMA (1.11) 1 μm" means that PMMA is used for the resist, the density of the resist is 1.11 g/cm$^3$ and the applied resist has a thickness of 1 μm.

Referring to Fig. 30, the average wavelength of X rays absorbed by the resist of PMMA is 5.36 × $10^{-10}$ m while that absorbed by the resist simulated by chlorine is 4.16 × $10^{-10}$ m. Namely, the average wavelength of X rays absorbed by the resist is smaller than that by the conventional PMMA resist. Moreover, the intensity of X rays absorbed by the resist of chlorine is 4.21 times as high as that by the PMMA resist, and thus an enhanced sensitivity is achieved.

For Case 2 of the exposure method of the twentieth embodiment, the same exposure apparatus as that for Case 1 described above was used. Here, the acceleration energy of the synchrotron radiation source was 800 MeV and deflection magnetic field intensity was 4.5 T. In this case, the average wavelength of light emitted from the synchrotron radiation source was 2.7 × $10^{-10}$ m. A relation between the intensity of X rays absorbed by the resist and the wavelength of X rays (spectrum of X rays absorbed by the resist) is shown in Fig. 31. In Fig. 31, data for the conventional PMMA resist is also shown for comparison.

Referring to Fig. 31, the average wavelength of X rays absorbed by the resist simulated by chlorine is 3.71 × $10^{-10}$ m which is shorter than that of Case 1 shown in Fig. 30. In addition, the intensity of X rays absorbed by the resist is 6.90 times as high as that absorbed by the conventional PMMA resist. In other words, a shorter average wavelength of light emitted from the synchrotron radiation source provides the advantages that the average wavelength of X rays absorbed by the resist decreases and that the intensity of the X rays absorbed by the resist increases. (The present invention is not limited to the synchrotron radiation source as an X-ray source.) When X rays of wavelength equal to or shorter than 7 × $10^{-10}$ m are used for exposure, preferably the average wavelength of light emitted from the synchrotron radiation source is defined as 6 × $10^{-10}$ m or shorter.

Twenty-First Embodiment

According to an exposure method of a twenty-first embodiment of the present invention, influences of the thickness of the membrane of the X-ray mask, when the thickness was varied, were examined. Specifically, the thickness of the membrane of the X-ray mask was varied in the range of 1 μm to 100 μm and the intensity of X rays absorbed by the resist was determined through simulations. For the exposure method, the acceleration energy of the synchrotron radiation source was 800 MeV, deflection magnetic field intensity was 4.5 T, and the thickness of the window made of beryllium was 20 μm. The membrane of the X-ray mask was made of diamond. Regarding other data, an exposure apparatus basically the same as that of the present invention was used. Specifically, the X-ray mirrors were made of cobalt, the beryllium window was 20 μm in thickness, and the membrane of the X-ray mask was made of diamond.

Results are shown in Fig. 32. In Fig. 32, data obtained by the conventional exposure method is also shown. In Fig. 32, "SiC, SiC, PMMA" represents data for the conventional exposure method using two X-ray mirrors with reflection surfaces made of SiC and using the PMMA resist. Indications following "SiC, SiC, PMMA" are basically similar to those for the graph in Fig. 2.

Referring to Fig. 32, regarding the conventional exposure method (indicated by "SiC, SiC, PMMA") by which X rays of wavelength equal to or longer than 7 × $10^{-10}$ m are used for exposure, the intensity of X rays absorbed by the resist when the thickness of the membrane is 20 μm is 1/40th as high as or lower than that when the thickness of the membrane is 2 μm. Regarding the conventional exposure method using the conventional resist of any material except for PMMA, the intensity of X rays absorbed by the resist when the thickness of the membrane is 20 μm is 1/20th as high as or lower than that when the membrane thickness is 2 μm.

Regarding the exposure method of the present invention, the intensity of X rays absorbed by the resist simulated by such a material as chlorine and silicon when the thickness of the membrane is 20 μm is one-third to one-fifth as high as that when the membrane thickness is 2 μm. In other words, according to the present invention, the rate of decrease in the intensity of X rays absorbed by the resist when the membrane thickness increases is remarkably small compared with the conventional exposure method. Namely, according to the present invention, even if the membrane is thicker than the conventional one, a sufficiently high intensity of X rays absorbed by the resist can be ensured. Then, the membrane can have a greater thickness than the conventional one. As the thickness of the membrane of the X-ray mask can be increased, the mechanical strength of the X-ray mask can easily be enhanced and the accuracy of the X-ray mask can also be enhanced advantageously.

For each data shown in Fig. 32, a relation between the thickness of the membrane and the average wavelength of X rays absorbed by the resist was determined through simulations. Results are shown in Fig. 33.

Referring to Fig. 33, according to the present invention, it is possible to have the average wavelength of X rays absorbed by the resist that is approximately 3 × $10^{-10}$ m. In consideration of the thickness of the conventional membrane that is in the range of 1 to 2 μm (the average wavelength of X rays absorbed by the resist is approximately 9 × $10^{-10}$ m), the present invention achieves a remarkable decrease in the average wavelength of X rays absorbed by the resist, from 9 × $10^{-10}$ m to 3 × $10^{-10}$ m. Then, the present invention can enhance the resolution more easily than the conventional method.

Twenty-Second Embodiment

According to an exposure method of a twenty-second embodiment of the present invention, for study of the thickness of the X-ray absorber film of the X-ray mask, simulations were conducted to examine mask contrast (ratio between the intensity of X rays absorbed by the resist having been transmitted through the X-ray absorber film of the X-ray mask and that transmitted through the X-ray mask without the X-ray absorber film).

As transfer patterns transferred by X-ray exposure become finer in size, X rays of shorter wavelength can be used. Such X rays of shorter wavelength have a high transmitting capability and thus the thickness of the X-ray absorber film of the X-ray mask must be increased. In this case, in etching for forming a pattern on the X-ray absorber film of the X-ray mask, the aspect ratio (the ratio of the thickness of the X-ray absorber film to the width of the pattern) increases. The increased aspect ratio results in difficulty in fabrication of the X-ray mask. In order to overcome this problem, it would be preferable that a predetermined mask contrast is obtained with a thinner X-ray absorber film. The thinner X-ray absorber film allows prevention of positional distortion of the transfer pattern of the X-ray mask due to oxidation of sidewalls and accordingly provides improvement in the accuracy of the shape of the X-ray mask.

Here, the mask contrast was determined through simulations by using the X-ray absorber film with a fixed thickness and varying the thickness of the membrane to analyze the contrast through comparison.

The simulations were conducted on the conditions that the acceleration energy of the synchrotron radiation source was 700 MeV, deflection magnetic field intensity was 4.5 T, and an exposure apparatus basically the same as that shown in Fig. 1 of the first embodiment was used. Further, the angle of incidence of X rays on the X-ray mirror was 89°. The window made of beryllium was 20 µm in thickness, and the X-ray absorber film of the X-ray mask was made of tungsten with a density of 16.0 g/cm$^3$ and a thickness of 0.3 µm.

For a comparative exposure method, SiC was used as the material constituting the reflection surface of the X-ray mirror and SiC was also used for the membrane of the X-ray mask. Regarding the resist, a PMMA resist was used as a conventional resist and resists simulated by using chlorine, sulfur, phosphorus, silicon and bromine respectively were used as resists of the present invention. Results are shown in Fig. 34. Preferably, the exposure method according to the present invention uses a resist containing at least one of chlorine, sulfur, phosphorus, silicon and bromine. In addition, the total content of chlorine, sulfur, silicon and bromine in the resist is preferably at least 20 % by mass.

Referring to Fig. 34, according to the comparative conventional exposure method, the results have almost no difference depending on the resists except for the resist of bromine. When any of the resists is used, the contrast decreases as the thickness of the SiC membrane increases. For example, when the membrane is 2 µm in thickness which is a standard membrane thickness, the contrast is 2.32 for the resist simulated by bromine while the contrast for other resists is approximately 2.8. When the thickness of the membrane is 10 µm, the contrast is 2.1 for the resist of bromine while the contrast for other resists is approximately 2.3, and thus the contrast deteriorates for any resist.

Simulations were also conducted for the exposure method according to the present invention similarly to the conventional exposure method as described above. The simulations were conducted under the conditions that the acceleration energy of the synchrotron radiation source and the deflection magnetic field intensity were the same as those as shown in Fig. 34, and two X-ray mirrors having reflection surfaces made of cobalt were used. The angle of incidence of X rays on the X-ray mask was 89°. The window made of beryllium had a thickness of 20 µm, and the X-ray absorber film was made of tungsten having a density of 16.0 g/cm$^3$ and a thickness of 0.3 µm. The membrane was made of diamond. The diamond membrane allows the peak wavelength of X rays absorbed by the resist to be shorter than that absorbed by the membrane and accordingly the resolution of a pattern transferred to the resist can be higher than that obtained by the conventional exposure method. According to this exposure method of the present invention, the contrast was determined through simulations by varying the thickness of the diamond membrane. Results are shown in Fig. 35.

Referring to Fig. 35, data are indicated in a manner basically the same as that of Fig. 34. As shown in Fig. 35, when the thickness of the diamond membrane is 2 µm which is a standard value, the contrast has the value of approximately 3 or greater for any resist material. In particular, for the resist simulated by silicon, the contrast is approximately 4.2 which is remarkably great. The reason could be that the peak wavelength of X rays absorbed by the resist is in a range of wavelength in which the peak of X rays absorbed by the silicon constituting the X-ray absorber film (respective wavelength regions of resist-absorbed X rays and X-ray absorber film-absorbed X rays respectively with a relatively high intensity in which respective peak wavelengths are included partially or totally overlap), and thus X rays in the wavelength region to be used for exposure process can surely be absorbed by the X-ray absorber film.

For the region of the thickness of the diamond membrane that is 10 µm or smaller, the contrast depends on the thickness of the membrane to a considerably smaller degree compared with the conventional exposure method. In other words, when the membrane thickness is 10 µm or smaller, the contrast has almost the same value. Namely, the exposure method of the present invention shown in Fig. 35 can provide the contrast almost the same as that of the conventional one even if the thickness of the membrane is increased to a certain extent while the thickness of the X-ray absorber film is made shorter than the conventional one.

Although the membrane thickness is increased here, similar effects can be obtained by providing a diamond film in addition to the membrane that transmits X rays and thus increasing the total diamond film thickness on the beam line of X rays.

Twenty-Third Embodiment

According to an exposure method of a twenty-third embodiment of the present invention, study was conducted on a combination of a material for the X-ray mask exhibiting a high contrast and a material for the resist. Specifically, an exposure apparatus basically the same as that of the first embodiment shown in Fig. 1 was used, the acceleration energy of the synchrotron radiation source was 700 MeV, deflection magnetic field intensity was 4.5 T, cobalt (Co) was used for the material constituting the reflection surface of the X-ray mirror, and the angle of incidence of X rays on the X-ray mirror was 89.3°. The thickness of the window made of beryllium was 20 μm and the X-ray absorber film made of tungsten having a density of 16.2 g/cm$^3$ was used. The X-ray absorber film was 0.3 μm in thickness. The membrane of the X-ray mask was made of diamond. This exposure apparatus was used to conduct simulations to determine the contrast of various types of resists when the thickness of the membrane was changed. Results are shown in Fig. 36.

Under conditions almost similar to those shown in Fig. 36, the X-ray absorber film made of gold having a density of 19.32 g/cm$^3$ was used to determine the relation between the membrane thickness and the contrast through simulations. Results are shown in Fig. 37. Data in Figs. 36 and 37 are shown in a similar manner to those shown in Figs. 34 and 35.

Referring to Fig. 36, it is seen that the contrast is enhanced by using tungsten for the X-ray absorber film and silicon for simulating the resist. Then, the X-ray mask of the present invention can be fabricated by using such materials as diamond for the membrane and tungsten for the X-ray absorber film, the materials having proven process characteristics. The X-ray mask can thus be produced relatively easily to carry out the exposure method of the present invention.

Further, it is seen from Fig. 37 that, when the X-ray absorber film is made of gold, an almost constant contrast can be achieved by the membrane with its thickness range larger than that when tungsten is used for the X-ray absorber film.

Referring to Figs. 36 and 37, when different X-ray absorber films are used, a higher contrast is achieved by different resists. For example, the contrast obtained when the resist simulated by silicon is used is examined. When the membrane of diamond is 10 μm in thickness and the X-ray absorber film is made of tungsten, the contrast is 2.3 while the contrast is 2.8 when the X-ray absorber film is made of gold. On the other hand, when the resist simulated by bromine is used, contrast values obtained respectively by the X-ray absorber film of tungsten and the X-ray absorber film of gold have a relatively small difference therebetween.

According to the present invention, with a certain thickness of the membrane of the X-ray mask, the mask contrast can freely be set by changing the combination of materials for the X-ray absorber film and resist employed. When any mask contrast value is determined in advance, a resist which provides a high contrast can be selected to decrease the thickness of the X-ray absorber and accordingly the X-ray mask can readily by fabricated.

Twenty-Fourth Embodiment

According to an exposure method of a twenty-fourth embodiment of the present invention, a wavelength sweeper for converting the wavelength of X rays is provided which has a structure shown in Fig. 38. Referring to Fig. 38, X-ray mirrors 13 to 15 of the first to the third stages each have a reflection surface made of beryllium.

Referring to Fig. 38, the distance in the x-axis direction between X-ray mirror 13 of the first stage and X-ray mirror 14 of the second stage is a constant value of L. The distance in the x-axis direction between X-ray mirror 14 of the second stage and X-ray mirror 15 of the third stage is also a constant value of L. X-ray mirror 13 of the first stage is fixed in its position and capable of rotating on an axis perpendicular to the plane of Fig. 38. X-ray mirror 14 of the second stage is capable of moving in parallel with y-axis. X-ray mirror 15 of the third stage is also capable of rotating on an axis perpendicular to the plane of Fig. 38 as X-ray mirror 13 of the first stage.

Suppose that the oblique angle of incidence of X rays 16 on X-ray mirror 13 of the first stage is $\alpha$ and the distance in the direction of y-axis between the X-ray mirror 13 of the first stage and X-ray mirror 14 of the second stage is $D\alpha$. Then, the angle of X-ray mirror 15 of the third stage is adjusted so that the oblique angle of incidence of X rays 16 on X-ray mirror 15 of the third stage is $\alpha$. Consequently, the optical axis of X rays 16 emitted from X-ray mirror 15 of the third stage is nearly the same as that of X rays 16 incident on X-ray mirror 13 of the first stage. Here, the oblique angle of incidence of X rays 16 on X-ray mirror 14 of the second stage is $2\alpha$.

Then, suppose that X-ray mirror 13 of the first stage is rotated so that the oblique angle of incidence of X rays 16 on X-ray mirror 13 of the first stage is $\beta$. X-ray mirror 14 of the second stage is moved in parallel with y-axis. X-ray mirror 15 of the third stage is rotated so that the oblique angle of incidence of X rays 16 on X-ray mirror 15 is β. Consequently, the optical axis of X rays 16 emitted from X-ray mirror 15 of the third stage and that incident on X-ray mirror 13 of the first stage are almost the same like those as described above.

In this way, with the same optical axis of X rays 16, the oblique angle of incidence of X rays on X-ray mirrors 13 to 15 can arbitrarily be selected. The angle of incidence (90° - oblique incident angle) of X rays on X-ray mirrors 13 to 15 can thus be changed to easily cut X rays in a region of short wavelength.

The wavelength sweeper shown in Fig. 38 can be applied to the exposure apparatus of the present invention to narrow the range of wavelength of X rays (to obtain narrow band) absorbed by the resist. The mask contrast can further be enhanced in this way.

As described in connection with the twenty-first to twenty-fourth embodiments of the present invention, the present invention can use diamond, which is one of materials having highest rigidity, for the membrane material of the X-ray mask, and make the membrane relatively thicker than the conventional one. The mask contrast can be enhanced to reduce the thickness of the X-ray absorber film of the X-ray mask. As a result, the X-ray mask can have an enhanced accuracy.

## Twenty-Fifth Embodiment

Referring to Fig. 39, an exposure method of a twenty-fifth embodiment according to the present invention is described.

The exposure methods heretofore described all employ the synchrotron radiation source as an X-ray source. The exposure method shown in Fig. 39 uses a plasma X-ray source 17 as an X-ray source. The effects of the present invention are achievable by such a plasma X-ray source. Specifically, an exposure apparatus 20 shown in Fig. 39 includes a plasma X-ray source 17, a window 4 made of beryllium arranged under plasma X-ray source 17, and an X-ray mask 8. A substrate 9 with its surface having a resist 10 applied thereto is arranged opposite X-ray mask 8. X-ray mask 8 includes a membrane 6 and an X-ray absorber film 7 provided on membrane 6 and having a transfer pattern. X rays emitted from plasma X-ray source 17 are radiated to resist 10 via window 4 and X-ray mask 8. The radiated X rays causes the pattern formed on X-ray absorber film 7 to be transferred to resist 10 and subjected to exposure.

No X-ray mirror as shown in Fig. 1 is used in the exposure apparatus shown in Fig. 39. However, it is possible for the exposure apparatus shown in Fig. 39 to achieve the effects similar to those of the exposure method of the first embodiment according to the present invention by determining a combination of respective materials for resist 10, window 4 and membrane 6 so that transmitting characteristics of window 4 and membrane 6 with respect to X rays as well as absorbing characteristic of resist 10 are determined to accordingly decrease the average wavelength of X rays absorbed by resist 10.

## Twenty-Sixth Embodiment

An exposure method of a twenty-sixth embodiment according to the present invention is described with reference to Fig 40.

Referring to Fig. 40, an exposure apparatus for performing the exposure method of the present invention has a structure basically the same as that of the exposure apparatus shown in Fig. 1 except that the exposure apparatus shown in Fig. 40 has a filter 18 inserted on the upstream side of window 4 in order to prevent window 4 made of beryllium from being heated by X rays and accordingly damaged. Filter 18 may be made of diamond, beryllium or the like. For example, diamond filter 18 is 1 μm in thickness, membrane 6 of X-ray mask 8 is also made of diamond and membrane 6 is 4 μm in thickness. The total thickness of the membrane 6 and filter 18 made of diamond is 5 μm and thus X rays radiated to the resist have the same characteristics as those when membrane 6 is 5 μm in thickness as described in connection with the first embodiment. Then, effects similar to those of the first embodiment can be achieved.

The thickness of membrane 6 is multiplied by 10 and the resultant value is added to the thickness (30 μm) of window 4 made of beryllium. Then, the total thickness is 70 μm. Further, the thickness (1 μm) of diamond filter 18 and the thickness (4 μm) of diamond membrane 6 are each multiplied by 10 and respective resultant values are summed for use the sum as an evaluation value of diamond. Then, the evaluation value is 50. The thickness (30 μm) of beryllium window 4 is used as an evaluation value of beryllium. The sum of respective evaluation values (diamond evaluation value and beryllium evaluation value) is 80. It is understood from this that X rays in a short wavelength region can surely be used.

Moreover, filter 18 made of diamond is used in addition to the membrane, which increases the degree of freedom in selecting the thicknesses of membrane 6 and filter 18 serving as a transmission film.

Twenty-Seventh Embodiment

The resist used for the exposure method of the present invention may be any of chemically amplified resist and non chemically amplified resist if it is sensitive to X rays. The resist may be any of positive resist and negative resist. The resist of the present invention contains at least one selected from the group consisting of silicon, phosphorus, sulfur, chlorine, fluorine and iodine.

Examples of base polymer of the non chemically amplified positive resist are PMMA (polymethylmethacrylate) based one, copolymer of α-methylstyrene and α-chloroacrylate, poly(butene-1-sulfone), novolac resin, poly(2,2,2-trifluoroethyl-2-chloroacrylate) and the like.

As a mixed type, the resist is constituted of two elements, novolac resin and quinonediazide.

Examples of base polymer of the non chemically amplified negative resist are polyglycidyl methacrylate, copolymer of glycidyl methacrylate and ethylacrylate, chloromethylated polystyrene, polyvinylphenol and the like. As a mixed type, the resist is constituted of polyvinylphenol-based resin and azide.

Examples of base polymer of the chemically amplified positive resist are poly(p-butoxycarbonyloxystyrene) with hydroxyl group of polyvinylphenol protected by t-BOC (butoxycarbonyloxy) group, copolymer of vinylphenol with hydroxyl group protected by t-BOC group and non-protected vinylphenol, styrene-maleimide copolymer, poly(4-(t-butoxycarbonyloxy) styrene-sulfone) being copolymer of vinylphenol protected by t-BOC group and sulfone, copolymer of vinylphenol and methylvinylphenol, novolac resin, polyphthalaldehyde (PPA), polyformal, polymer including alkoxy pyrimidine derivative, methacrylate-based polymer and the like.

Examples of base polymer of the chemically amplified negative resist are copolymer of 3-methyl-4-hydroxystyrene and 4-hydroxystyrene, novolac resin, polyvinylphenol resin, poly(2-cyclopropyl-2-propyl-4-vinyl benzoic acid), poly(3-methyl-2-(4-vinylphenol)-2,3-butanediol), and the like.

A part or all of hydrogen atoms in a generally known resin material as described above can be substituted with chlorine, bromine or fluorine atoms to use the resultant resin as base polymer. Alternatively base resin having at least one selected from the group consisting of silicon, sulfur, phosphorus and iodine introduced into the base resin structure can be used to selectively absorb X rays in a short wavelength region.

It is not necessary for the base polymer to contain any element absorbing X rays in a short wavelength region. It is only required for the resist to contain any constituent material having molecules absorbing X rays. Then, the sensitivity of the resist to X rays can be improved.

An acid generating agent included in the chemically amplified resist is not limited to a specific one and applicable to the present invention if the agent is any compound decomposed by optical radiation to generate acid. Specific examples of the compound generating acid are, triphenylsulfonium hexafluoroantimonate, triphenylsulfonium triflate, triphenylsulfonium nonaflate, triphenylsulfonium tosylate, triphenylsulfonium methanesulfonate, triphenylsulfonium ethanesulfonate, triphenylsulfonium propanesulfonate, triphenylsulfonium butanesulfonate, dimethylsulfonium hexafluoroantimonate, dimethylsulfonium triflate, dimethylphenylsulfonium nonaflate, dimethylphenylsulfonium tosylate, dimethylsulfonium ethanesulfonate, dimethylphenylsulfonium ethanesulfonate, dimethylphenylsulfonium propanesulfonate, dimethylphenylsulfonium butanesulfonate, 4-tert-butylphenyldiphenylsulfonium hexafluoroantimonate, 4-tert-butylphenyldiphenylsulfonium triflate, 4-tert-butylphenyldiphenylsulfonium nonaflate, 4-tert-butylphenyldiphenylsulfonium tosylate, 4-tert-butylphenyldiphenylsulfonium methanesulfonate, 4-tert-butylphenyldiphenylsulfonium ethanesulfonate, 4-tert-butylphenyldiphenylsulfonium propanesulfonate, 4-tert-butylphenyldiphenylsulfonium butanesulfonate, tris(4-methylphenyl)sulfonium hexafluoroantimonate, tris(4-methylphenyl)sulfonium triflate, tris(4-methylphenyl)sulfonium nonaflate, tris(4-methylphenyl)sulfonium tosylate, tris(4-methylphenyl)sulfonium methanesulfonate, tris(4-methylphenyl)sulfonium ethanesulfonate, tris(4-methylphenyl)sulfonium propanesulfonate, tris(4-methylphenyl)sulfonium butanesulfonate, tris(4-methoxyphenyl)sulfonium hexafluoroantimonate, tris(4-methoxyphenyl)sulfonium triflate, tris (4-methoxyphenyl)sulfonium nonaflate, tris(4-methoxyphenyl)sulfonium tosylate, tris(4-methoxyphenyl)sulfonium methanesulfonate, tris(4-methoxyphenyl)sulfonium ethanesulfonate, tris(4-methoxyphenyl)sulfonium propanesulfonate, tris(4-methoxyphenyl)sulfonium butanesulfonate, diphenyliodonium hexafluoroantimonate, diphenyliodonium triflate, diphenyliodonium nonaflate, diphenyliodonium tosylate, diphenyliodonium methanesulfonate, diphenyliodonium ethanesulfonate, diphenyliodonium propanesulfonate, diphenyliodonium butanesulfonate, 4-methoxyphenylphenyliodonium hexafluoroantimonate, 4-methoxyphenylphenyliodonium triflate, 4-methoxyphenylphenyliodonium nonaflate, 4-methoxyphenylphenyliodonium tosylate, 4-methoxyphenylphenyliodonium methanesulfonate, 4-methoxyphenylphenyliodonium ethanesulfonate, 4-methoxyphenylphenyliodonium propanesulfonate, 4-methoxyphenylphenyliodonium butanesulfonate, 4,4'-ditert-butyldiphenyliodonium hexafluoroantimonate, 4,4'-ditert-butyldiphenyliodonium triflate, 4,4'-ditert-butyldiphenyliodonium nonaflate, 4,4'-ditert-butyldiphenyliodonium tosylate, 4,4'-ditert-butyldiphenyliodonium methanesulfonate, 4,4'-ditert-butyldiphenyliodonium ethanesulfonate, 4,4'-ditert-butyldiphenyliodonium propanesulfonate, 4,4'-ditert-butyldiphenyliodonium butanesulfonate, 4,4'-dimethyldiphenyliodonium hexafluoroantimonate, 4,4'-dimethyldiphenyliodonium triflate, 4,4'-dimethyldiphenyliodonium nonaflate, 4,4'-dimethyldiphenyliodonium tosylate, 4,4'-dimethyldiphenyliodonium methanesulfonate, 4,4'-dimethyldiphenyliodonium ethanesulfonate, 4,4'-dimethyldiphenyliodonium propanesulfonate, 4,4'-dimethyldiphenyliodonium butanesulfonate, 3,3'-dinitrodiphenyliodonium hexafluoroantimonate, 3,3'-dinitrodiphenyliodonium triflate, 3,3'-dinitrodiphenyliodonium nonaflate, 3,3'-dinitrodiphenyliodonium tosylate, 3,3'-dinitrodiphenyliodonium methanesulfonate, 3,3'-dinitrodiphenyliodonium ethanesulfonate, 3,3'-dinitrodiphenyliodonium propanesulfonate, 3,3'-dinitrodiphenyliodonium butanesulfonate, naphthylcarbonylmethyltetrahydrothiophenyl hexafluoroantimonate, naphthylcarbonylmethyltetrahydrothiophenyl triflate, naphthylcarbonylmethyltetrahydrothiophenyl nonaflate, naphthylcarbonylmethyltetrahydrothiophenyl tosylate, naphthylcarbonylmethyltetrahydrothiophenyl methanesulfonate, naphthylcarbonylmethyltetrahydrothiophenyl ethanesulfonate, naphthylcarbonylmethyltetrahydrothiophenyl propanesulfonate, naphthylcarbonylmethyltetrahydrothiophenyl butanesulfonate, dimethylhydroxynaphthyl hexafluoroantimonate, dimethylhydroxynaphthyl triflate, dimethylhydroxynaphthyl nonaflate, dimethylhydroxynaphthyl tosylate, dimethylhydroxynaphthyl methanesulfonate, dimethylhydroxynaphthyl ethanesulfonate, dimethylhydroxynaphthyl propanesulfonate, dimethylhydroxynaphthyl butanesulfonate, trifluoromethanesulfonyloyloxy succinimide, nonafluorobutanesulfonyloyloxy succinimide, trimethanesulfonyloyloxy succinimide, triethanesulfonyloyloxy succinimide, tripropanesulfonyloyloxy succinimide, tributanesulfonyloyloxy succinimide, toluenesulfonyloyloxy succinimide, trifluoromethanesulfonyloyloxy cyclohexanedicarboximide, nonafluorobutanesulfonyloyloxy cyclohexanedicarboximide, trimethanesulfonyloyloxy cyclohexanedicarboximide, triethanesulfonyloyloxy cyclohexanedicarboximide, tripropanesulfonyloyloxy cyclohexanedicarboximide, tributanesulfonyloyloxy cyclohexanedicarboximide, toluenesulfonyloyloxy cyclohexanedicarboximide, trifluoromethanesulfonyloyloxy norbornenedicarboximide, nonafluorobutanesulfonyloyloxy norbornenedicarboximide, trimethanesulfonyloyloxy norbornenedicarboximide, triethanesulfonyloyloxy norbornenedicarboximide, tripropanesulfonyloyloxy norbornenedicarboximide, tributanesulfonyloyloxy, and norbornenedicarboximide, toluenesulfonyloyloxy norbornenedicarboximide.

Preferable onium salt compounds among the compounds listed above are diphenyliodonium triflate, triphenylsulfonium triflate, triphenylsulfonium hexafluoroantimonate, and triphenylsulfonium tetrafluoroborate because of their high rate of acid generation by optical radiation. Other preferable compounds are nitrobenzylsulfonate, n-iminosulfonate, 1,2-diazonaphthoquinone-4-sulfonate, $\alpha$-sulfonyloxyketone, $\alpha$-hydroxymethyl benzoin sulfonate and the like.

Examples of halogenated compounds are tris(trihalogenated methyl)-s-triazine derivative, trihalogenated phenol derivative, DDT derivative and trichloromethyl-s-triazine. Examples of trichloroacetophenone sulfone compounds are disulfone, bis(allylsulfonyl)diazomethane, and allylcarbonyl allylsulfonyl diazomethane.

Examples of protecting group of the chemically amplified positive resist are t-BOC group, isopropoxycarbonyl group (i-PrOC), tetrahydropyranyl group, trimethylsilylether group, t-butoxycarbonylmethyl group (tBOC-$CH_2$) and the like. The protecting group is not limited to the above specific examples.

Examples of resin containing decomposition group and dissolution inhibiting agent are polycarbonate, naphthalene t-buthylcarboxylate, naphthyl t-buthylcarbonate, biphenyl t-buthylether, THP-M, 2-methylpentene 1-sulfone (PMPS) and the like.

For the acid generating agent, protecting group and dissolution inhibiting agent, any compound or resin containing hydrogen atoms in molecules partially or totally substituted with atoms of at least one element selected from the group consisting of chlorine, bromine, fluorine and iodine is used as a composition of the resist. Alternatively, any compound or resin having in its structure at least one selected from the group consisting of silicon, sulfur, phosphorus, and iodine can be used as a resist composition to selectively absorb X rays in short wavelength region. Consequently, a pattern can be transferred with a high resolution.

It is not necessarily required for all resist compositions to contain any element absorbing X rays in short wavelength region. Any compound or resin as a component of the resist may contain an element absorbing X rays in short wavelength region to achieve effects of the present invention. Namely, the sensitivity of the resist can be improved.

Preferably, the resist according to the present invention, for example, the resist used for the first embodiment and resists for the second to twenty-eighth embodiments of the present invention, has the total content of an element selected from the group consisting of bromine, silicon, phosphorus, sulfur, chlorine, fluorine and iodine that is 20 % or higher in mass. Then, a sufficiently high intensity of X rays in short wavelength region absorbed by the resist film can be achieved.

Specific compounds and resin materials containing any element absorbing X rays in short wavelength region are described in connection with examples discussed later.

Twenty-Eighth Embodiment

Solvent of a resist, which is used for an exposure method according to the present invention, is mixed with hydrocarbon including at least one selected from the group consisting of bromine, silicon, phosphorus, sulfur and chlorine, and resist baking conditions are adjusted. As a result, the resist used in an exposure process that contains at least one element selected from the group consisting of bromine, silicon, phosphorus, sulfur and chlorine can be obtained. In this way, instead of including the element as described above in a high polymer material constituting the resist, the resist including an element such as chlorine in the solvent can be used for the exposure method of the first embodiment of the present invention to accomplish effects similar to those obtained by the twenty-seventh embodiment as discussed above. The above-described resist is also applicable to the exposure methods according to the first to the twenty-sixth embodiments.

The first to twenty-eighth embodiments of the present invention are applicable not only to a manufacturing process of semiconductor devices but also to a manufacturing process of other microstructures.

## Examples

According to the present invention, for the composition of the resist, hydrogen atoms in resin or compound constituting the resist can partially or totally be substituted with atoms of at least one selected from the group consisting of chlorine, bromine, fluorine and iodine. Alternatively, for the composition of the resist, compound or resin having its structure in which at least one selected from the group consisting of silicone, sulfur, phosphorus and iodine can be used. Resin or compound constituting the resist applicable to the present invention is shown below.

### Example 1

Table 3 shows examples of resists according to the present invention, that are non chemically amplified positive resists of resin based on copolymer of α-methylstyrene and α-chloroacrylate.

Table 3

| | ID | chemical formula | structural formula |
|---|---|---|---|
| comparative example | ZEP | $C_{13}H_{15}ClO_2$ | α methylstyrene $C_9H_{10}$ α methyl chloroacrylate $C_4H_5ClO_2$ 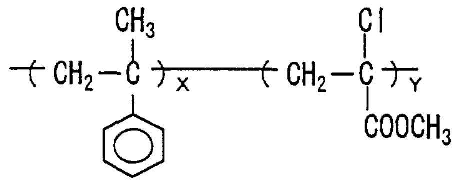 |
| sample | ZEP+$Cl_9$ | $C_{13}H_6Cl_{10}O_2$ | 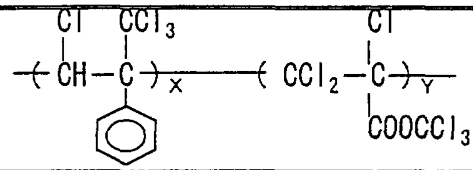 |
| | ZEP+$Cl_5$ | $C_{13}H_{10}Cl_6O_2$ | 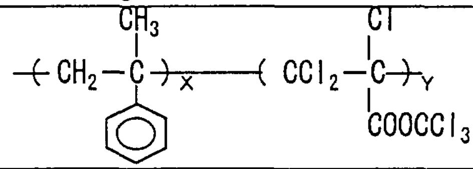 |
| | ZEP+$Cl_4$ | $C_{13}H_{11}Cl_5O_2$ | 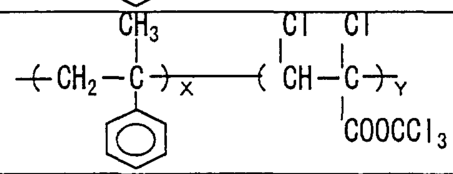 |
| | ZEP+$Cl_3$ | $C_{13}H_{12}Cl_4O_2$ | 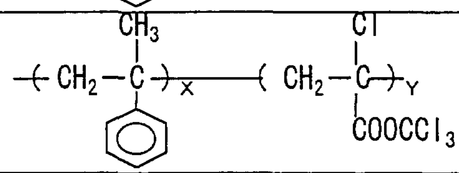 |
| | ZEP+$Cl_2$ | $C_{13}H_{13}Cl_3O_2$ | 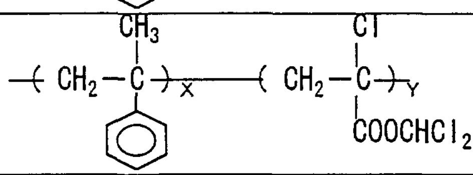 |
| | ZEP+$Cl_1$ | $C_{13}H_{14}Cl_2O_2$ | 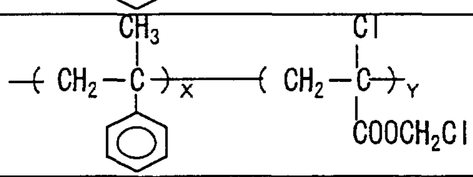 |
| | ZEP+Br | $C_{13}H_5Br_{10}ClO_2$ | 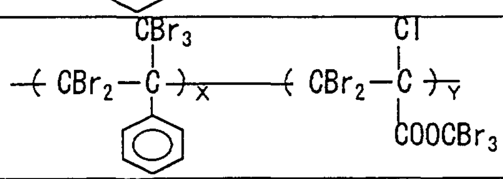 |
| | ZEP+F | $C_{13}H_5F_{10}ClO_2$ | 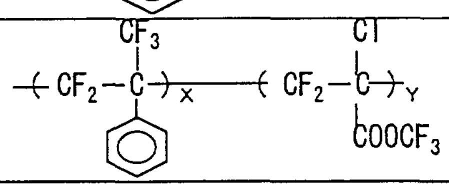 |

<u>Example 2</u>

Table 4 shows examples of materials constituting non chemically amplified resists according to the present invention, having PMMA (polymethylmethacrylate) partially substituted with chlorine for example.

Table 4

| | ID | chemical formula | structural formula |
|---|---|---|---|
| comparative example | PMMA | $C_5H_8O_2$ | polymethylmethacrylate 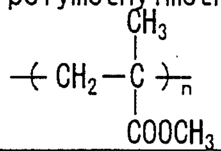 |
| sample | PMMA+$Cl_8$ | $C_5Cl_8O_2$ | 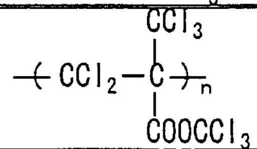 |
| | PMMA+$Cl_7$ | $C_5H_1Cl_7O_2$ | 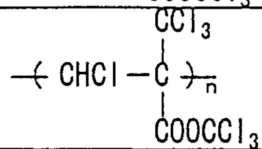 |
| | PMMA+$Cl_6$ | $C_5H_2Cl_6O_2$ | 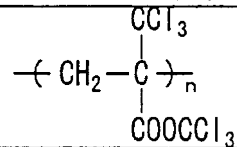 |
| | PMMA+$Cl_5$ | $C_5H_3Cl_5O_2$ | 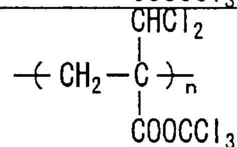 |
| | PMMA+$Cl_4$ | $C_5H_4Cl_4O_2$ | 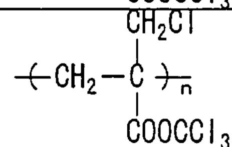 |
| | PMMA+$Cl_3$ | $C_5H_5Cl_3O_2$ | 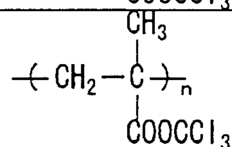 |
| | PMMA+$Cl_2$ | $C_5H_6Cl_2O_2$ | 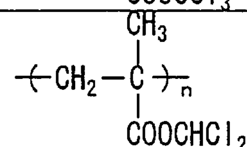 |
| | PMMA+$Cl_1$ | $C_5H_7ClO_2$ | 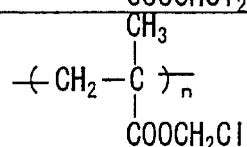 |
| | PMMA+Br | $C_5Br_8O_2$ | 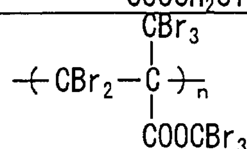 |
| | PMMA+F | $C_5F_8O_2$ | 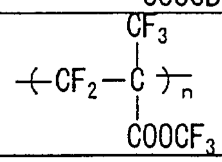 |

Example 3

Table 5 shows examples of materials constituting non chemically amplified resists according to the present invention, having hydrogen of poly(2,2,2-trifluoroethyl-2-chloroacrylate) partially substituted with chlorine for example.

Table 5

| | ID | chemical formula | structural formula |
|---|---|---|---|
| comparative example | EBR9 | $C_5H_4O_2ClF_3$ | trifluoroethylchloroacrylate 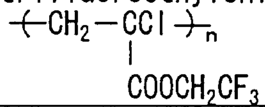 |
| sample | EBR9+Cl$_4$ | $C_5O_2Cl_5F_3$ | 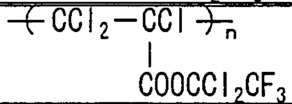 |
| | EBR9+Cl$_3$ | $C_5H_1O_2Cl_4F_3$ | 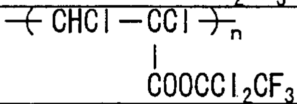 |
| | EBR9+Cl$_2$ | $C_5H_2O_2Cl_3F_3$ | 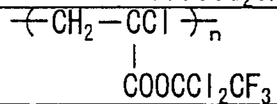 |
| | EBR9+Cl$_2$ | $C_5H_2O_2Cl_3F_3$ | 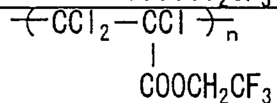 |
| | EBR9+Cl$_1$ | $C_5H_3O_2Cl_2F_3$ | 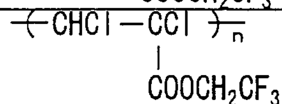 |
| | EBR9+Cl$_1$ | $C_5H_3O_2Cl_2F_3$ | 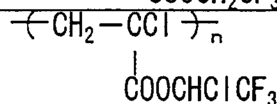 |
| | EBR9+Br | $C_5O_2ClBr_4F_3$ | 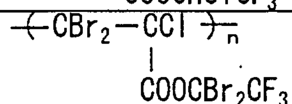 |
| | EBR9+F | $C_5O_2ClF_7$ | 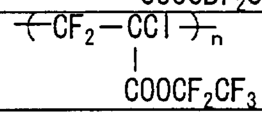 |

Example 4

Table 6 shows examples of materials constituting non chemically amplified resists according to the present invention, having Calix (6) anene partially substituted with chlorine for example.

Table 6

| | ID | chemical formula | structural formula |
|---|---|---|---|
| c. e. * | Calix(6) arene | $C_{10}H_9O_2Cl$ | 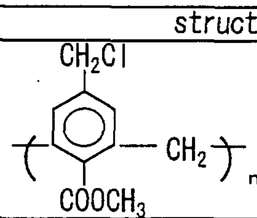 n=6 |
| sample | Calix(6) arene+$Cl_7$ | $C_{10}H_2O_2Cl_8$ | 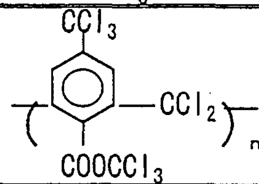 |
| | Calix(6) arene+$Cl_6$ | $C_{10}H_3O_2Cl_7$ | 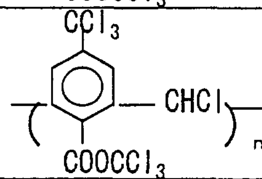 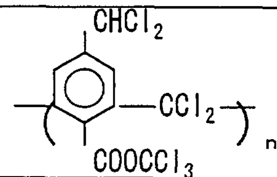 |
| | Calix(6) arene+$Cl_5$ | $C_{10}H_4O_2Cl_6$ | 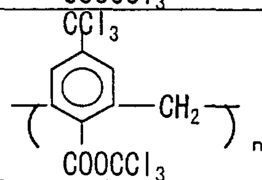 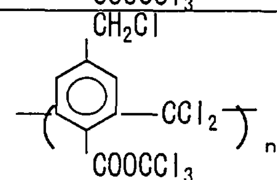 |
| | Calix(6) arene+$Cl_4$ | $C_{10}H_5O_2Cl_5$ | 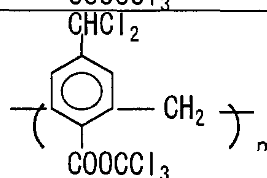 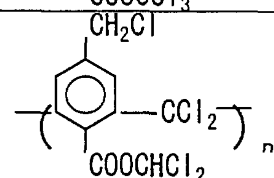 |
| | Calix(6) arene+$Cl_3$ | $C_{10}H_6O_2Cl_4$ | 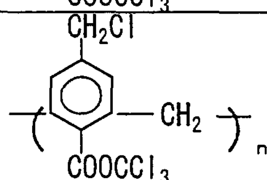 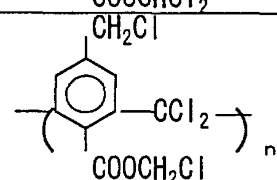 |
| | Calix(6) arene+$Cl_2$ | $C_{10}H_7O_2Cl_3$ | 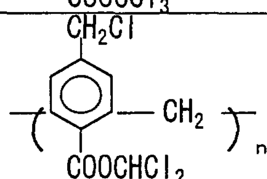 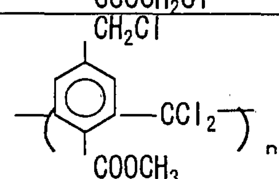 |
| | Calix(6) arene+$Cl_1$ | $C_{10}H_8O_2Cl_2$ | 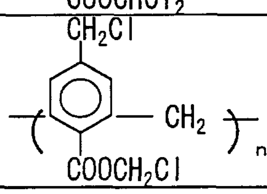 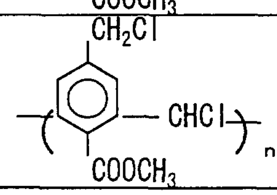 |

*c.e.: comparative example

Example 5

Table 7 shows materials for non chemically amplified positive resists according to the present invention having poly(butene-1-sulfone) (PBS) partially substituted with chlorine for example or to which chlorine for example is introduced.

Table 7

| ID | | structural formula |
|---|---|---|
| comparative example | | $-(CH_2-CH-SO_2)_n-$<br>\|<br>$CH_2CH_3$ |
| sample | 1 | $-(CH_2-CH-SO_2-SO_2)_n-$<br>\|<br>$CH_2CH_3$ |
| | 2 | $-(CH_2-CCl-SO_2)_n-$<br>\|<br>$CCl_2CCl_3$ |
| | 3 | $-(CH_2-CBr-SO_2)_n-$<br>\|<br>$CBr_2CBr_3$ |
| | 4 | $-(CH_2-CH-SO_2)_n-$<br>\|<br>$CF_2CF_3$ |

Example 6

Table 8 shows other examples of materials constituting resists according to the present invention having novolac resin partially substituted with chlorine for example.

Table 8

| ID | | structural formula |
|---|---|---|
| comparative example | | 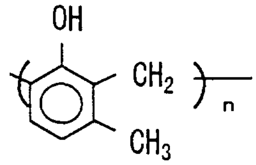 |
| sample | 1 | 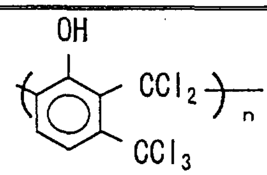 |
| | 2 | 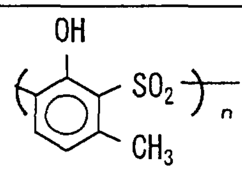 |
| | 3 | 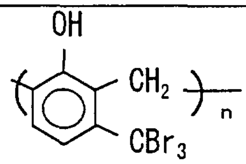 |
| | 4 | 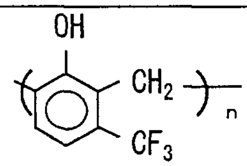 |
| | 5 | 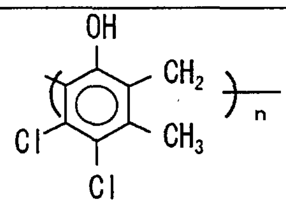 |

Example 7

Table 9 shows materials constituting non chemically amplified negative resists of resin only according to the present invention having polyglycidylmethacrylate partially substituted with chlorine for example.

Table 9

| ID | | structural formula |
|---|---|---|
| comparative example | | 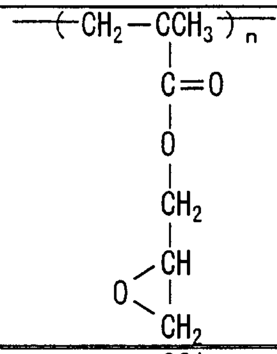 |
| sample | 1 | 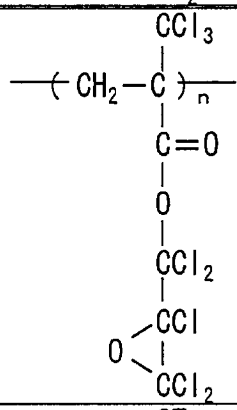 |
| | 2 | 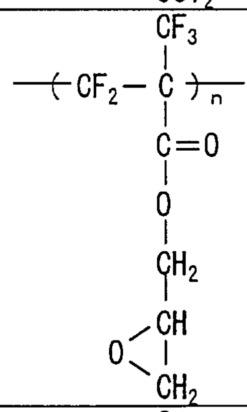 |
| | 3 | 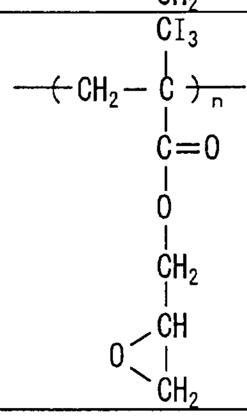 |

Example 8

Tables 10 and 11 show materials constituting resists according to the present invention having copolymer of glycidylmethacrylate and ethylacrylate partially substituted with chlorine for example.

Table 10

| ID | | structural formula |
|---|---|---|
| comparative example | | 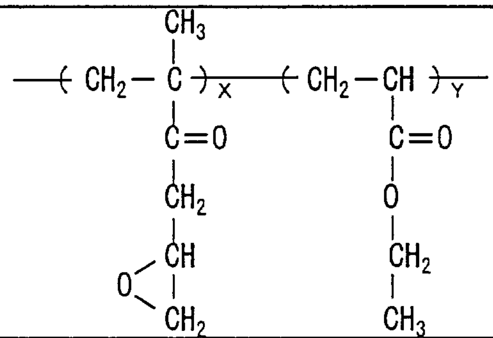 |
| sample | 1 | 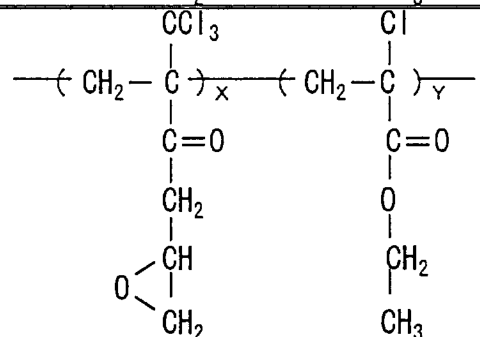 |
| | 2 | 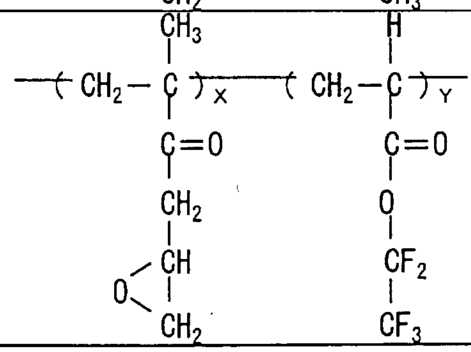 |

Table 11

| ID | | structural formula |
| --- | --- | --- |
| sample | 3 | 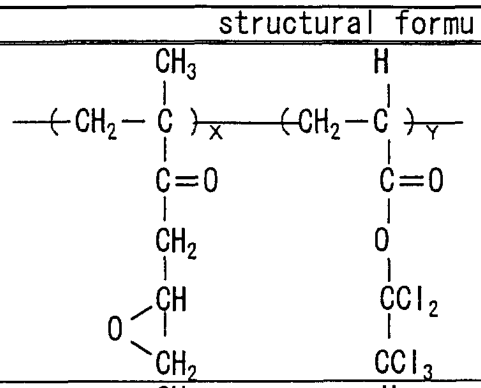 |
| | 4 | 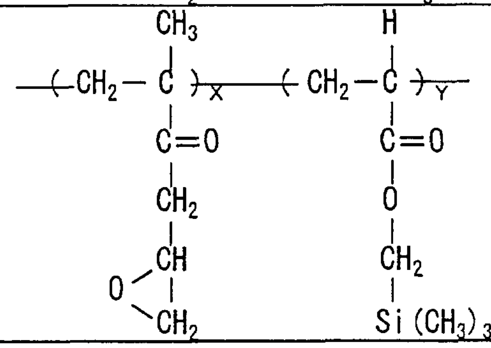 |

Example 9

Table 12 shows materials constituting the resists according to the present invention having chloromethylated polystyrene partially substituted with chlorine for example.

Table 12

| ID | | structural formula |
|---|---|---|
| comparative example | | 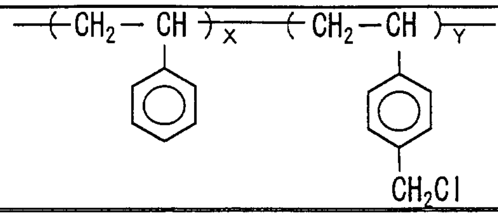 |
| sample | 1 | 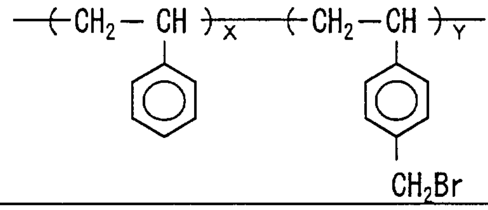 |
| sample | 2 | 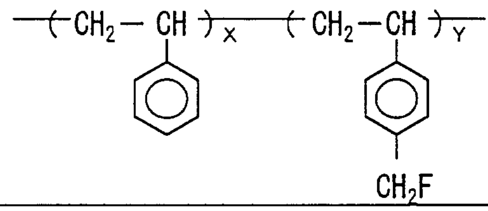 |
| sample | 3 | 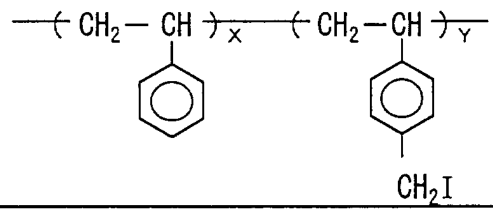 |

Example 10

Table 13 shows materials constituting the resists according to the present invention having polyvinylphenol partially substituted with chlorine for example.

Table 13

| ID | | structural formula | | |
|---|---|---|---|---|
| comparative example | | 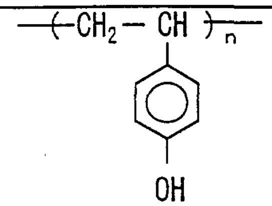 | | |
| sample | 1 | 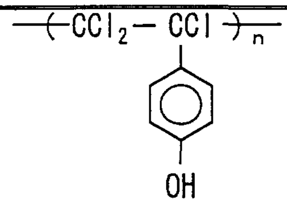 | 6 | 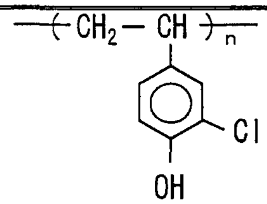 |
| | 2 | 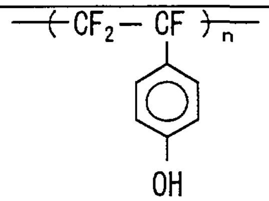 | 7 | 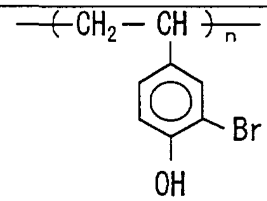 |
| | 3 | 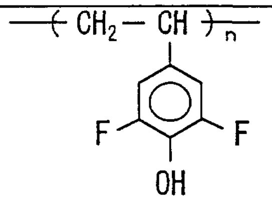 | 8 | 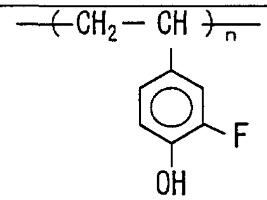 |
| | 4 | 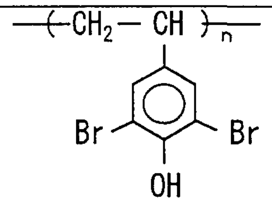 | 9 | 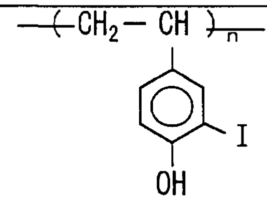 |
| | 5 | 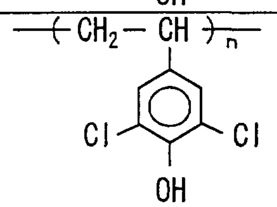 | | |

Example 11

Table 14 shows materials constituting the resists according to the present invention, being base polymer of chemically amplified resists, having poly(p-butoxycarbonyloxystyrene) with hydroxyl group of polyvinylphenol protected by t-BOC (butoxycarbonyloxy) group that is partially substituted with chlorine for example.

Table 14

| ID | | structural formula | | |
|---|---|---|---|---|
| comparative example | | 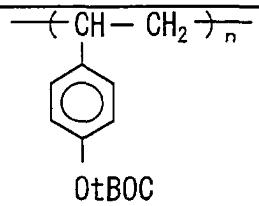 | | |
| sample | 1 | 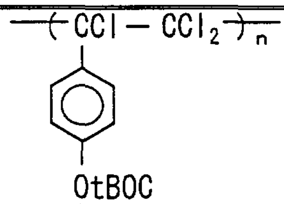 | 5 | 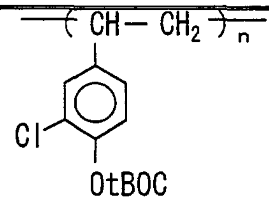 |
| | 2 | 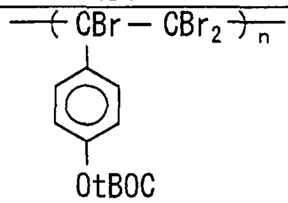 | 6 | 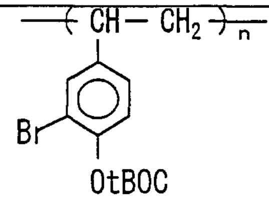 |
| | 3 | 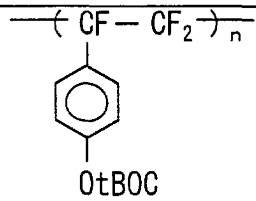 | 7 | 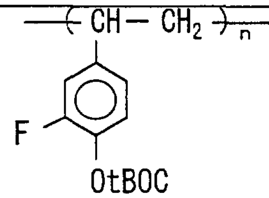 |
| | 4 | 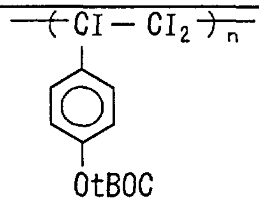 | 8 | 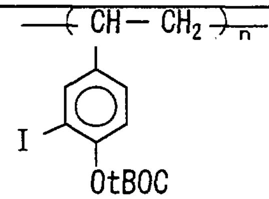 |

Example 12

Tables 15 and 16 show materials constituting the resists according to the present invention having copolymer of vinylphenol having hydroxyl group protected by t-BOC group and vinylphenol having hydroxyl group not protected by t-BOC group that is partially substituted with chlorine for example.

Table 15

| ID | | structural formula |
|---|---|---|
| comparative example | | 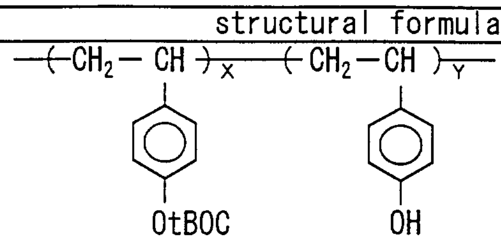 |
| sample | 1 | 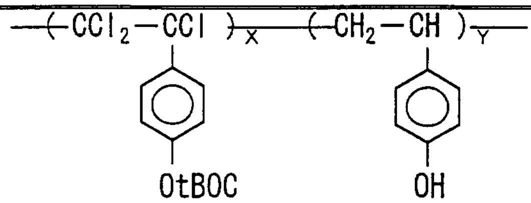 |
| | 2 | 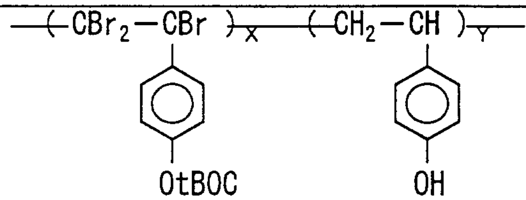 |
| | 3 | 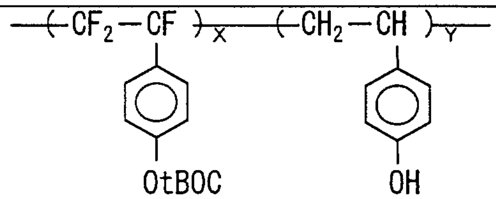 |
| | 4 | 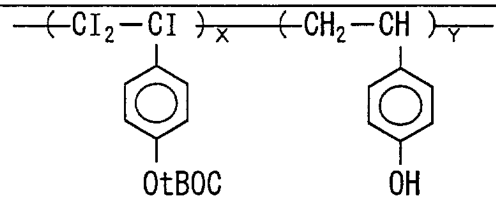 |

Table 16

| ID | | structural formula |
|---|---|---|
| sample | 5 | 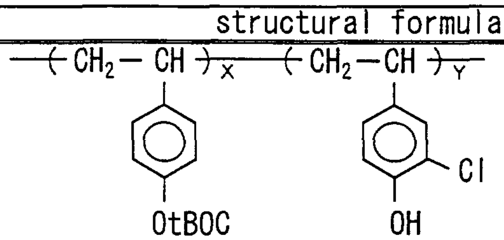 |
| | 6 | 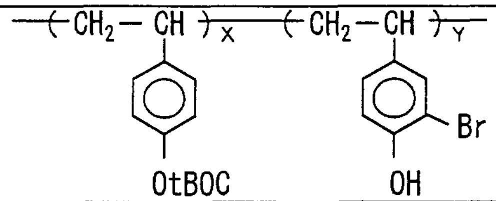 |
| | 7 | 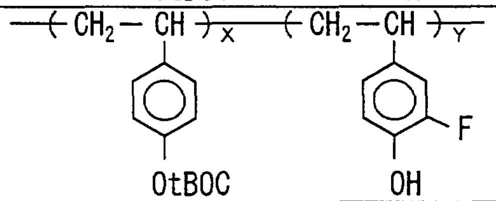 |
| | 8 | 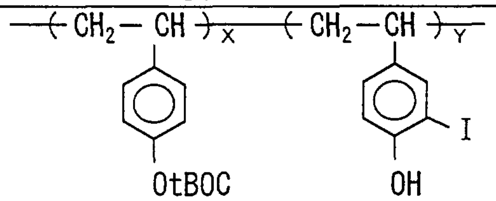 |

Example 13

Table 17 shows materials constituting the resists according to the present invention having styrene-maleimide copolymer partially substituted with chlorine for example.

Table 17

| ID | | structural formula |
|---|---|---|
| comparative example | | 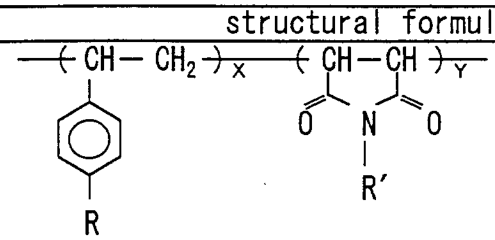 |
| | 1 | 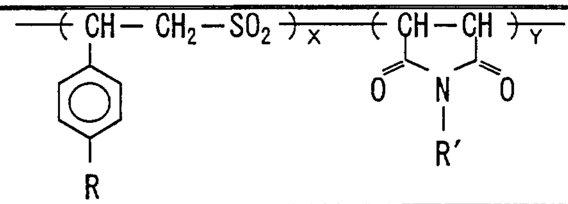 |
| | 2 | 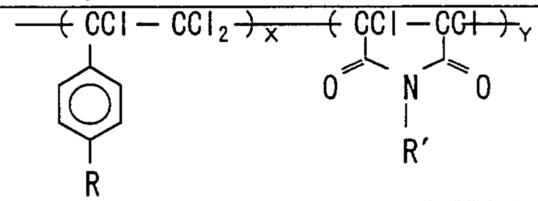 |
| | 3 | 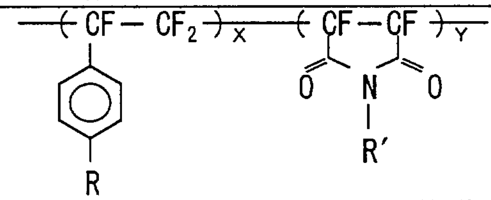 |

Example 14

Tables 18 and 19 show materials constituting the resists according to the present invention, copolymer of vinylphenol protected by t-BOC group and sulfone, poly(4-(t-butoxycarbonyloxy)styrene-sulfone) partially substituted with chlorine for example.

Table 18

| ID | | structural formula |
|---|---|---|
| comparative example | | 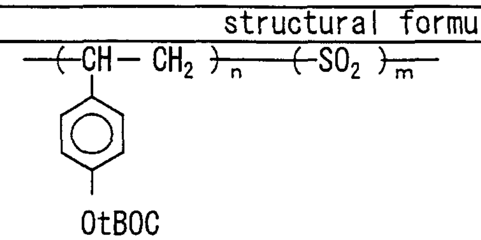 |
| sample | 1 | 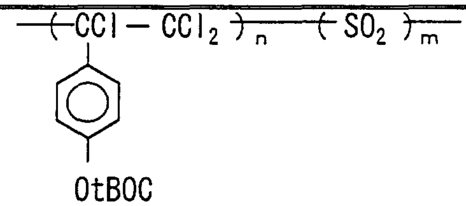 |
| | 2 | 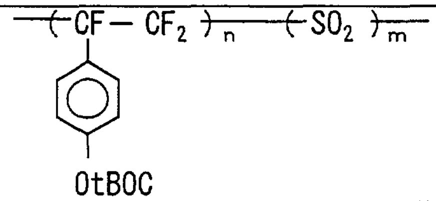 |
| | 3 | 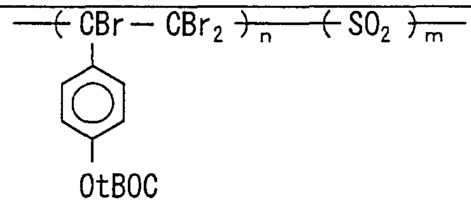 |
| | 4 | 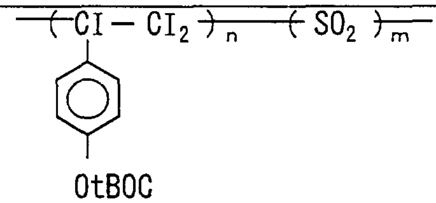 |
| | 5 | 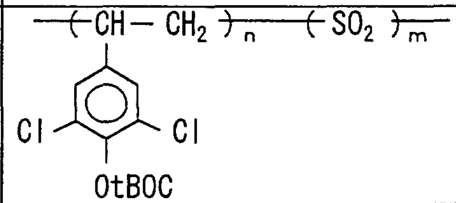 |
| | 6 | 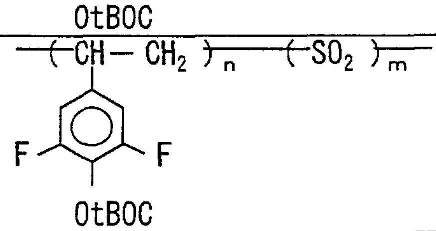 |

Table 19

| ID | | structural formula |
|---|---|---|
| sample | 7 | 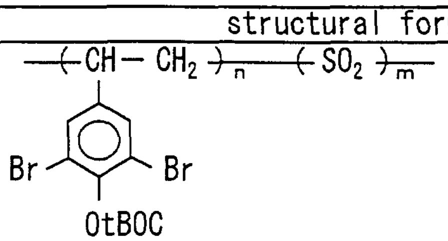 |
| | 8 | 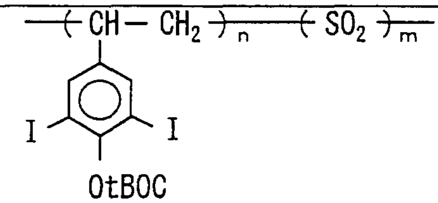 |
| | 9 | 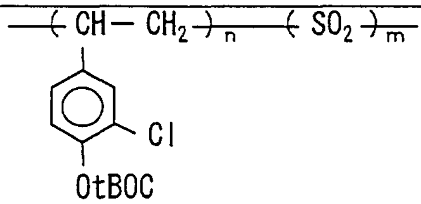 |
| | 10 | 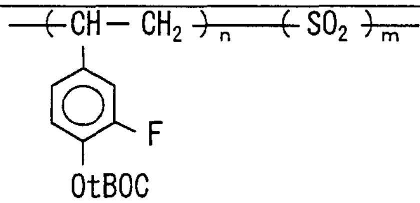 |
| | 11 | 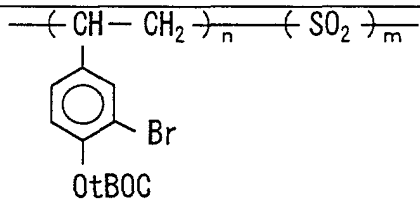 |
| | 12 | 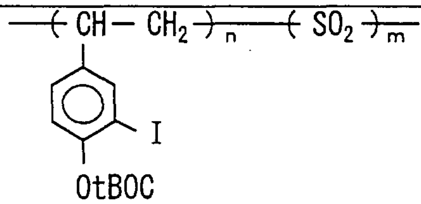 |

Example 15

Table 20 shows materials constituting the resists according to the present invention having copolymer of vinylphenol and methylvinylphenol partially substituted with chlorine for example.

Table 20

| ID | | structural formula |
|---|---|---|
| comparative example | | 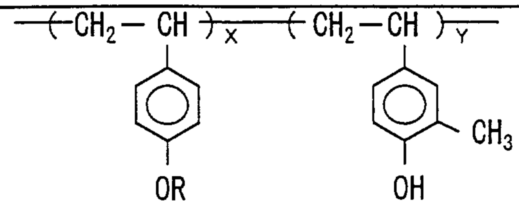 |
| sample | 1 | 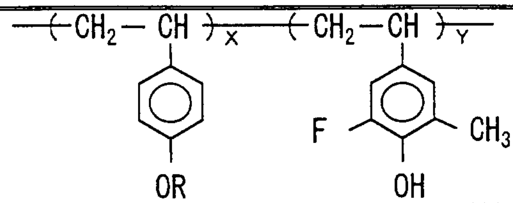 |
| | 2 | 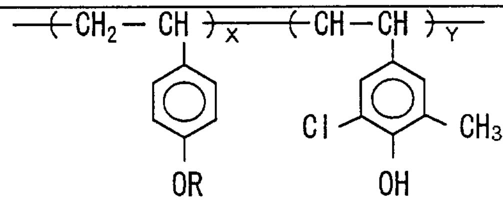 |
| | 3 | 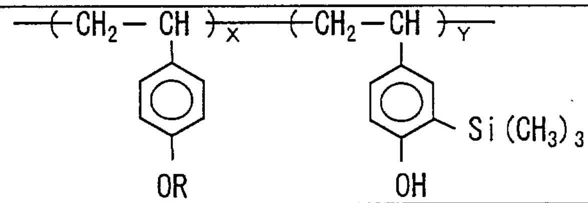 |
| | 4 | 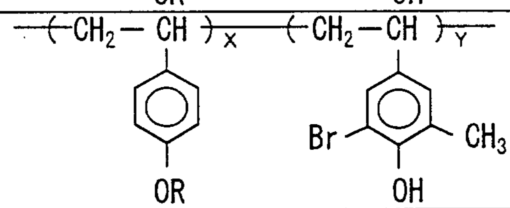 |
| | 5 | 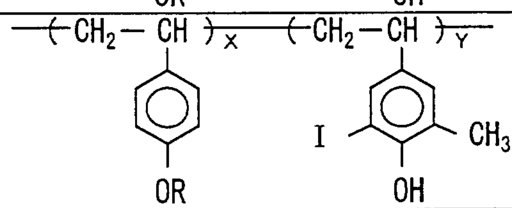 |

Example 16

Table 21 shows materials constituting the resists according to the present invention having polyphthalaldehyde (PPA) partially substituted with chlorine for example.

Table 21

| ID | | structural formula |
|---|---|---|
| comparative example | | 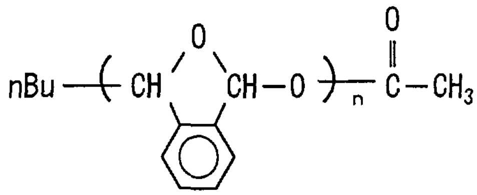 |
| sample | 1 | 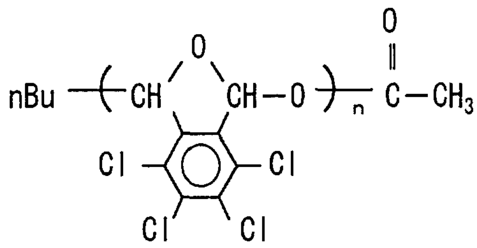 |
| | 2 | 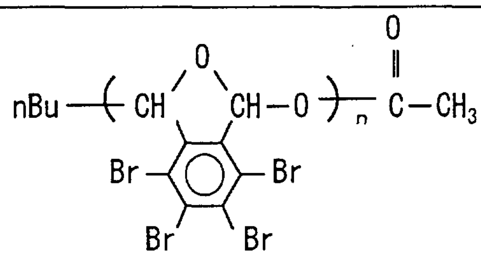 |
| | 3 | 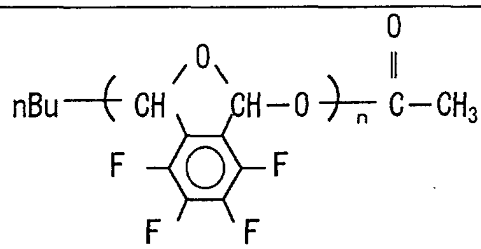 |
| | 4 | 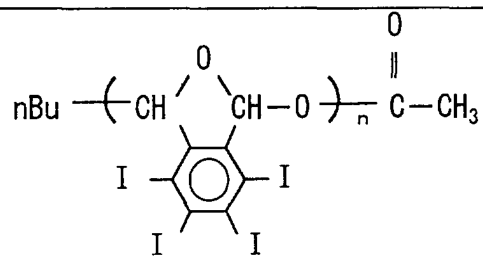 |

Example 17

Table 22 shows materials constituting the resists according to the present invention having acrylic-based polymer partially substituted with chlorine for example.

Table 22

| ID | | structural formula |
|---|---|---|
| comparative example | | 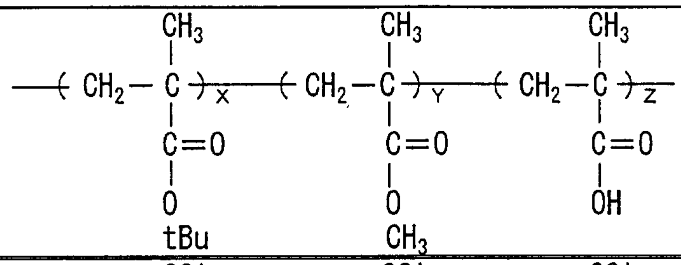 |
| sample | 1 | 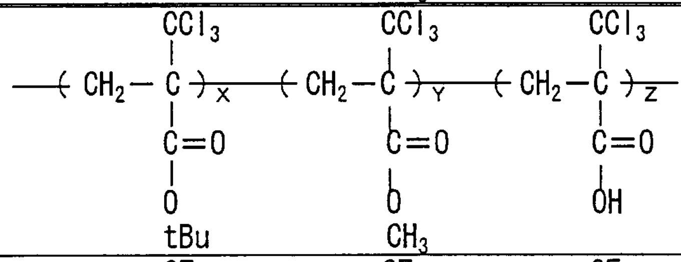 |
| | 2 | 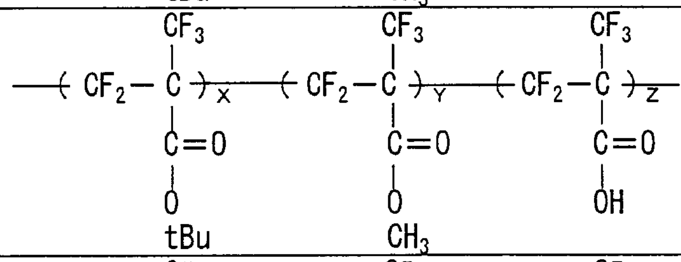 |
| | 3 | 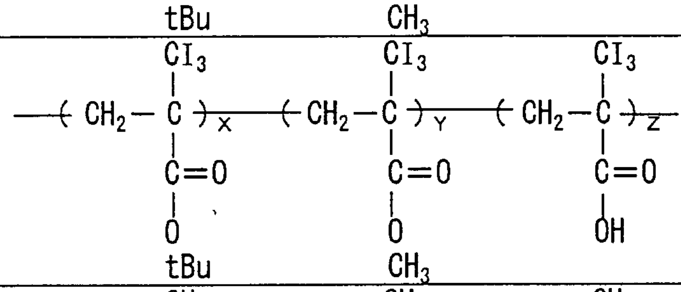 |
| | 4 | 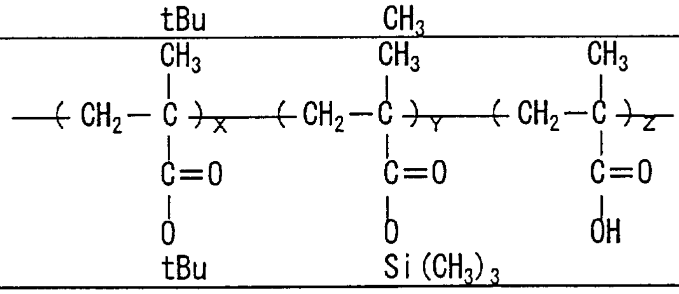 |

Example 18

Table 23 shows materials constituting the resists according to the present invention having poly(3-methyl-2-(4-vinylphenol)-2,3-butanediol) partially substituted with chlorine for example.

Table 23

| ID | | structural formula |
|---|---|---|
| comparative example | | 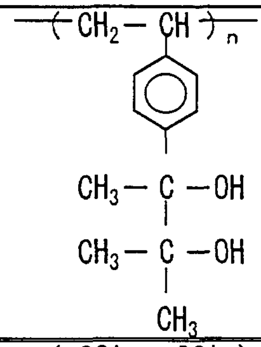 |
| sample | 1 | 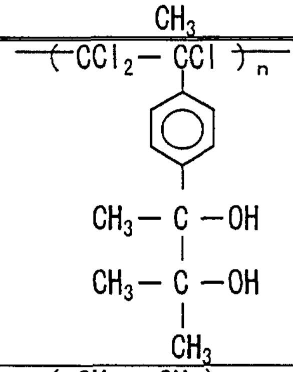 |
| | 2 | 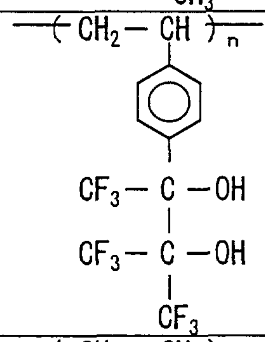 |
| | 3 | 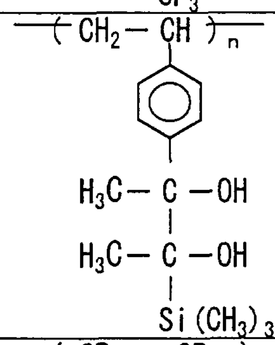 |
| | 4 | 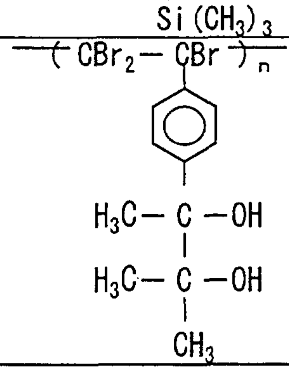 |

Example 19

Table 24 shows materials constituting the resists according to the present invention having diphenyliodonium triflate which is an acid generating agent and partially substituted with chlorine for example.

Table 24

| ID | | structural formula |
|---|---|---|
| comparative example | | 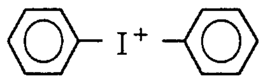 $^-OSO_2CF_3$ |
| sample | 1 | 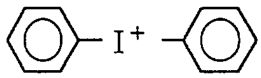 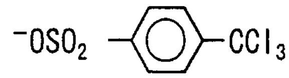 |
| | 2 | 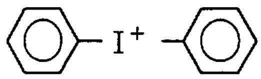 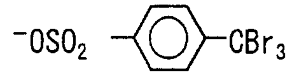 |
| | 3 | 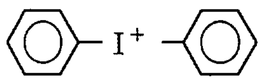 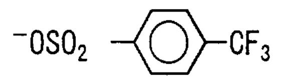 |
| | 4 | 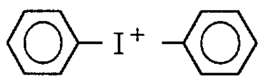 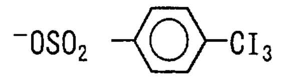 |
| | 5 | 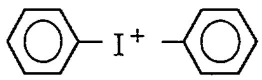 $PCl_6^-$ |
| | 6 | 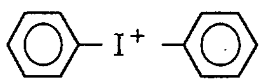 $PBr_6^-$ |
| | 7 | 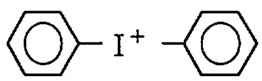 $PI_6^-$ |

Example 20

Tables 25 and 26 show materials constituting the resists according to the present invention having triphenylsulfoniumtriflate partially substituted with chlorine for example.

Table 25

| ID | | structural formula |
|---|---|---|
| comparative example | | 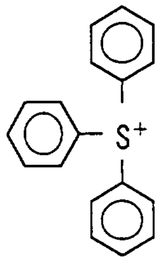 $CF_3SO_3^-$ |
| sample | 1 | 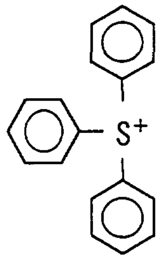 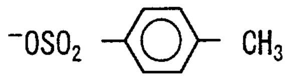 |
| | 2 | 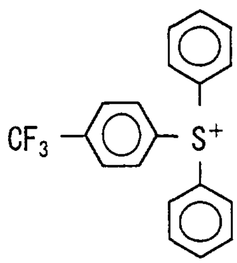 $CF_3SO_3^-$ |
| | 3 | 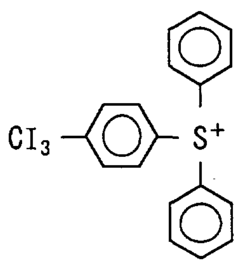 $CF_3SO_3^-$ |

Table 26

| ID | | structural formula |
|---|---|---|
| sample | 4 | 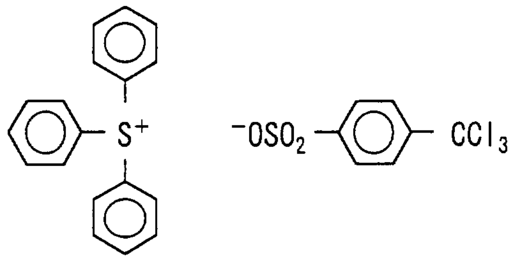 |
| | 5 | 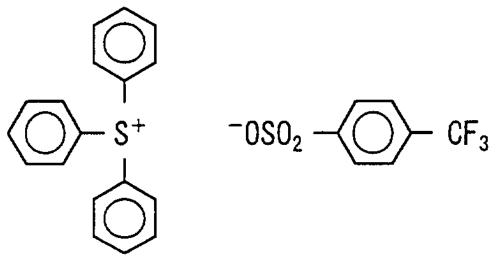 |
| | 6 | 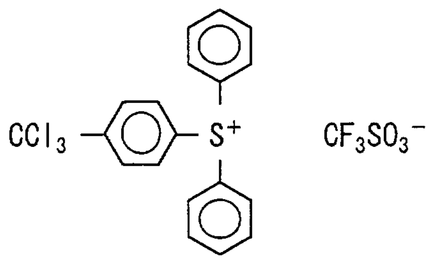 |
| | 7 | 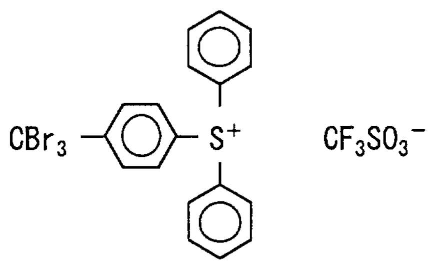 |

Example 21

Tables 27 and 28 show materials constituting the resists according to the present invention having triphenylsulfonium hexafluoroantimonate partially substituted with chlorine for example.

Table 27

| ID | | structural formula |
|---|---|---|
| comparative example | | 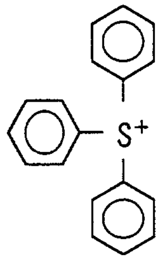 $SbF_6^-$ |
| sample | 1 | 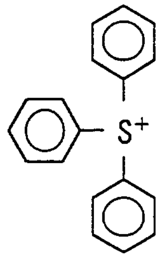 $SbCl_6^-$ |
| | 2 | 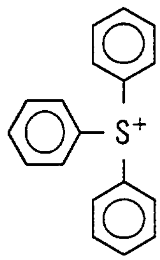 $SbBr_6^-$ |
| | 3 | 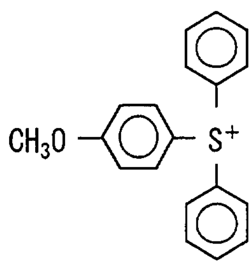 $SbBr_6^-$ |

Table 28

| ID | | structural formula |
|---|---|---|
| sample | 4 | 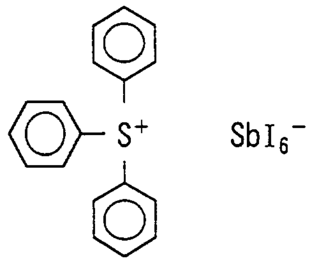 |
| | 5 | 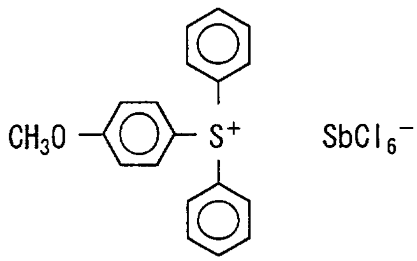 |
| | 6 | 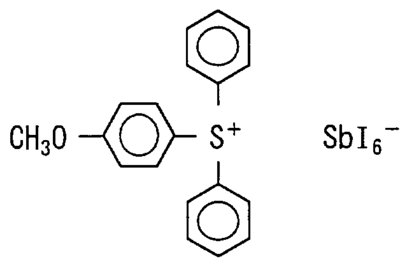 |

Example 22

Tables 29 and 30 show materials constituting the resists according to the present invention having triphenylsulfonium tetrafluoroborate partially substituted with chlorine for example.

Table 29

| ID | | structural formula |
|---|---|---|
| comparative example | | 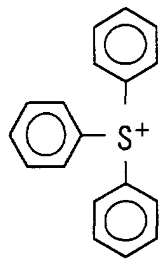 $BF_4^-$ |
| sample | 1 | 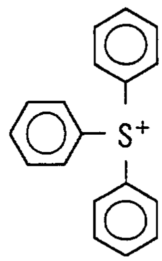 $BCl_4^-$ |
| | 2 | 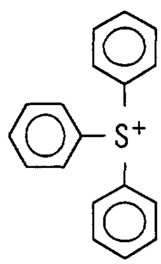 $BBr_4^-$ |
| | 3 | 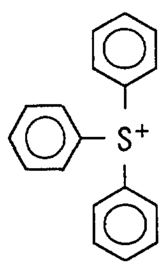 $BI_4^-$ |

Table 30

| ID | | structural formula |
|---|---|---|
| sample | 4 | 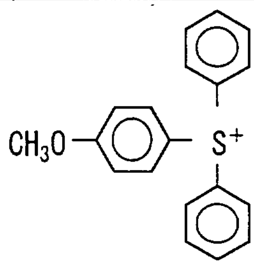 $BCl_4^-$ |
| | 5 | 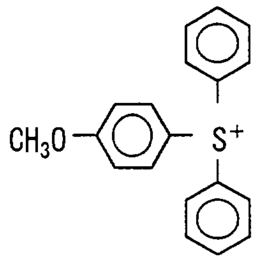 $BBr_4^-$ |
| | 6 | 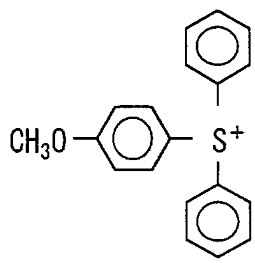 $BI_4^-$ |

Example 23

Table 31 shows materials constituting the resists according to the present invention having nitrobenzyl tosylate partially substituted with chlorine for example.

Table 31

| ID | | structural formula |
|---|---|---|
| comparative example | | 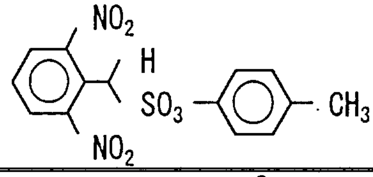 |
| sample | 1 | 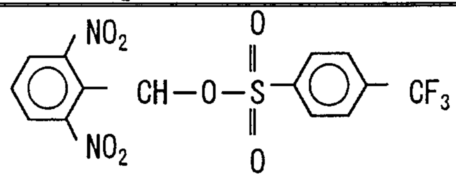 |
| | 2 | 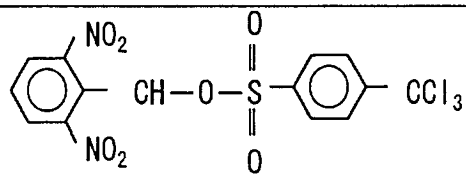 |
| | 3 | 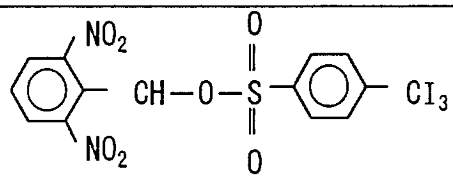 |
| | 4 | 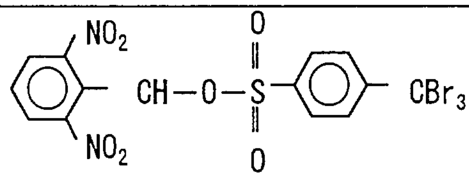 |

Example 24

Table 32 shows materials constituting the resists according to the present invention having n-iminosulfonate partially substituted with chlorine for example.

Table 32

| ID | | structural formula |
|---|---|---|
| comparative example | | 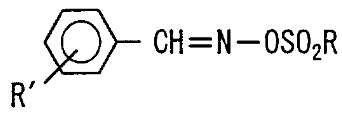 |
| sample | 1 | 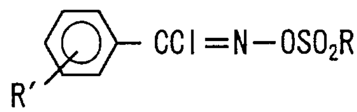 |
| | 2 | 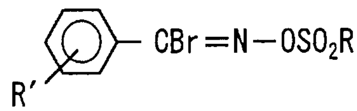 |
| | 3 | 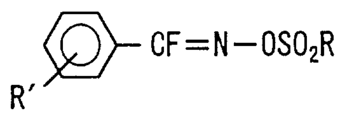 |
| | 4 | 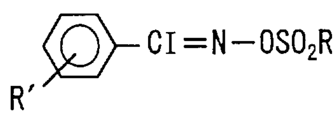 |

Example 25

Table 33 shows materials constituting the resists according to the present invention having 1,2-diazonaphthoquinone-4-sulfonate partially substituted with chlorine for example.

Table 33

| ID | | structural formula |
|---|---|---|
| comparative example | | 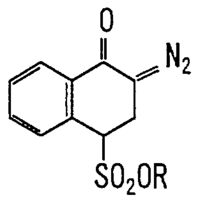 |
| sample | 1 | 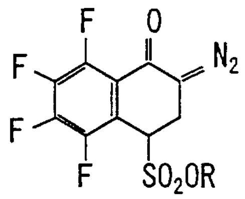 |
| | 2 | 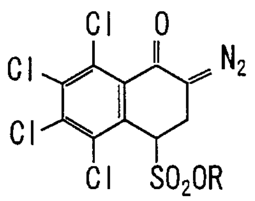 |
| | 3 | 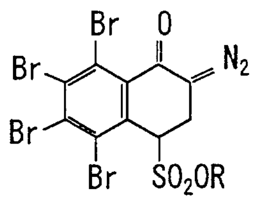 |
| | 4 | 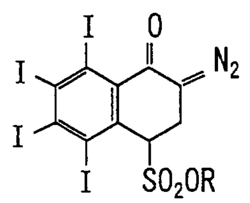 |

Example 26

Tables 34 and 35 show materials constituting the resists according to the present invention having α-sulfonyloxyketone partially substituted with chlorine for example.

Table 34

| ID | | structural formula |
|---|---|---|
| comparative example | | 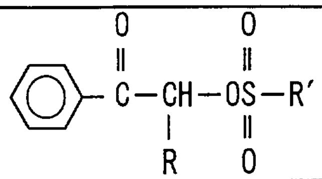 |
| sample | 1 | 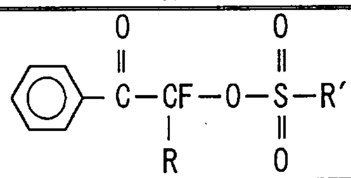 |
| | 2 | 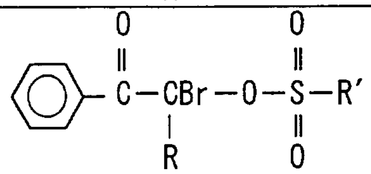 |
| | 3 | 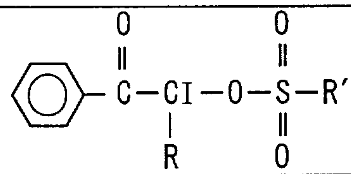 |
| | 4 | 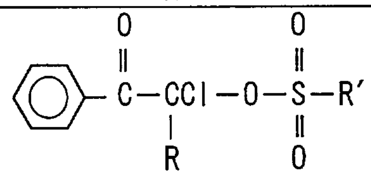 |

Table 35

| ID | | structural formula |
|---|---|---|
| sample | 5 | 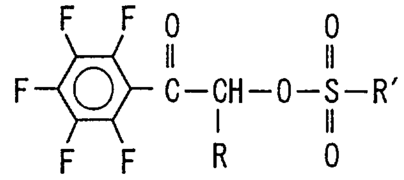 |
| | 6 | 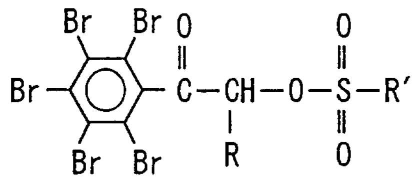 |
| | 7 | 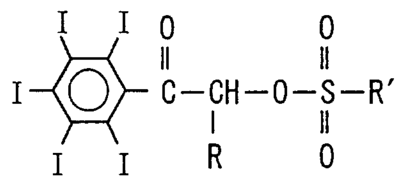 |
| | 8 | 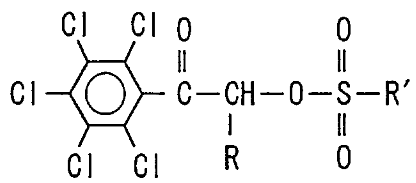 |

Example 27

Table 36 shows materials constituting the resists according to the present invention having α-hydroxymethyl benzoin sulfonate partially substituted with chlorine for example.

Table 36

| ID | | structural formula |
|---|---|---|
| comparative example | | 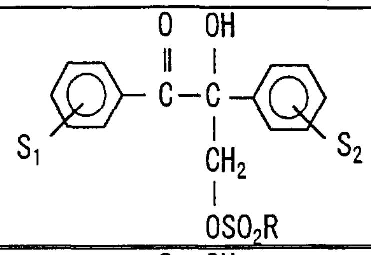 |
| sample | 1 | 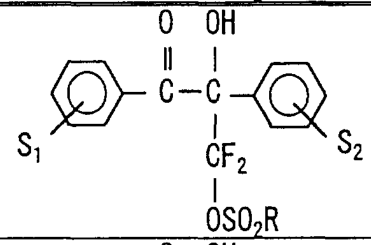 |
| | 2 | 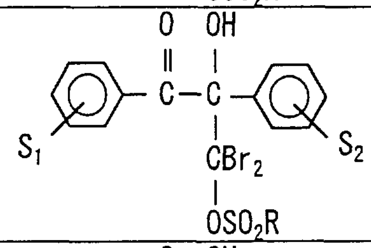 |
| | 3 | 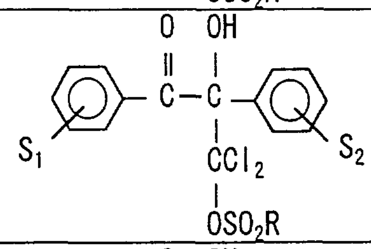 |
| | 4 | 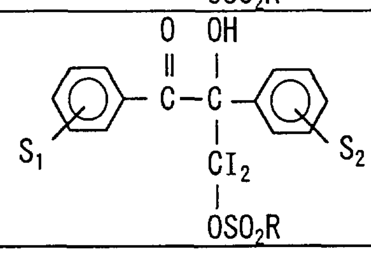 |

Example 28

Table 37 shows materials constituting the resists according to the present invention having tris(trihalogenated methyl)-s-triazine derivative partially substituted with chlorine for example.

Table 37

| ID | | structural formula |
|---|---|---|
| comparative example | | 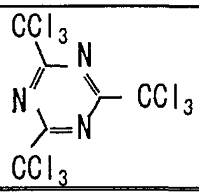 |
| sample | 1 | 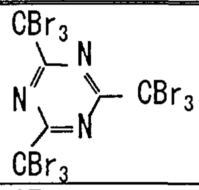 |
| | 2 | 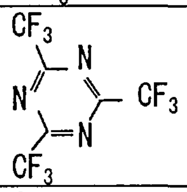 |
| | 3 | 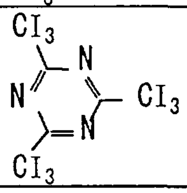 |

Example 29

Table 38 shows materials constituting the resists according to the present invention having trihalogenated phenol derivative partially substituted with chlorine for example.

Table 38

| ID | | structural formula |
|---|---|---|
| comparative example | | 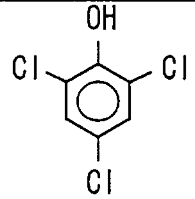 |
| sample | 1 | 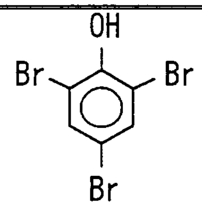 |
| | 2 | 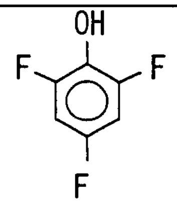 |
| | 3 | 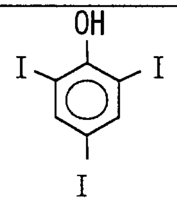 |
| | 4 | 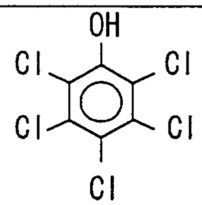 |

Example 30

Table 39 shows materials constituting the resists according to the present invention having trichloroacetophenone partially substituted with chlorine for example.

Table 39

| ID | | structural formula |
|---|---|---|
| comparative example | | 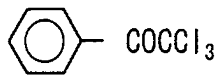 |
| sample | 1 | 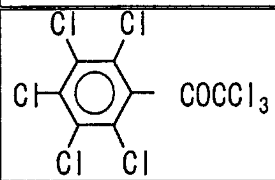 |
| | 2 | 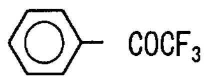 |
| | 3 | 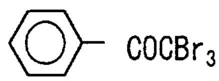 |
| | 4 | 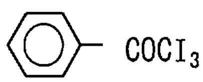 |

Example 31

Table 40 shows materials constituting the resists according to the present invention having disulfone partially substituted with chlorine for example.

Table 40

| ID | | structural formula |
|---|---|---|
| comparative example | | 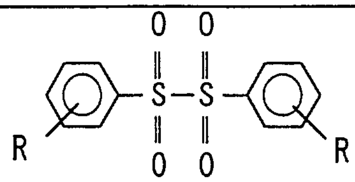 |
| sample | 1 | 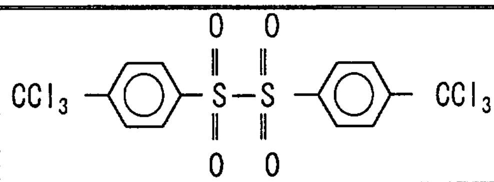 |
| | 2 | 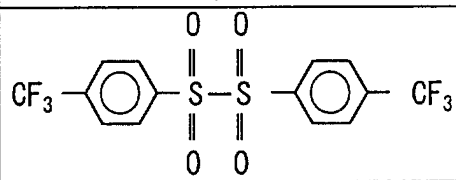 |
| | 3 | 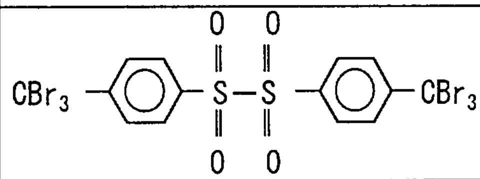 |
| | 4 | 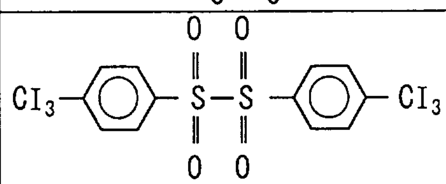 |

Example 32

Tables 41 and 42 show materials constituting the resists according to the present invention having bis(allylsulfonyl)diazomethane partially substituted with chlorine for example.

Table 41

| ID | | structural formula |
|---|---|---|
| comparative example | | 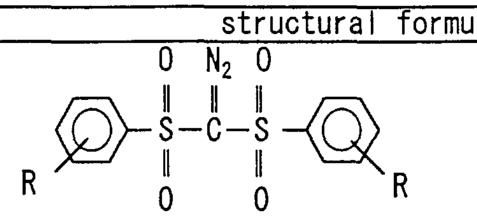 |
| sample | 1 | 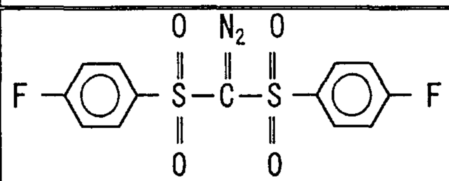 |
| | 2 | 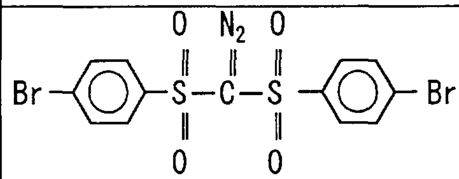 |
| | 3 | 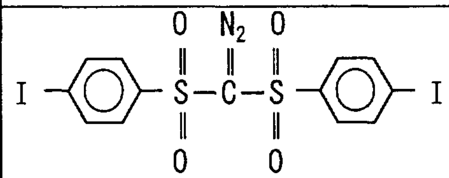 |

Table 42

| ID | | structural formula |
|---|---|---|
| sample | 4 | 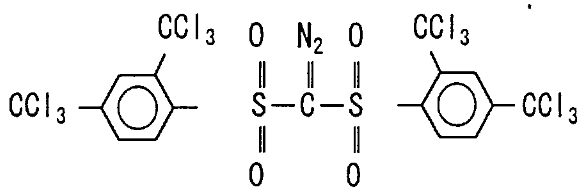 |
| | 5 | 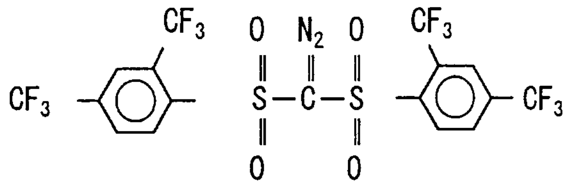 |
| | 6 | 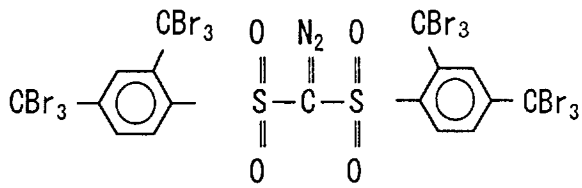 |
| | 7 | 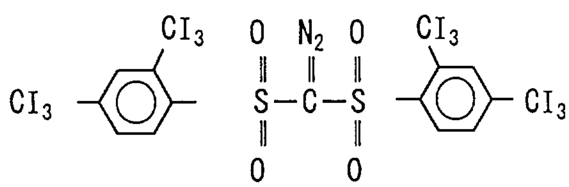 |

Example 33

Table 43 shows materials constituting the resists according to the present invention having allylcarbonyl allylsulfonyl diazomethane partially substituted with chlorine for example.

Table 43

| ID | | structural formula |
|---|---|---|
| comparative example | | 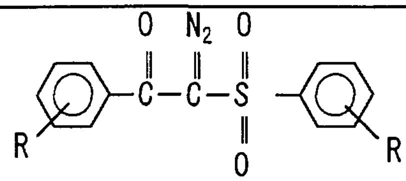 |
| sample | 1 | 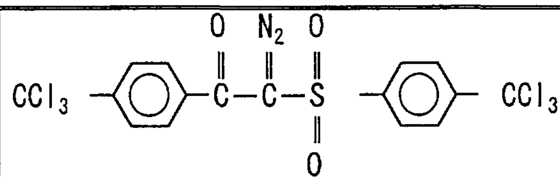 |
| | 2 | 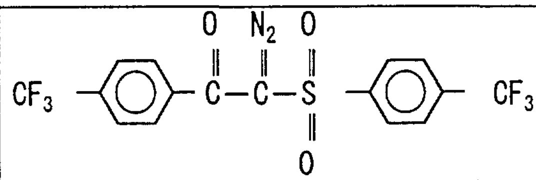 |
| | 3 | 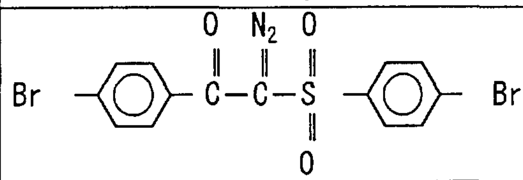 |
| | 4 | 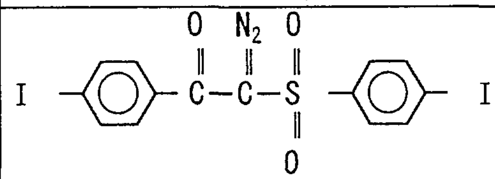 |

Example 34

Table 44 shows materials constituting the resists according to the present invention having Me-SB partially substituted with chlorine for example.

Table 44

| ID | | structural formula |
|---|---|---|
| comparative example | | 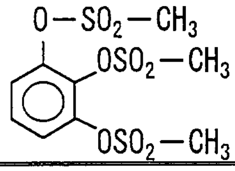 |
| sample | 1 | 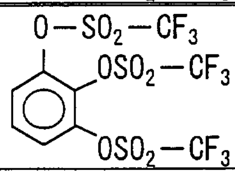 |
| | 2 | 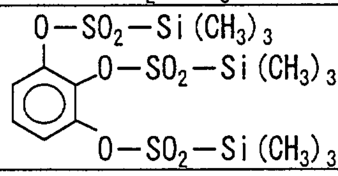 |
| | 3 | 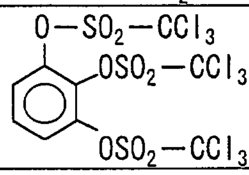 |
| | 4 | 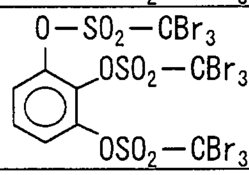 |
| | 5 | 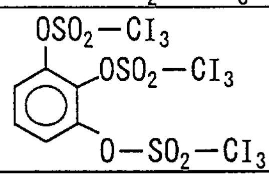 |

Example 35

Table 45 shows materials constituting the resists according to the present invention having t-BOC group serving as protecting group for the chemically amplified positive resist that is partially substituted with chlorine for example.

Table 45

| ID | | structural formula |
|---|---|---|
| comparative example | | 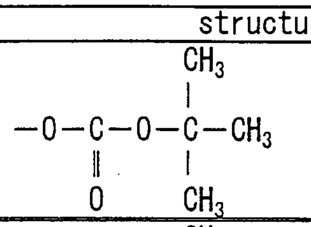 |
| sample | 1 | 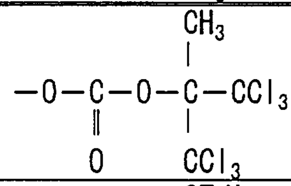 |
| | 2 | 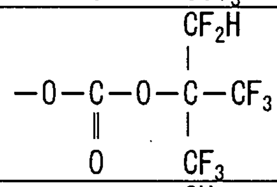 |
| | 3 | 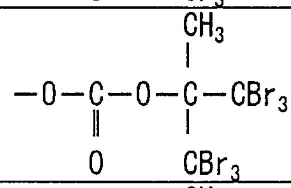 |
| | 4 | 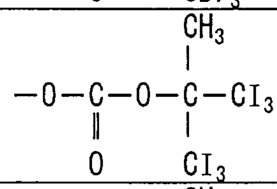 |
| | 5 | 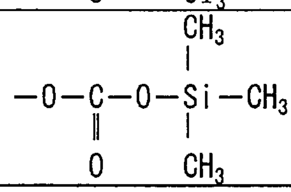 |

Example 36

Table 46 shows isopropoxycarbonyl group (i-PrOC) serving as a protecting group of materials constituting the resists according to the present invention that is partially substituted with chlorine for example.

Table 46

| ID | | structural formula |
|---|---|---|
| comparative example | | 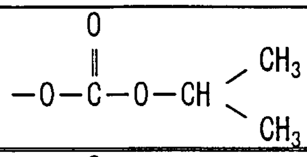 |
| sample | 1 | 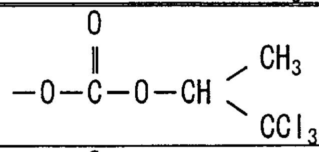 |
| | 2 | 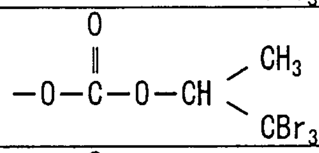 |
| | 3 | 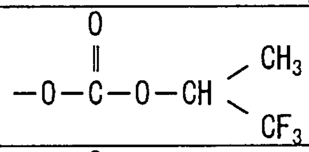 |
| | 4 | 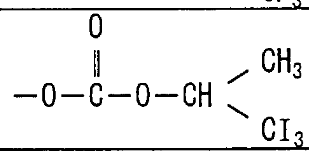 |

Example 37

Table 47 shows tetrahydropyranyl group serving as a protecting group of materials constituting the resists according to the present invention that is partially substituted with chlorine for example.

Table 47

| ID | | structural formula |
|---|---|---|
| comparative example | | 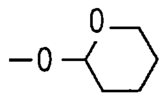 |
| sample | 1 | 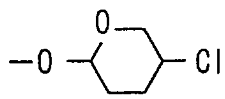 |
| | 2 | 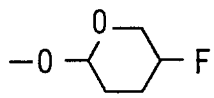 |
| | 3 | 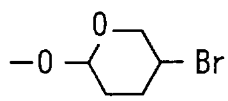 |
| | 4 | 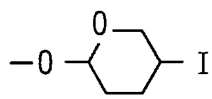 |

Example 38

Table 48 shows t-butoxycarbonylmethyl group (tBOC-CH2) serving as a protecting group of materials constituting the resists according to the present invention that is partially substituted with chlorine for example.

Table 48

| ID | | structural formula |
|---|---|---|
| comparative example | | 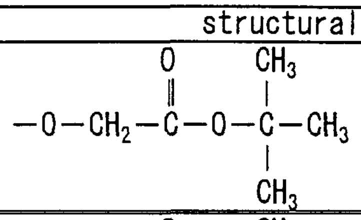 |
| sample | 1 | 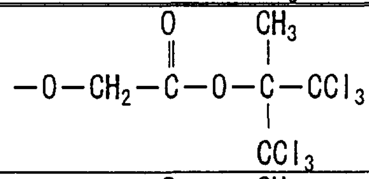 |
| | 2 | 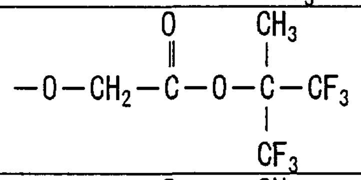 |
| | 3 | 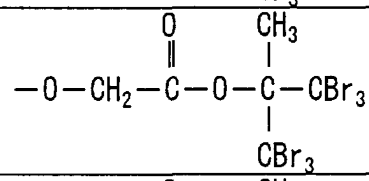 |
| | 4 | 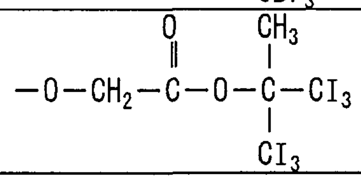 |

Example 39

Table 49 shows materials constituting the resists according to the present invention having a protecting group of trimethylsilylether group partially substituted with chlorine for example.

Table 49

| ID | | structural formula |
|---|---|---|
| comparative example | | 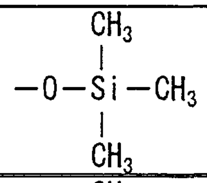 |
| sample | 1 | 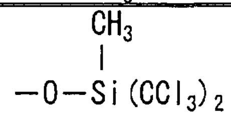 |
| | 2 | 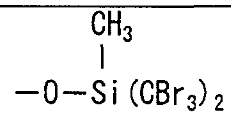 |
| | 3 | 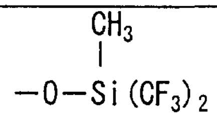 |
| | 4 | 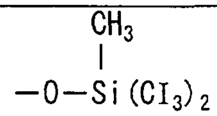 |

Example 40

Table 50 shows materials constituting the resists according to the present invention having polycarbonate partially substituted with chlorine for example.

Table 50

| ID | | structural formula |
| --- | --- | --- |
| comparative example | | 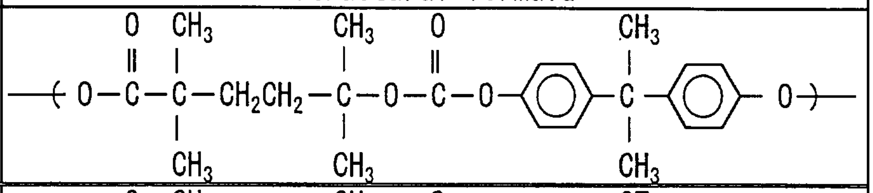 |
| sample | 1 | 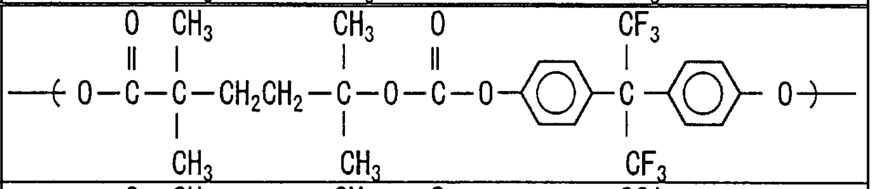 |
| | 2 | 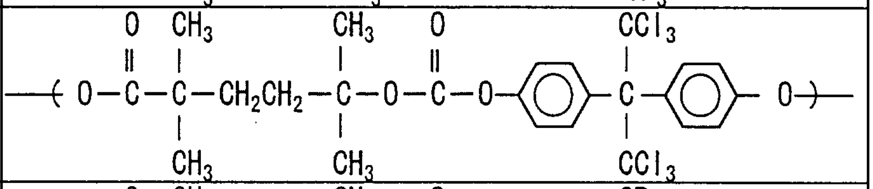 |
| | 3 | 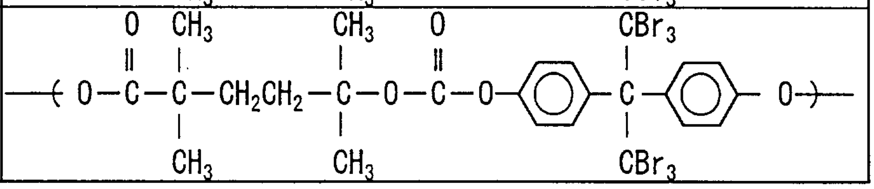 |

Example 41

Table 51 shows materials constituting the resists according to the present invention having biphenyl t-buthylether partially substituted with chlorine for example.

Table 51

| ID | | structural formula |
|---|---|---|
| comparative example | | 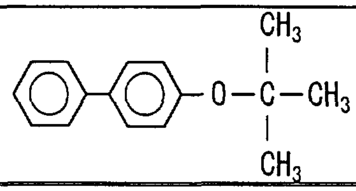 |
| sample | 1 | 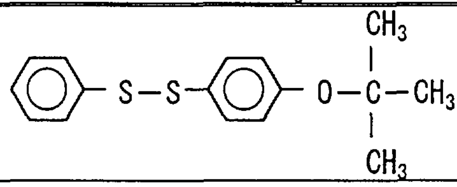 |
| | 2 | 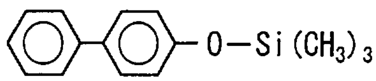 |
| | 3 | 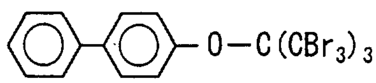 |
| | 4 | 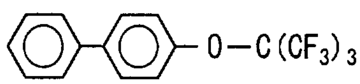 |
| | 5 | 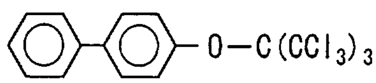 |

Example 42

Tables 52 and 53 show materials constituting the resists according to the present invention having THP-M partially substituted with chlorine for example.

Table 52

| ID | | structural formula |
|---|---|---|
| comparative example | | 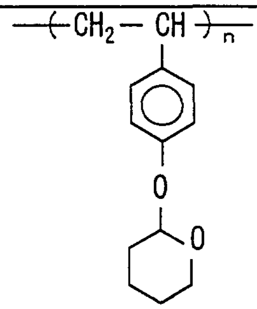 |
| sample | 1 | 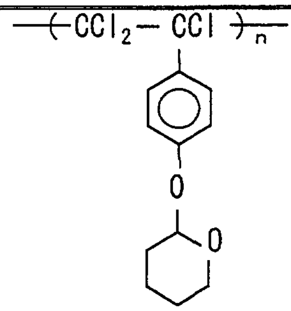 |
| | 2 | 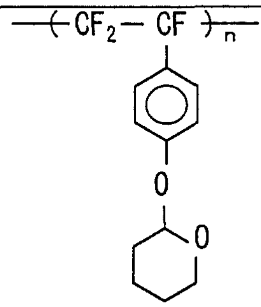 |
| | 3 | 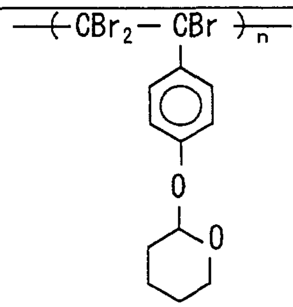 |

Table 53

| ID | | structural formula |
|---|---|---|
| sample | 4 | 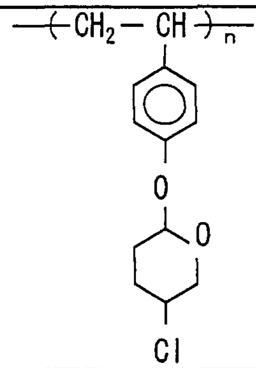 |
| | 5 | 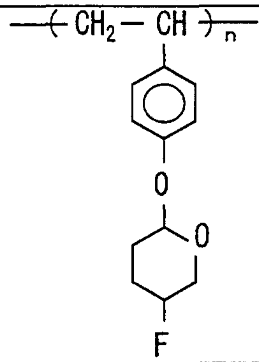 |
| | 6 | 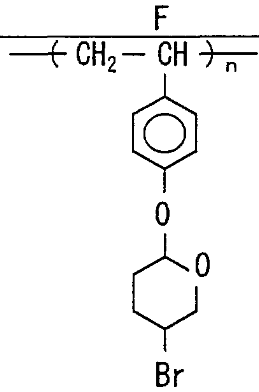 |
| | 7 | 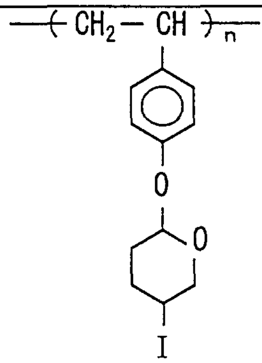 |

Example 43

Table 54 shows materials constituting the resists according to the present invention having 2-methylpentene 1-sulfone partially substituted with chlorine for example.

Table 54

| ID | | structural formula |
|---|---|---|
| comparative example | | 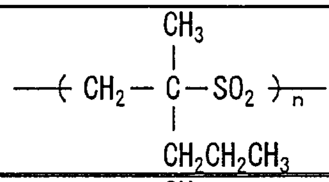 |
| sample | 1 | 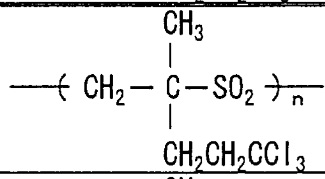 |
| | 2 | 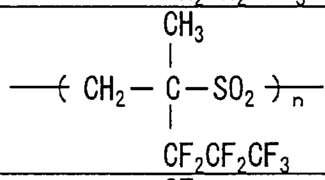 |
| | 3 | 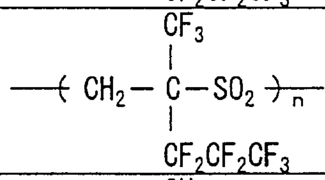 |
| | 4 | 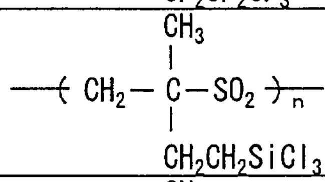 |
| | 5 | 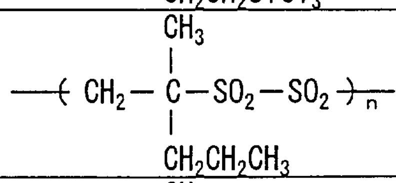 |
| | 6 | 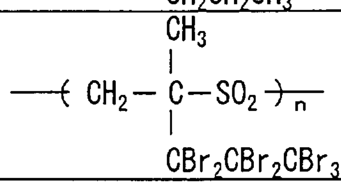 |

Although the present invention has been described and illustrated in detail, it is clearly understood that the same is by way of illustration and example only and is not to be taken by way of limitation.

## Claims

1. An exposure method of radiating X rays (2, 16) emitted from an X-ray source (1, 17) to a resist film (10) via an X-ray mask (8), a material constituting said resist film (10) being selected to absorb, by said resist film (10), X rays (2, 16) having an average wavelength equal to or shorter than an average wavelength of X rays (2, 16) radiated to said resist film (10)

2. An exposure method of radiating X rays (2, 16) emitted from an X-ray source (1, 17) to a resist film (10) via an X-ray mask (8), a material constituting said resist film (10) being selected to include an element having an absorption edge in a region of wavelength of the X rays (2, 16) radiated to said resist film (10).

3. The exposure method according to claim 1 or 2, wherein

the X rays (2, 16) emitted from said X-ray source (1, 17) are reflected by an X-ray mirror (3a, 3b, 13-15) and thereafter radiated to reach said resist film (10), and
a material constituting a surface of said X-ray mirror (3a, 3b, 13-15) that reflects the X rays (2, 16) includes at least one selected from the group consisting of beryllium, titanium, silver, ruthenium, rhodium, palladium, iron, cobalt, nickel, copper, manganese, chromium, hafnium, tantalum, tungsten, rhenium, osmium, iridium, alloys, nitrides, carbides and borides of foregoing elements, diamond, diamond like carbon, and boron nitride.

**4.** The exposure method according to claim 1 or 2, wherein

the X rays (2, 16) emitted from said X-ray source (1, 17) are transmitted through at least one filter (4, 18) made of beryllium before radiated to reach said resist film (10),
said X-ray mask (8) includes a membrane (6) including diamond and an X-ray absorber film (7) formed on said membrane (6), and
the sum of thickness of said filter (4, 18) and thickness of said membrane (6) multiplied by ten in the direction of travel of the X rays (2, 16) is at least 50 μm.

**5.** A contrast-enhanced exposure method of radiating X rays (2, 16) emitted from an X-ray source (1, 17) to a resist film (10) via an X-ray mask (8),

said X-ray mask (8) including a membrane (6) and an X-ray absorber film (7) formed on said membrane (6), and
a material constituting said resist film (10) and a material constituting said X-ray absorber film (7) being selected to have an absorption peak wavelength of X rays (2, 16) absorbed by said resist film (10) that is located in a region of wavelength where absorption peak of X rays (2, 16) absorbed by the material constituting said X-ray absorber film (7) is present.

**6.** The exposure method according to any of claims 1, 2 and 5, wherein
said resist film (10) includes at least one element selected from the group consisting of bromine, silicon, phosphorus, sulfur and chlorine.

**7.** The exposure method according to any of claims 1, 2 and 5, wherein
said resist film (10) includes an element selected from the group consisting of bromine, silicon, phosphorus, sulfur, chlorine, fluorine and iodine, and the total content of said element in said resist film (10) is at least 20 % by mass.

**8.** The exposure method according to any of claims 1, 2 and 5, wherein
a solvent containing hydrocarbon including at least one selected from the group consisting of bromine, silicon, phosphorus, sulfur and chlorine remains in said resist film (10).

**9.** An exposure method of radiating X rays (2, 16) emitted from an X-ray source (1, 17) to a resist film(10) via an X-ray mask (8) and at least one transmission film (4, 18),

said X-ray mask (8) includes a membrane (6) transmitting X rays (2, 16) therethrough,
a material constituting said transmission film (4, 18) and a material constituting said membrane (6) include at least one selected from the group consisting of diamond and boron nitride, and
the sum of thickness of said filter (4, 18) and thickness of said membrane (6) in the direction of travel of the X rays (2, 16) is at least 5 μm.

**10.** A semiconductor device (9) manufactured by the exposure method according to any of claims 1 to 9.

**11.** An exposure apparatus (19) including an X-ray mirror (3a, 3b, 13-15), said X-ray mirror (3a, 3b, 13-15) having a surface reflecting X rays (2, 16), and said surface being constituted of a material including at least one selected from the group consisting of hafnium, tantalum, tungsten, rhenium, osmium, iridium, and alloys, nitrides, carbides and borides of foregoing elements.

**12.** An exposure apparatus (19, 20) including an X-ray mask (8) and at least one transmission film (4, 18) transmitting X rays (2, 16) therethrough,

said X-ray mask (8) including a membrane (6) transmitting X rays therethrough,

a material constituting said transmission film (4, 18) including at least one selected from the group consisting of beryllium, diamond and boron nitride,
a material constituting said membrane (6) including at least one selected from the group consisting of diamond and boron nitride,
respective evaluation values of diamond and boron nitride being calculated by multiplying by ten respective thicknesses, in the direction of travel of the X rays (2, 16), constituted respectively of diamond and boron nitride of said transmission film (4, 18) and said membrane (6), and an evaluation value of beryllium being thickness, in the direction of travel of the X rays (2, 16), constituted of beryllium of said transmission film (4, 18), and
the sum of said evaluation values for the materials constituting said transmission film (4, 18) and said membrane (6) in the direction of travel of the X rays (2, 16) being at least 50.

**13.** A semiconductor device (9) manufactured by the exposure apparatus (19, 20) according to any of claims 11 and 12.

**14.** A microstructure (9) manufactured by the exposure apparatus (19, 20) according to any of claims 11 and 12.

**15.** An X-ray mask (8) including a membrane (6) made of one selected from the group consisting of diamond and boron nitride, said membrane (6) having a thickness of at least 5 µm.

FIG.1

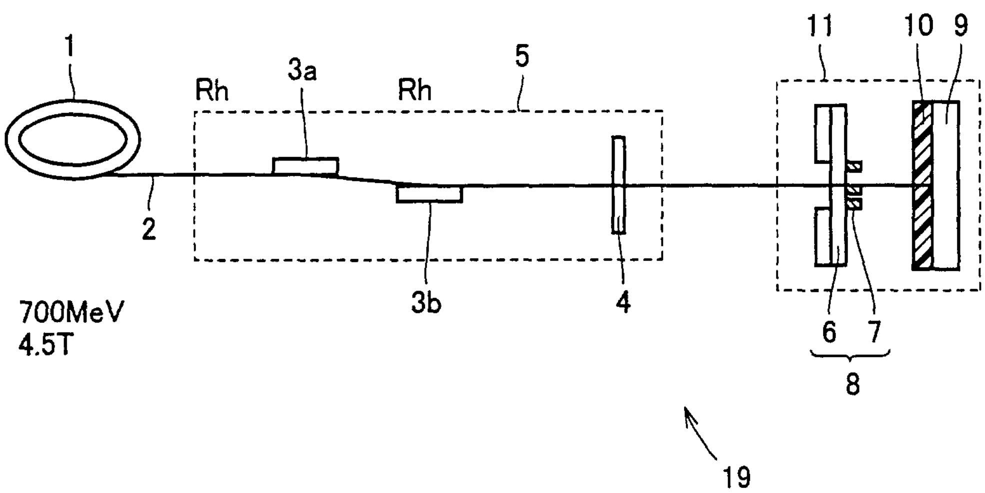

FIG.2

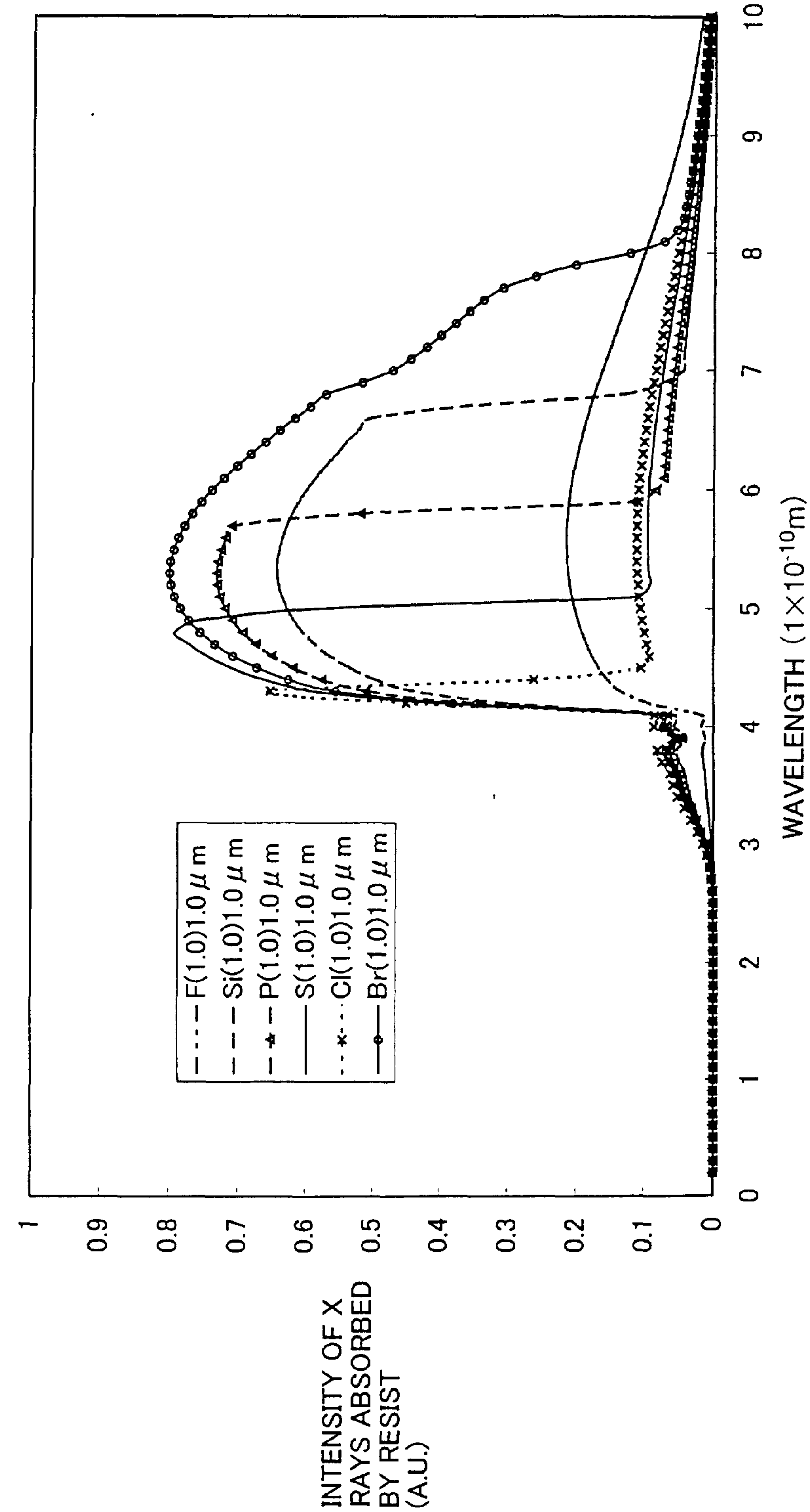
INTENSITY OF X RAYS ABSORBED BY RESIST (A.U.)
1
0.9
0.8
0.7
0.6
0.5
0.4
0.3
0.2
0.1
0
0
1
2
3
4
5
6
7
8
9
10
WAVELENGTH (1×10$^{-10}$m)
F(1.0)1.0 μ m
Si(1.0)1.0 μ m
P(1.0)1.0 μ m
S(1.0)1.0 μ m
Cl(1.0)1.0 μ m
Br(1.0)1.0 μ m

FIG.3

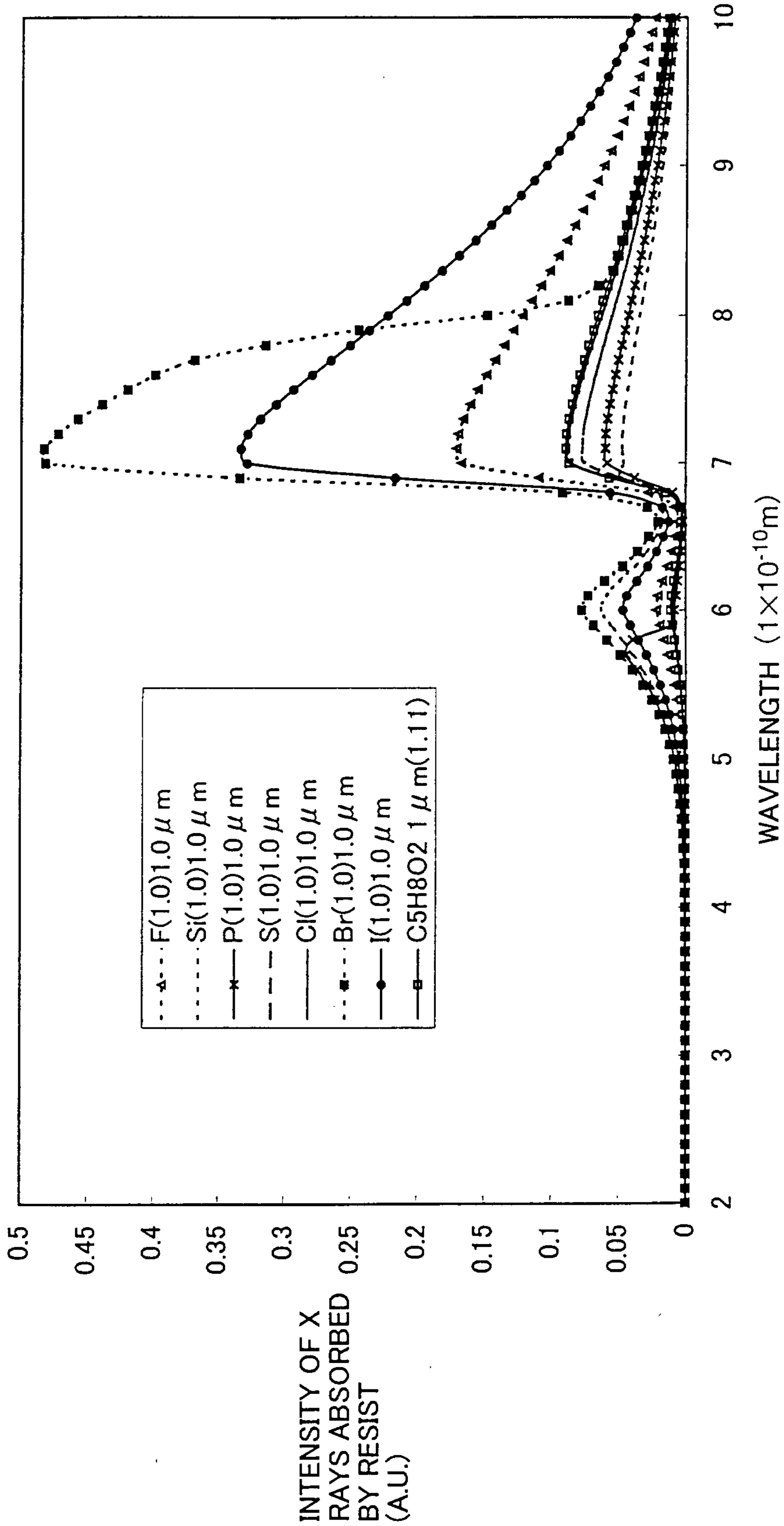
INTENSITY OF X RAYS ABSORBED BY RESIST (A.U.)
0.5
0.45
0.4
0.35
0.3
0.25
0.2
0.15
0.1
0.05
0
2
3
4
5
6
7
8
9
10
WAVELENGTH (1×10-10m)
F(1.0)1.0 μ m
Si(1.0)1.0 μ m
P(1.0)1.0 μ m
S(1.0)1.0 μ m
Cl(1.0)1.0 μ m
Br(1.0)1.0 μ m
I(1.0)1.0 μ m
C5H8O2 1 μ m(1.11)

FIG.4

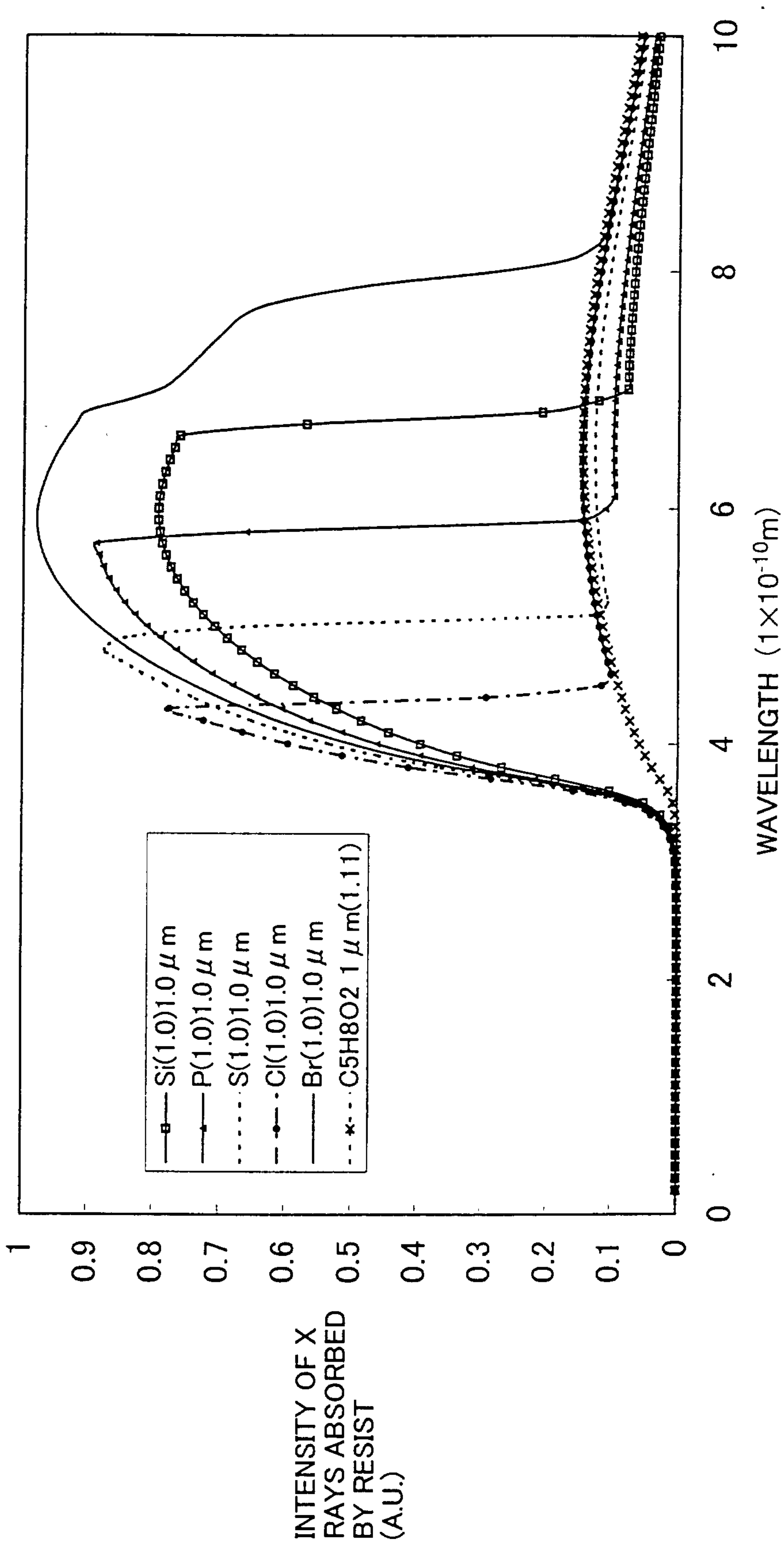
INTENSITY OF X RAYS ABSORBED BY RESIST (A.U.)
0
0.1
0.2
0.3
0.4
0.5
0.6
0.7
0.8
0.9
1
0
2
4
6
8
10
WAVELENGTH (1×$10^{-10}$m)
Si(1.0)1.0 μ m
P(1.0)1.0 μ m
S(1.0)1.0 μ m
Cl(1.0)1.0 μ m
Br(1.0)1.0 μ m
C5H8O2 1 μ m(1.11)

FIG.5

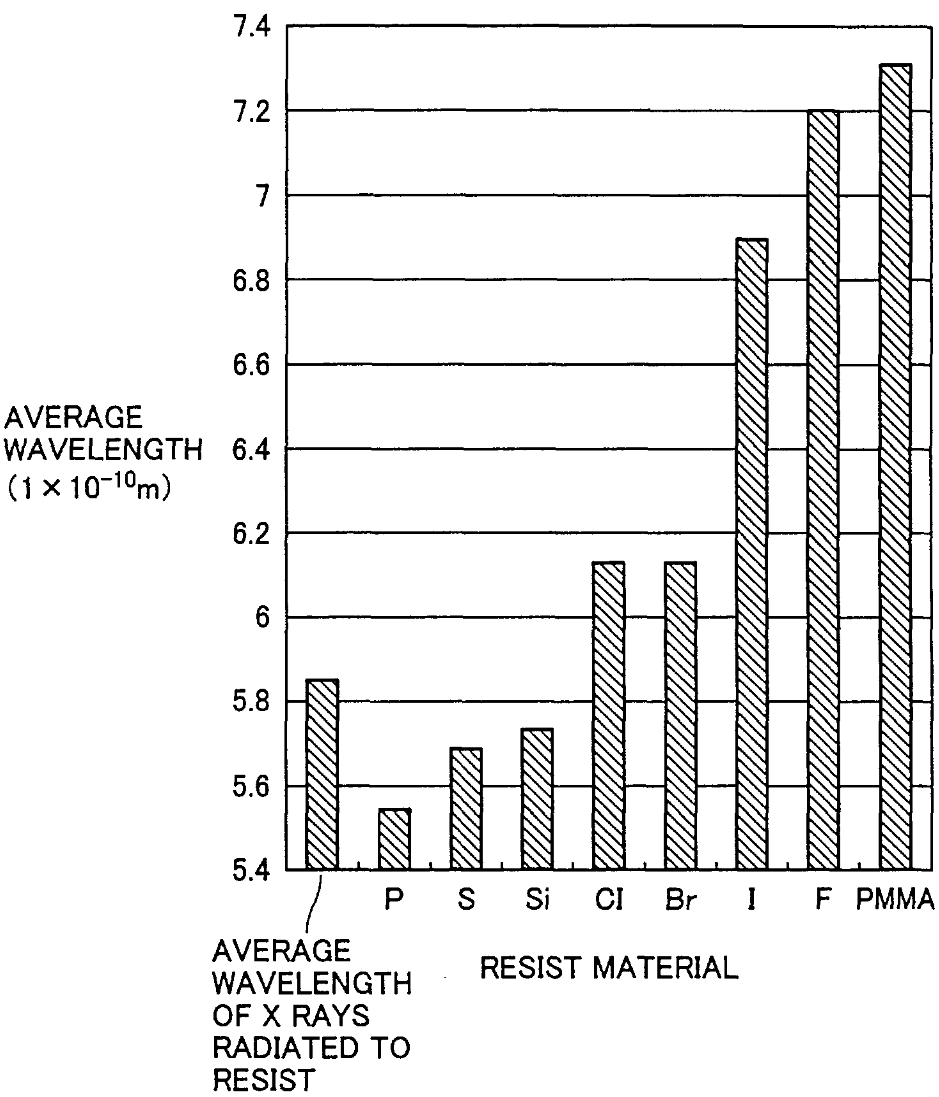
AVERAGE
WAVELENGTH
(1×10^-10 m)
7.4
7.2
7
6.8
6.6
6.4
6.2
6
5.8
5.6
5.4
P
S
Si
Cl
Br
I
F
PMMA
AVERAGE
WAVELENGTH
OF X RAYS
RADIATED TO
RESIST
RESIST MATERIAL

FIG.6

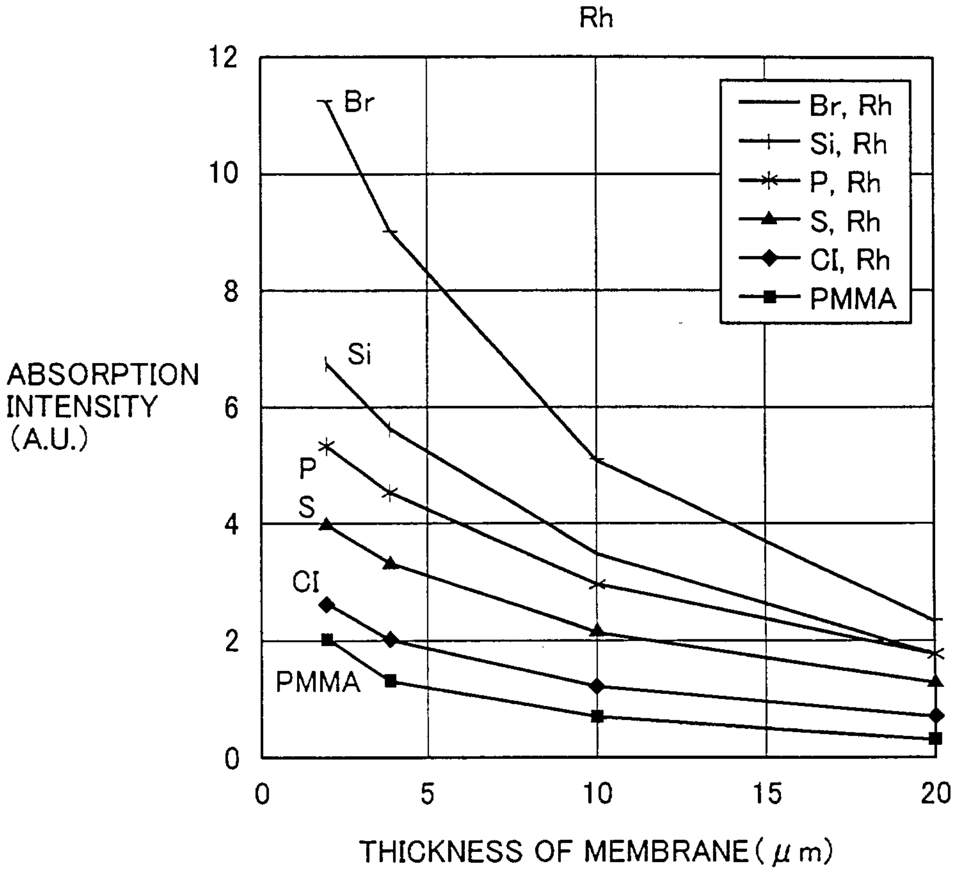
Rh
12
10
8
6
4
2
0
0
5
10
15
20
ABSORPTION
INTENSITY
(A.U.)
THICKNESS OF MEMBRANE ( μ m)
Br
Si
P
S
CI
PMMA
Br, Rh
Si, Rh
P, Rh
S, Rh
CI, Rh
PMMA

FIG.7

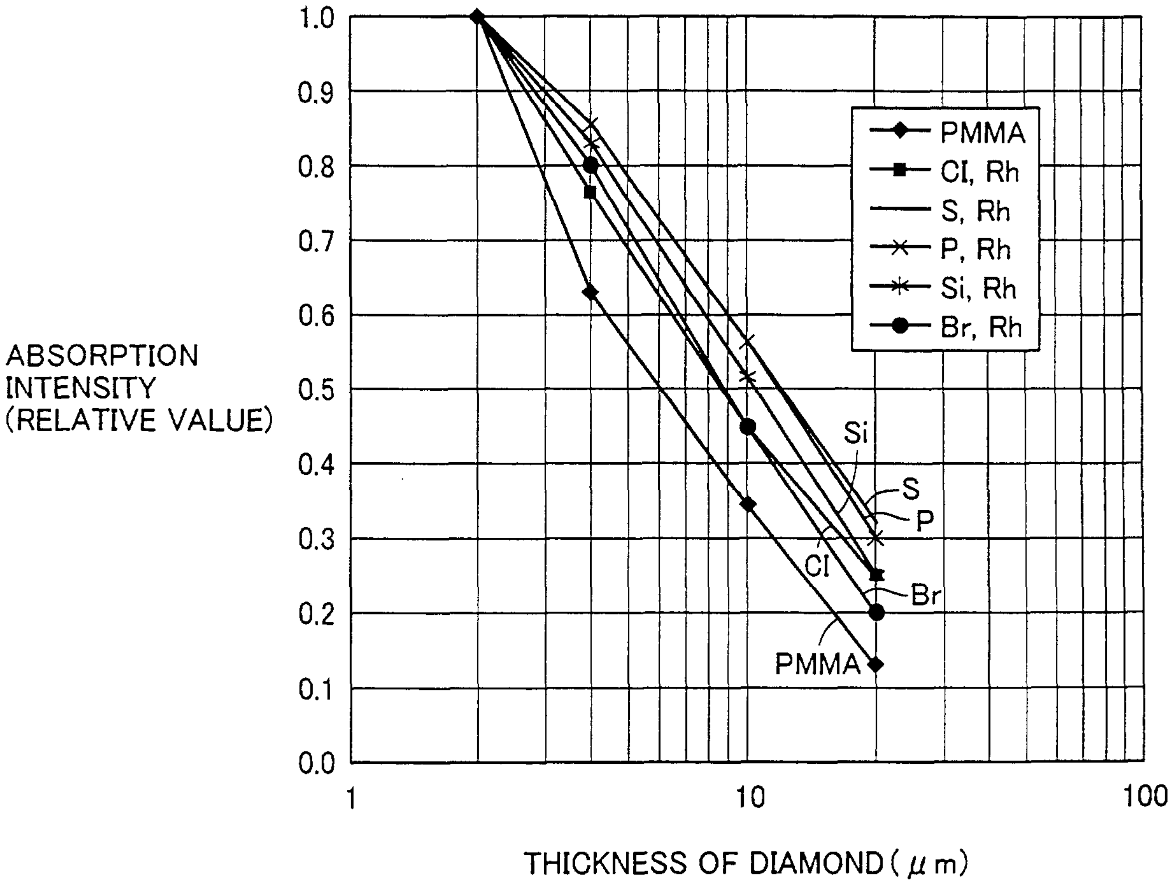
ABSORPTION INTENSITY (RELATIVE VALUE)
1.0
0.9
0.8
0.7
0.6
0.5
0.4
0.3
0.2
0.1
0.0
1
10
100
THICKNESS OF DIAMOND ( μ m)
PMMA
Cl, Rh
S, Rh
P, Rh
Si, Rh
Br, Rh
Si
S
P
Cl
Br
PMMA

FIG.8

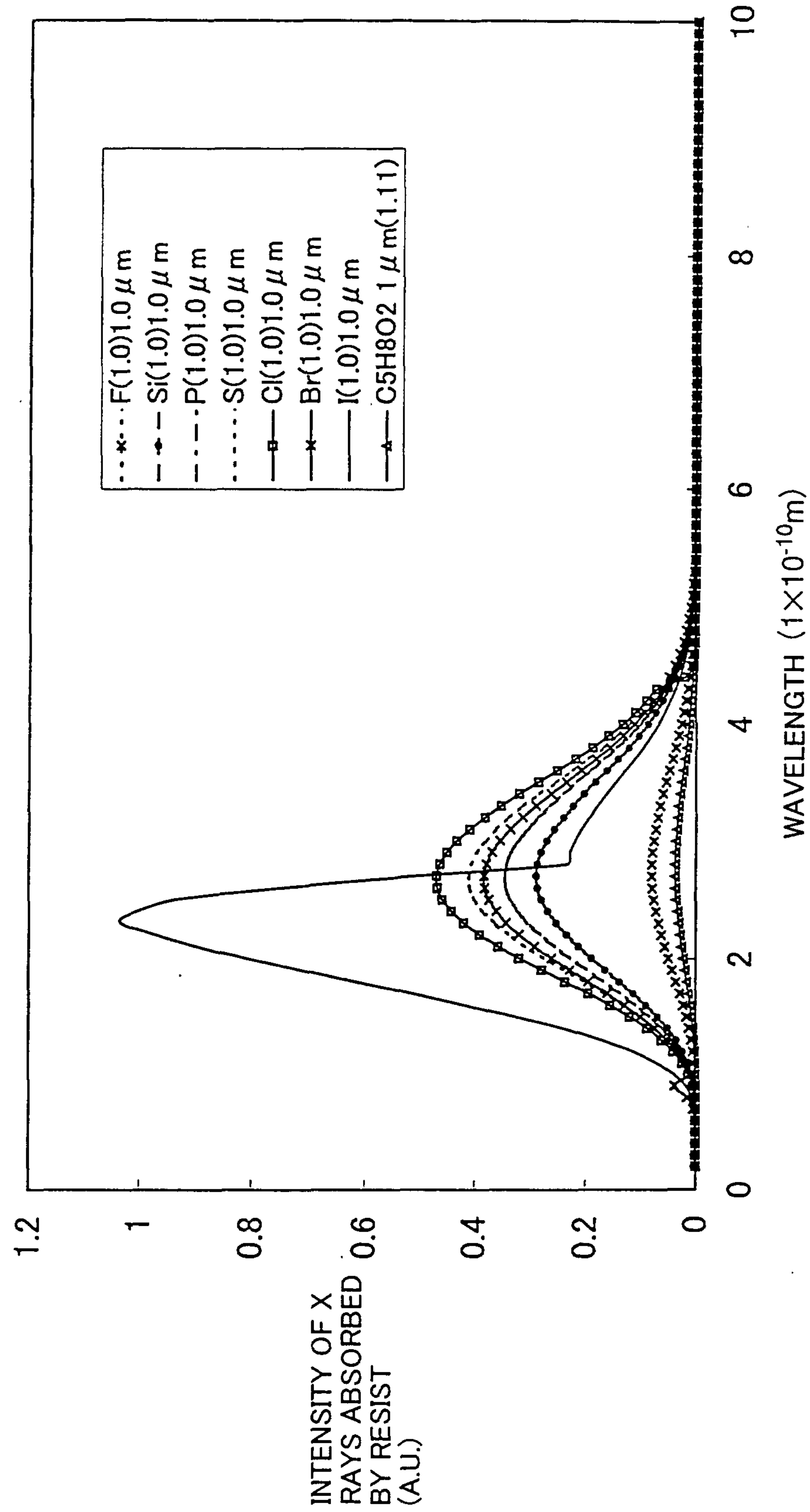
INTENSITY OF X RAYS ABSORBED BY RESIST (A.U.)
1.2
1
0.8
0.6
0.4
0.2
0
0
2
4
6
8
10
WAVELENGTH (1×10$^{-10}$m)
F(1.0)1.0 μ m
Si(1.0)1.0 μ m
P(1.0)1.0 μ m
S(1.0)1.0 μ m
Cl(1.0)1.0 μ m
Br(1.0)1.0 μ m
I(1.0)1.0 μ m
C5H8O2 1 μ m(1.11)

FIG.9

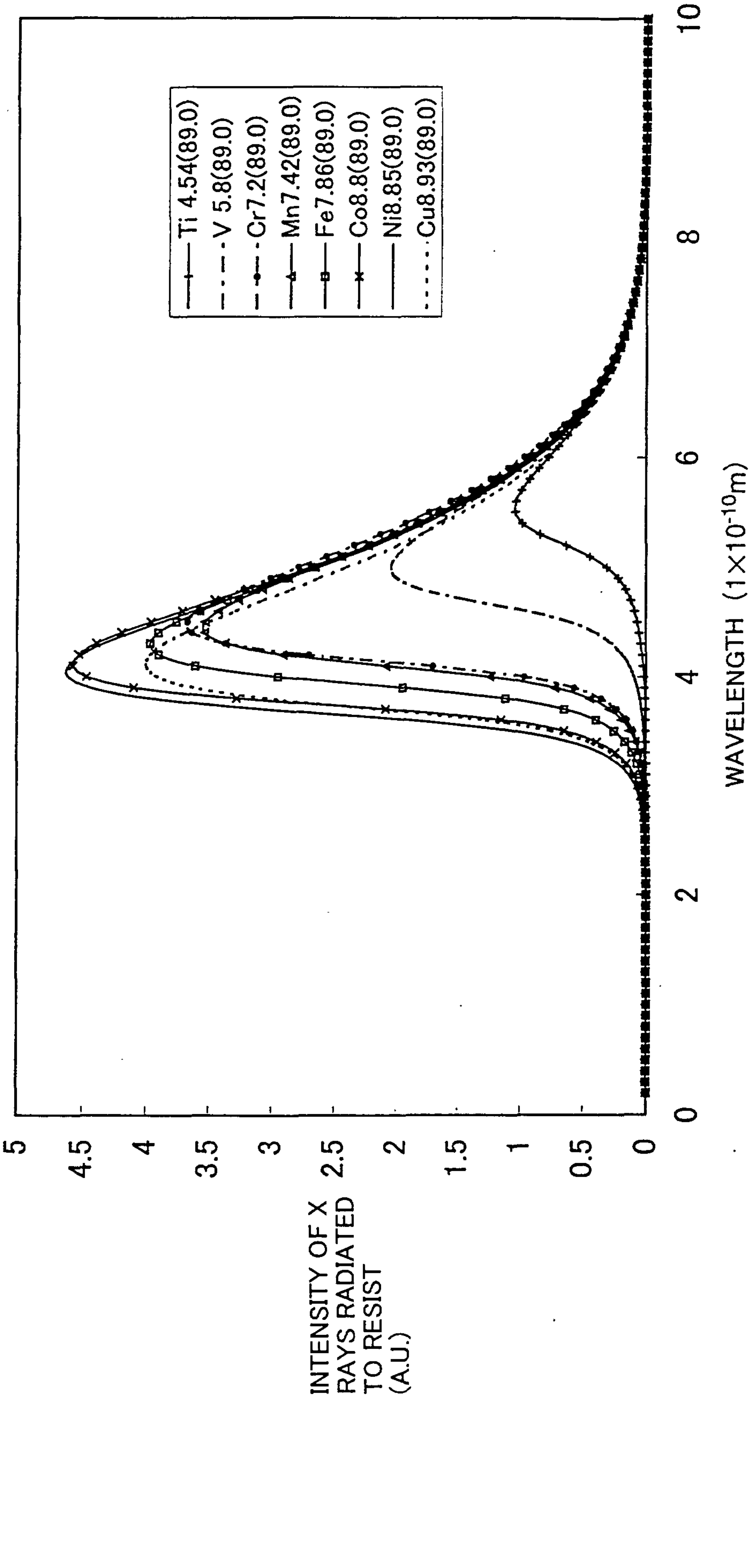
INTENSITY OF X RAYS RADIATED TO RESIST (A.U.)
WAVELENGTH (1×10$^{-10}$m)
0
0.5
1
1.5
2
2.5
3
3.5
4
4.5
5
0
2
4
6
8
10
Ti 4.54(89.0)
V 5.8(89.0)
Cr7.2(89.0)
Mn7.42(89.0)
Fe7.86(89.0)
Co8.8(89.0)
Ni8.85(89.0)
Cu8.93(89.0)

FIG.10

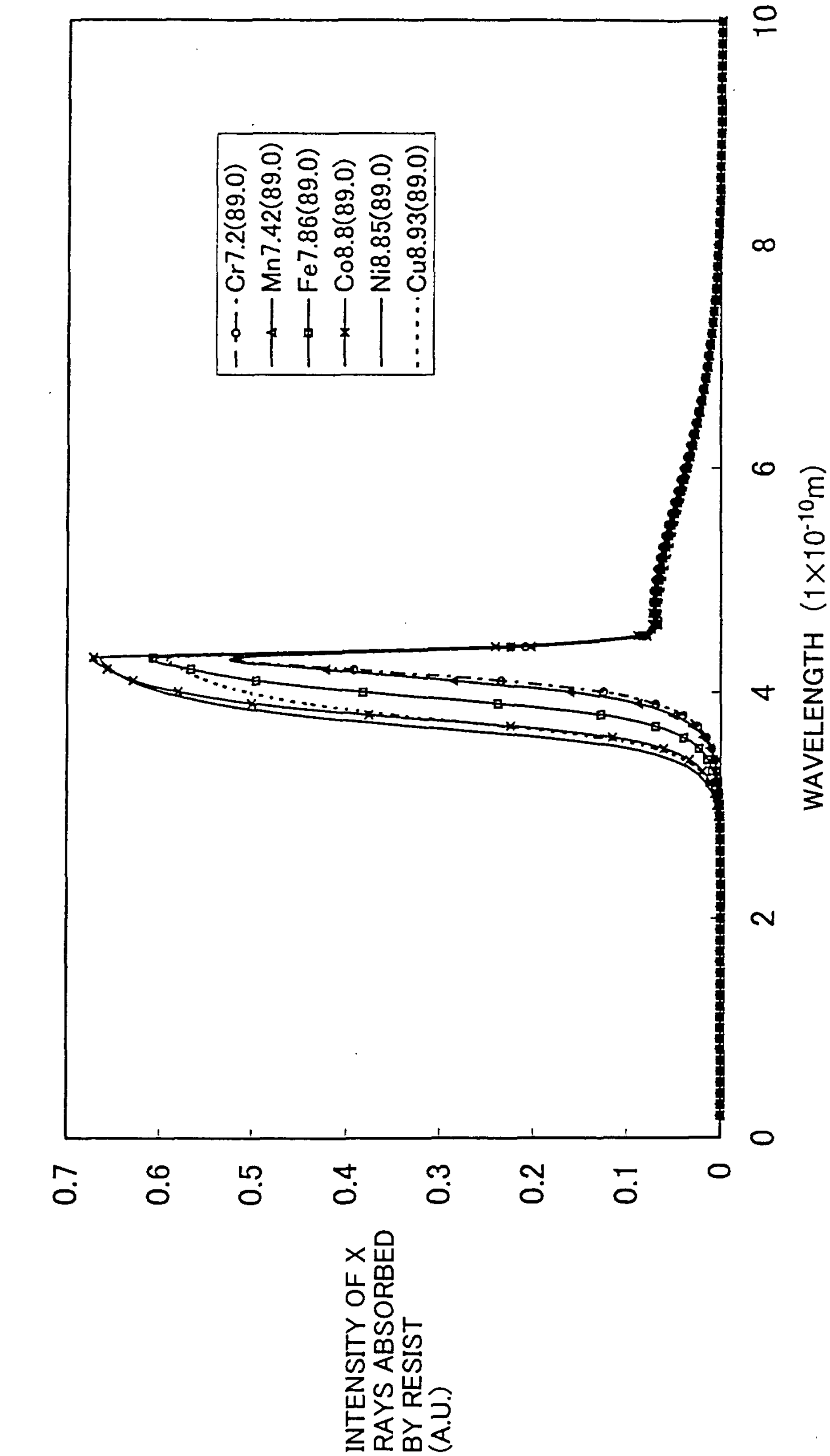
INTENSITY OF X RAYS ABSORBED BY RESIST (A.U.)
0.7
0.6
0.5
0.4
0.3
0.2
0.1
0
0
2
4
6
8
10
WAVELENGTH (1×10⁻¹⁰m)
Cr7.2(89.0)
Mn7.42(89.0)
Fe7.86(89.0)
Co8.8(89.0)
Ni8.85(89.0)
Cu8.93(89.0)

FIG.11

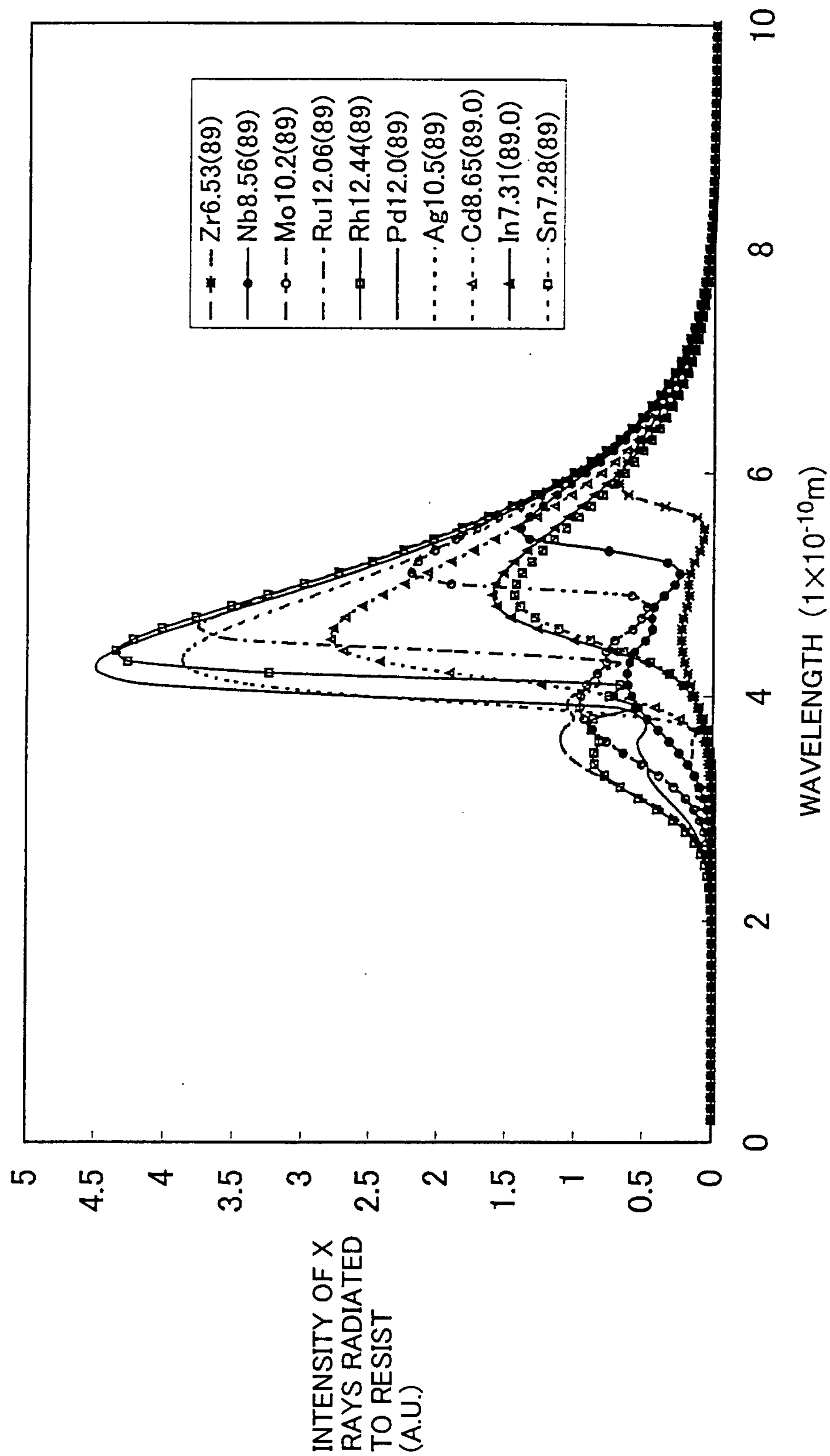
INTENSITY OF X RAYS RADIATED TO RESIST (A.U.)
0
0.5
1
1.5
2
2.5
3
3.5
4
4.5
5
0
2
4
6
8
10
WAVELENGTH (1×10-10m)
Zr6.53(89)
Nb8.56(89)
Mo10.2(89)
Ru12.06(89)
Rh12.44(89)
Pd12.0(89)
Ag10.5(89)
Cd8.65(89.0)
In7.31(89.0)
Sn7.28(89)

FIG.12

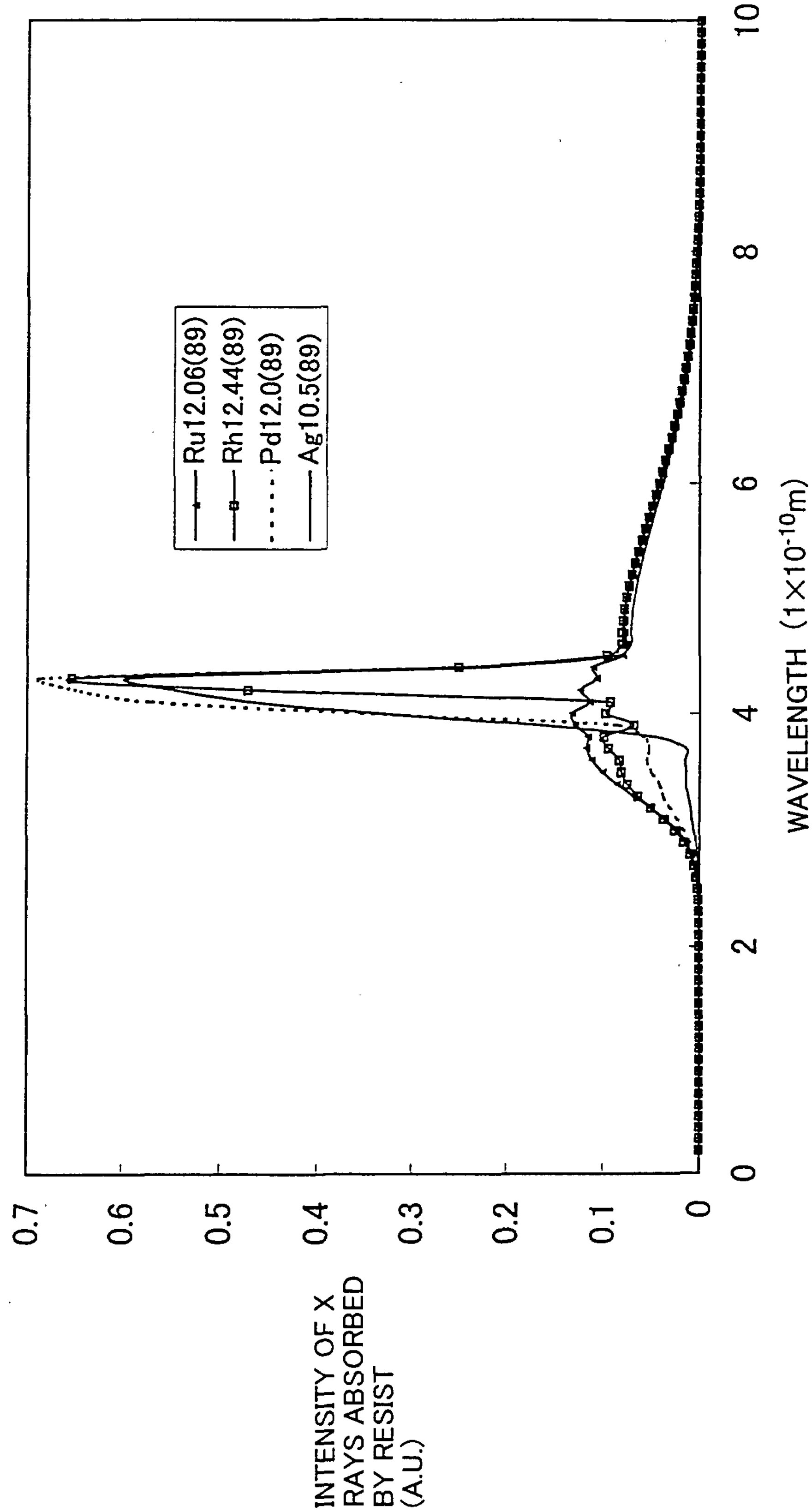
INTENSITY OF X RAYS ABSORBED BY RESIST (A.U.)
0.7
0.6
0.5
0.4
0.3
0.2
0.1
0
Ru12.06(89)
Rh12.44(89)
Pd12.0(89)
Ag10.5(89)
0
2
4
6
8
10
WAVELENGTH (1×10^-10m)

FIG.13

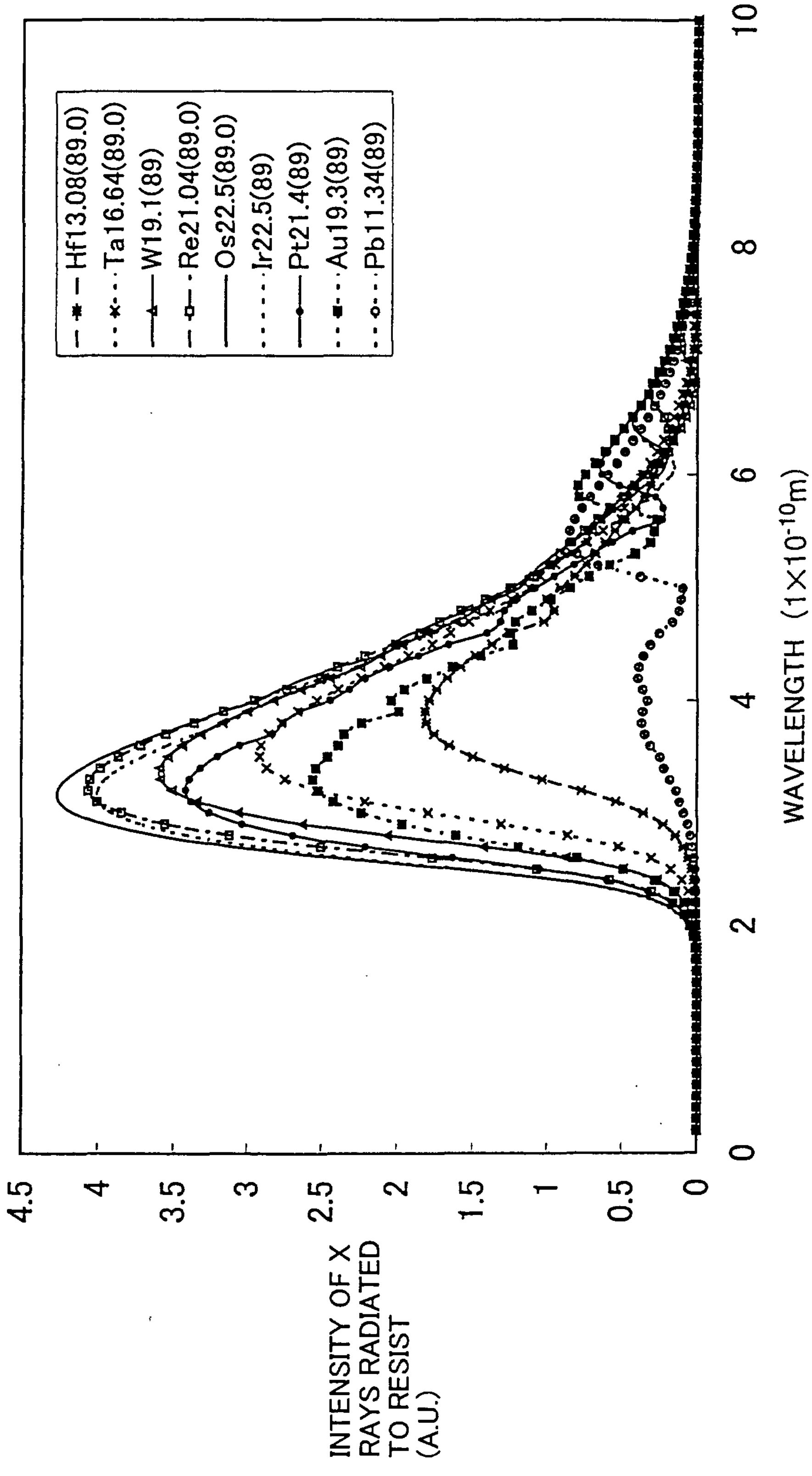
INTENSITY OF X RAYS RADIATED TO RESIST (A.U.)
4.5
4
3.5
3
2.5
2
1.5
1
0.5
0
0
2
4
6
8
10
WAVELENGTH $(1\times10^{-10}m)$
Hf13.08(89.0)
Ta16.64(89.0)
W19.1(89)
Re21.04(89.0)
Os22.5(89.0)
Ir22.5(89)
Pt21.4(89)
Au19.3(89)
Pb11.34(89)

FIG.14

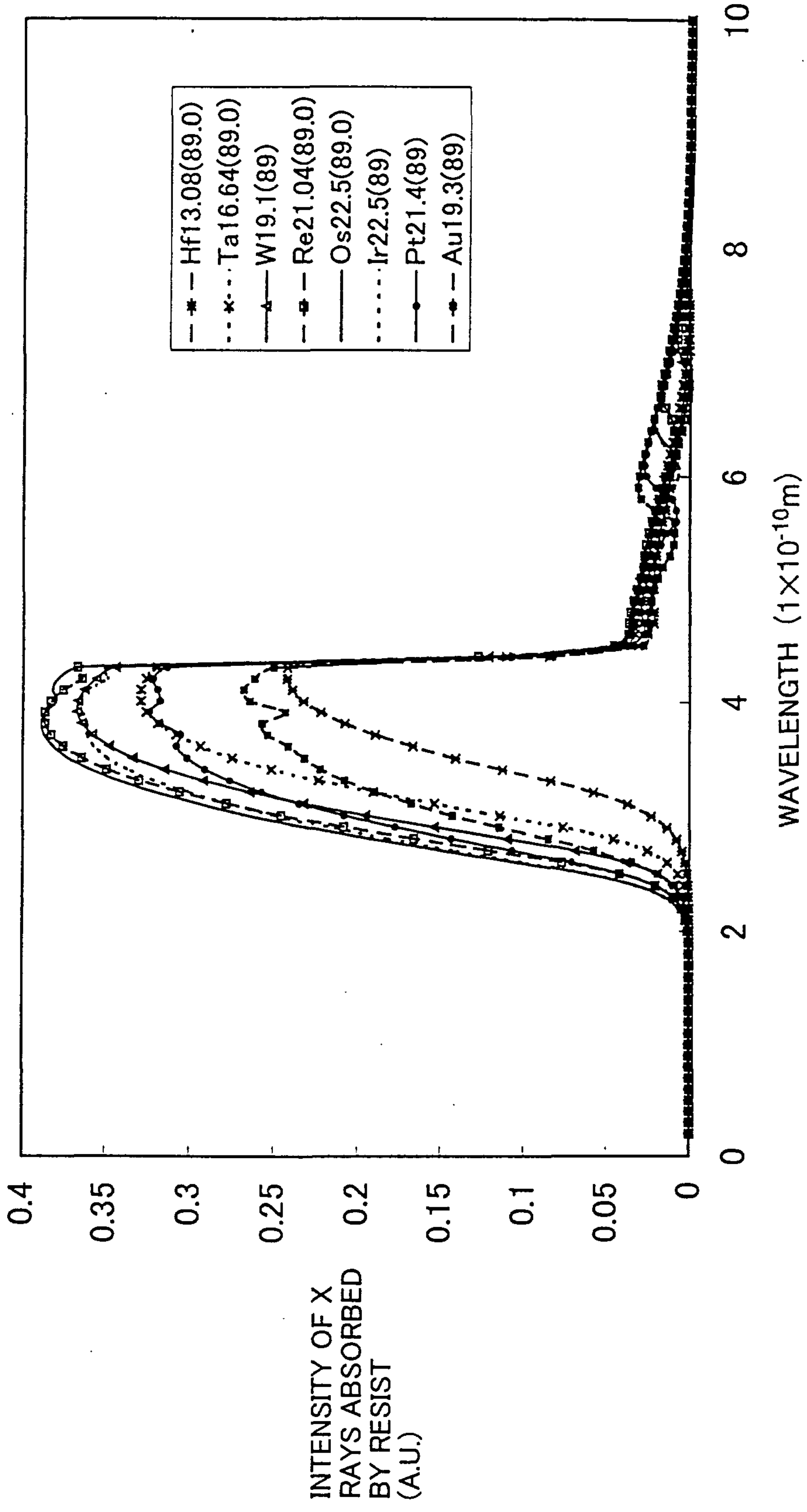

INTENSITY OF X RAYS ABSORBED BY RESIST (A.U.)
0.4
0.35
0.3
0.25
0.2
0.15
0.1
0.05
0
0
2
4
6
8
10
WAVELENGTH (1×10$^{-10}$m)
Hf13.08(89.0)
Ta16.64(89.0)
W19.1(89)
Re21.04(89.0)
Os22.5(89.0)
Ir22.5(89)
Pt21.4(89)
Au19.3(89)

FIG.15

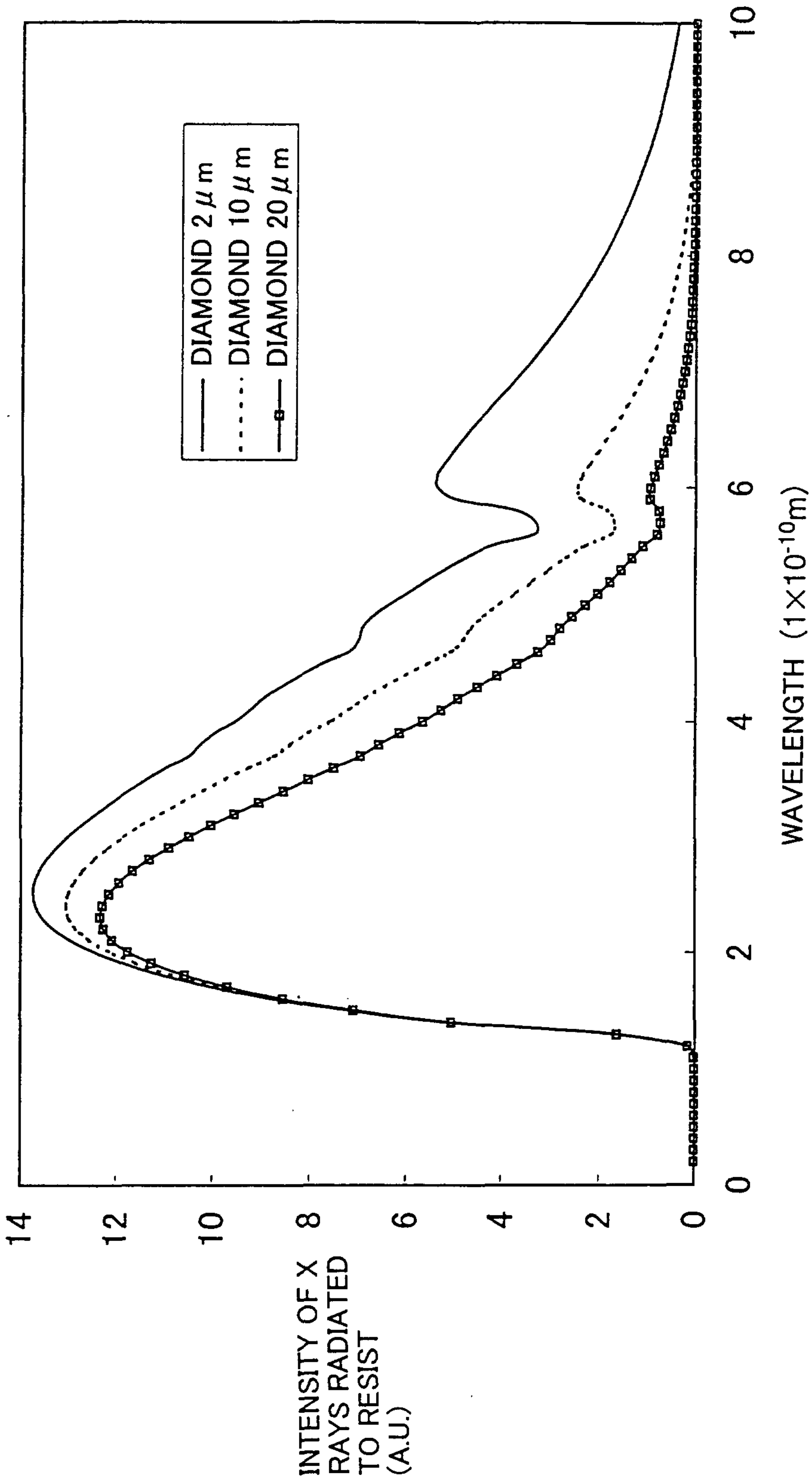
INTENSITY OF X RAYS RADIATED TO RESIST (A.U.)
14
12
10
8
6
4
2
0
0
2
4
6
8
10
WAVELENGTH (1×10$^{-10}$m)
DIAMOND 2 μ m
DIAMOND 10 μ m
DIAMOND 20 μ m

FIG.16

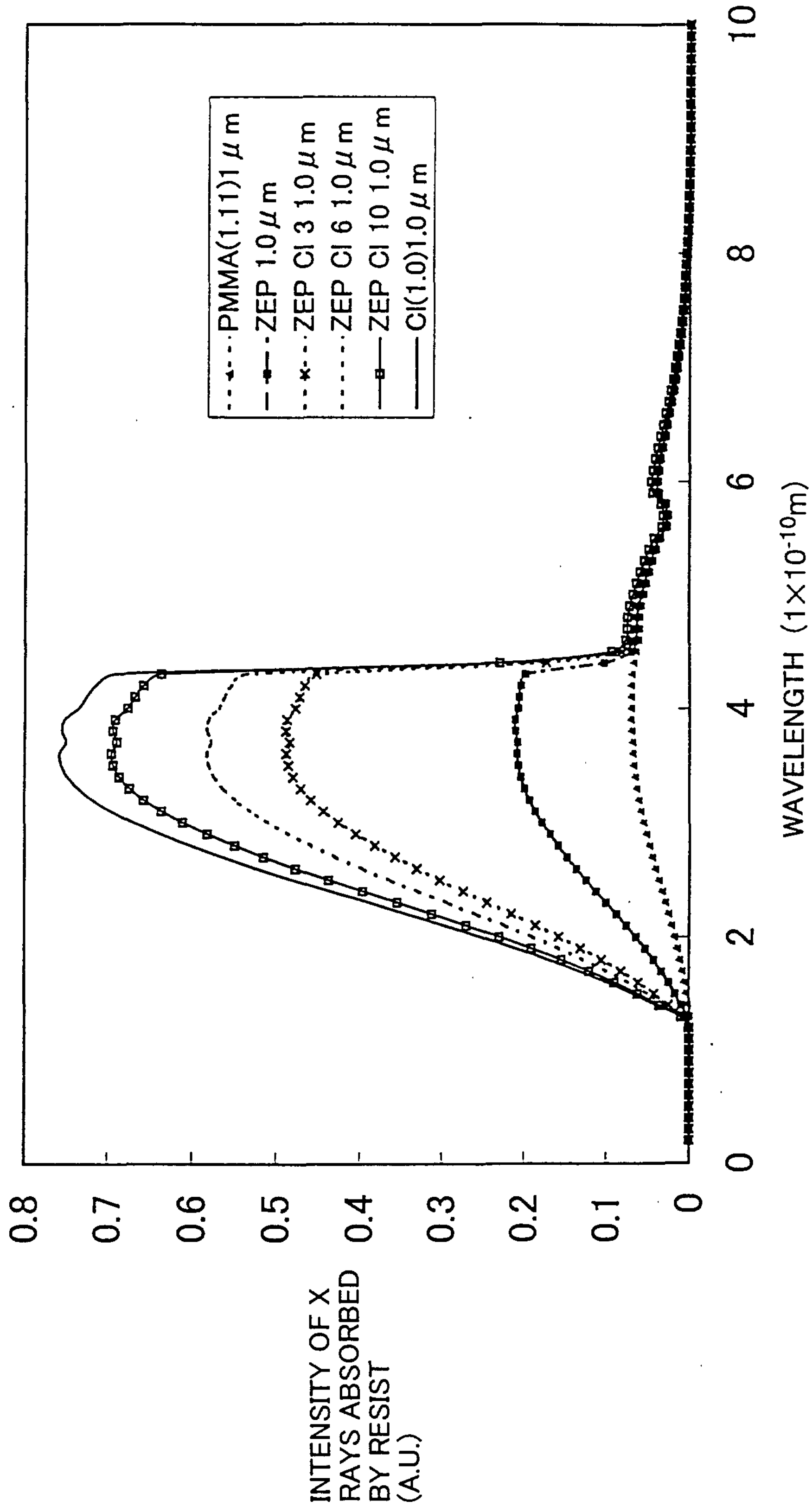
INTENSITY OF X RAYS ABSORBED BY RESIST (A.U.)
0.8
0.7
0.6
0.5
0.4
0.3
0.2
0.1
0
0
2
4
6
8
10
WAVELENGTH (1×10-10m)
PMMA(1.11)1 μm
ZEP 1.0 μm
ZEP Cl 3 1.0 μm
ZEP Cl 6 1.0 μm
ZEP Cl 10 1.0 μm
Cl(1.0)1.0 μm

FIG.17

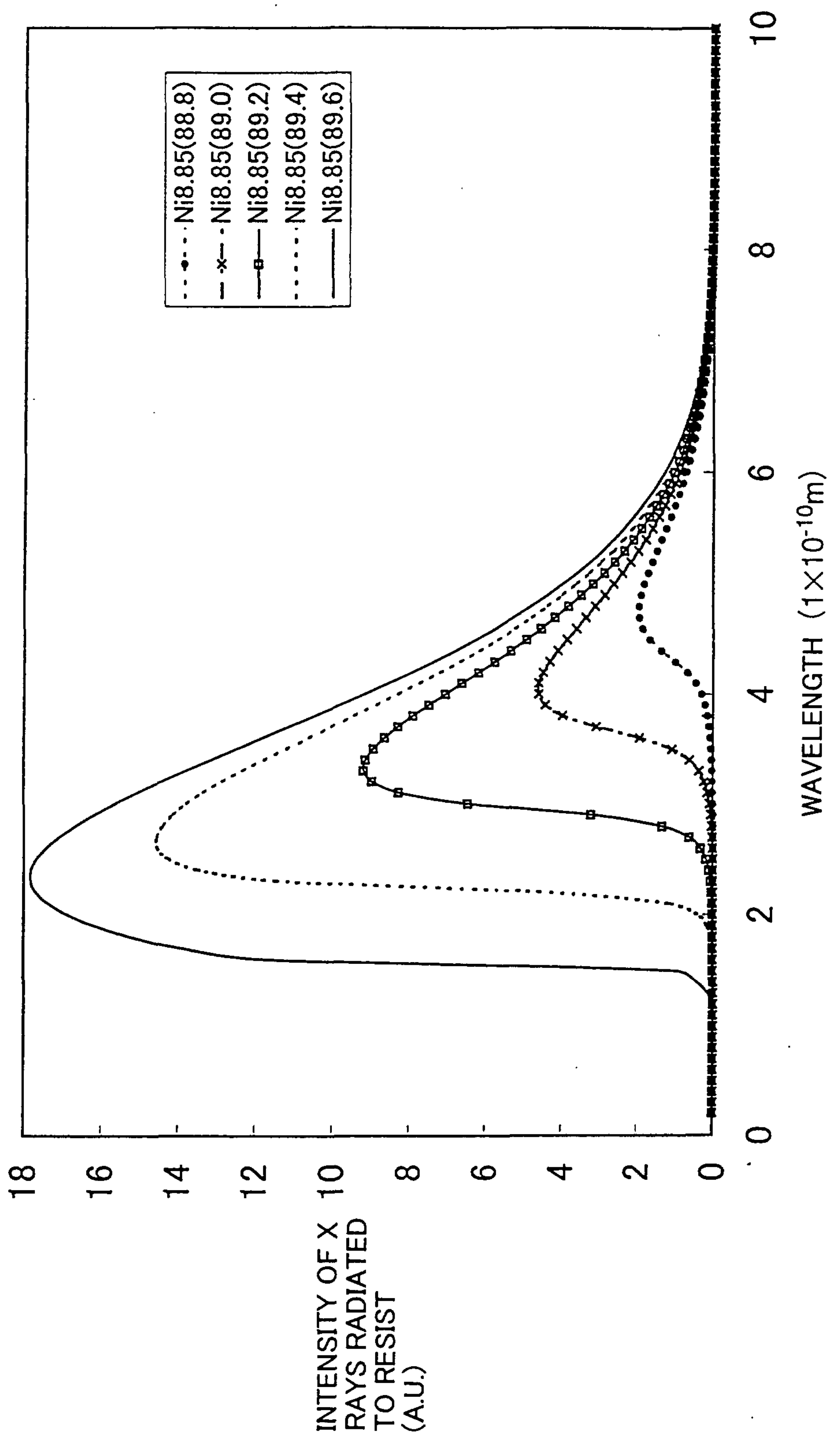

INTENSITY OF X RAYS RADIATED TO RESIST (A.U.)
0
2
4
6
8
10
12
14
16
18
WAVELENGTH (1×10^-10 m)
0
2
4
6
8
10
Ni8.85(88.8)
Ni8.85(89.0)
Ni8.85(89.2)
Ni8.85(89.4)
Ni8.85(89.6)

FIG.18

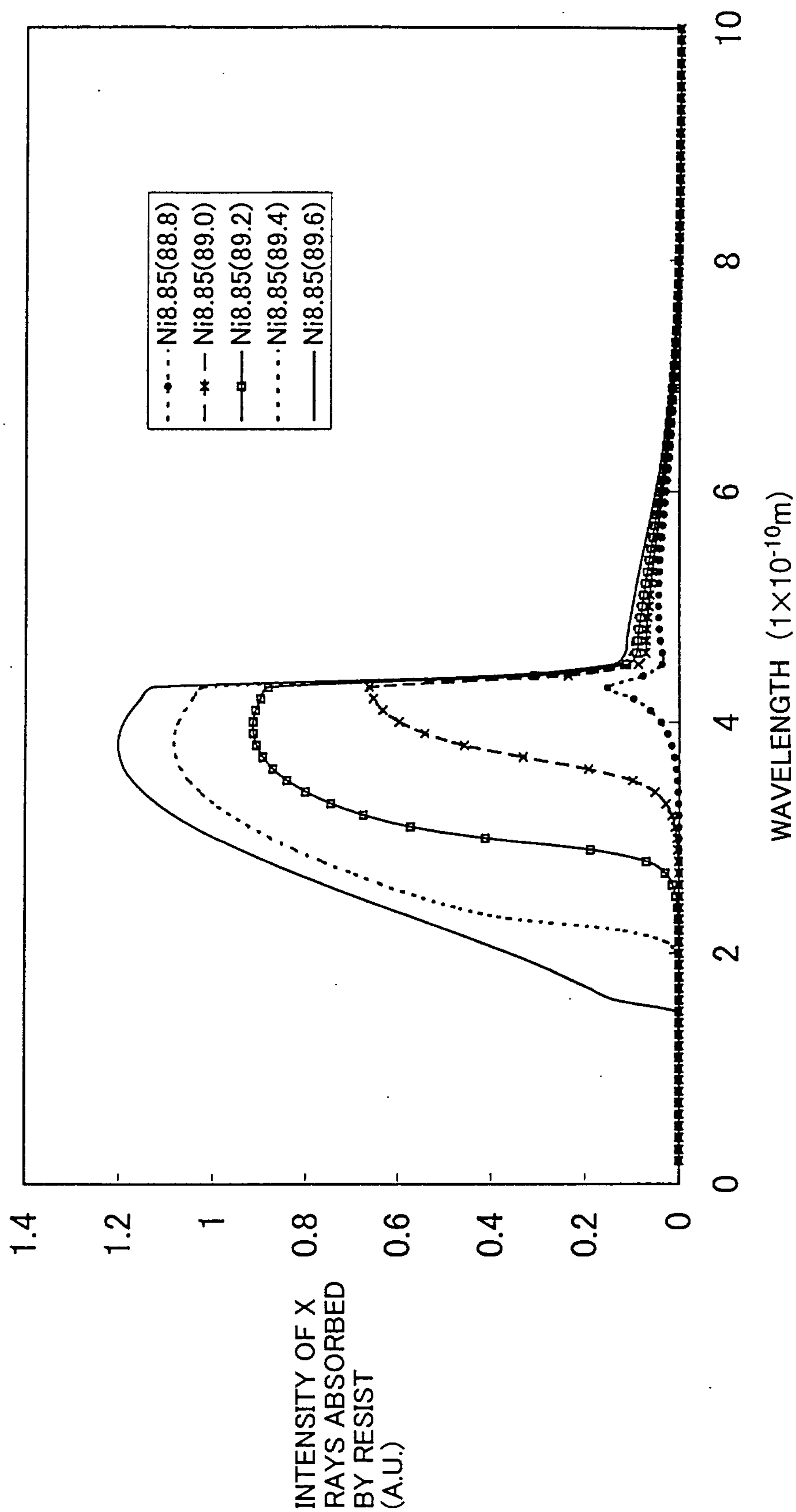
INTENSITY OF X RAYS ABSORBED BY RESIST (A.U.)
1.4
1.2
1
0.8
0.6
0.4
0.2
0
0
2
4
6
8
10
WAVELENGTH (1×10-10m)
Ni8.85(88.8)
Ni8.85(89.0)
Ni8.85(89.2)
Ni8.85(89.4)
Ni8.85(89.6)

FIG.19

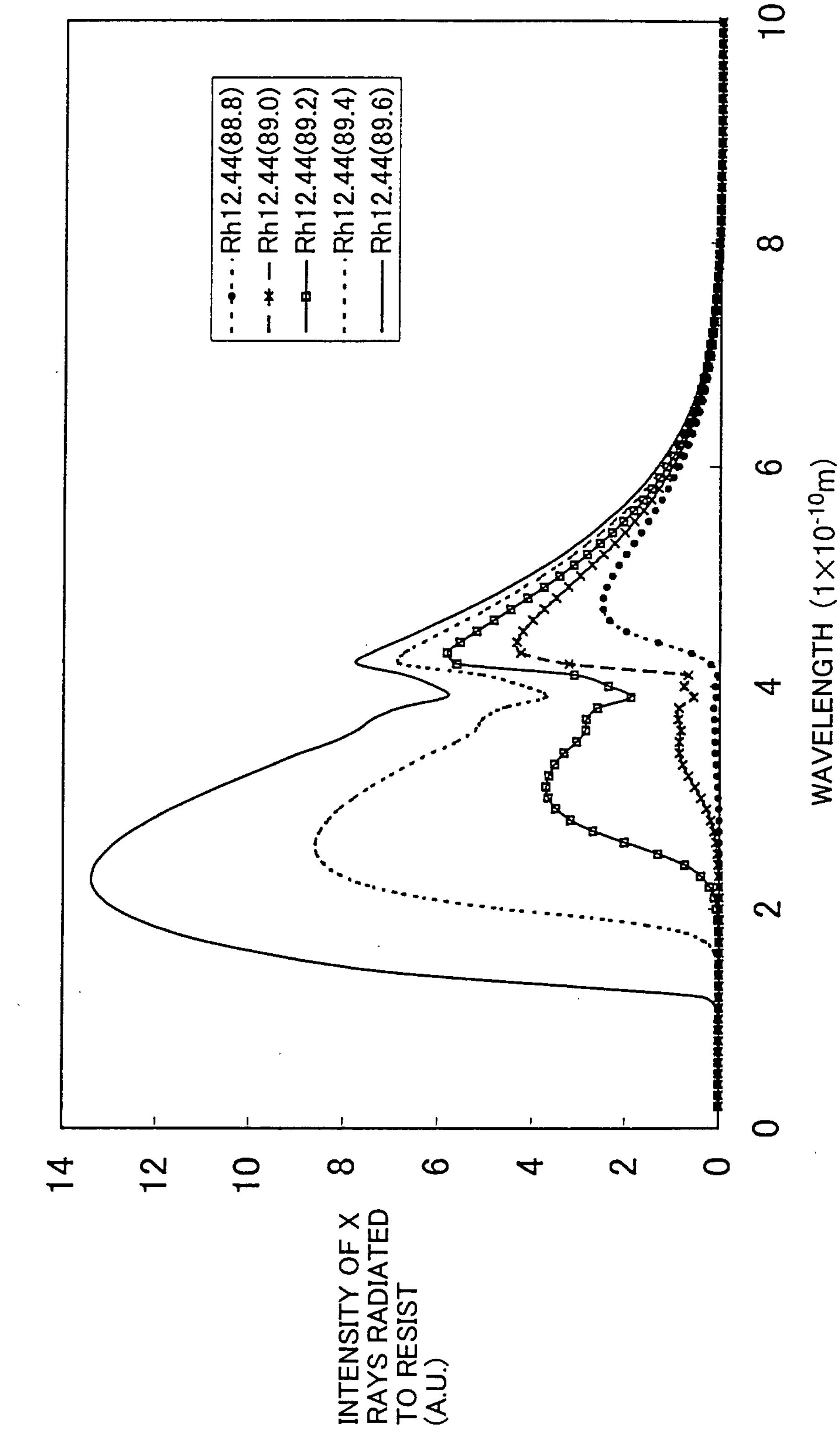
INTENSITY OF X RAYS RADIATED TO RESIST (A.U.)
0
2
4
6
8
10
12
14
WAVELENGTH (1×10$^{-10}$m)
0
2
4
6
8
10
Rh12.44(88.8)
Rh12.44(89.0)
Rh12.44(89.2)
Rh12.44(89.4)
Rh12.44(89.6)

FIG.20

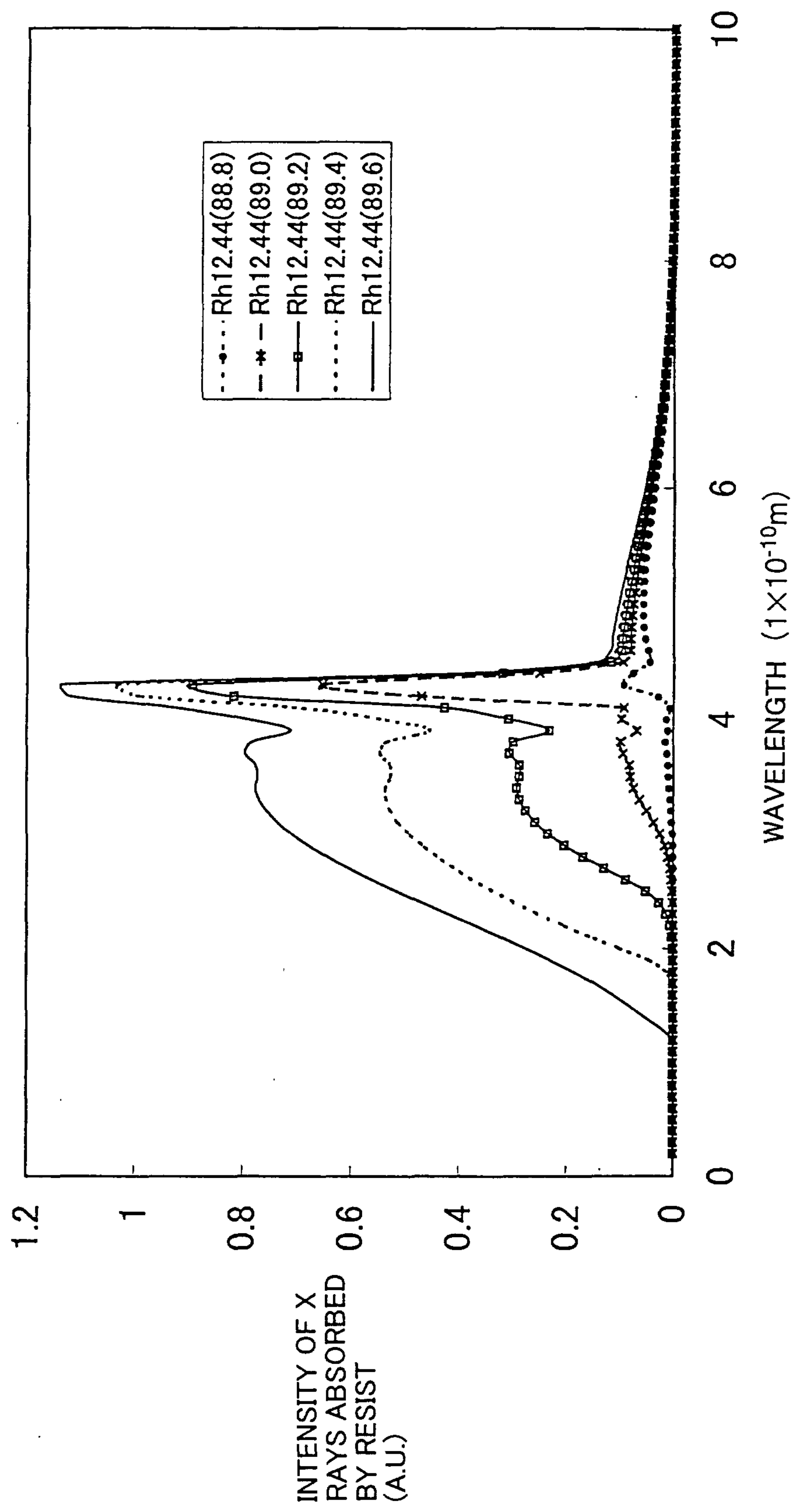
INTENSITY OF X RAYS ABSORBED BY RESIST (A.U.)
1.2
1
0.8
0.6
0.4
0.2
0
0
2
4
6
8
10
WAVELENGTH (1×10^-10m)
Rh12.44(88.8)
Rh12.44(89.0)
Rh12.44(89.2)
Rh12.44(89.4)
Rh12.44(89.6)

FIG.21

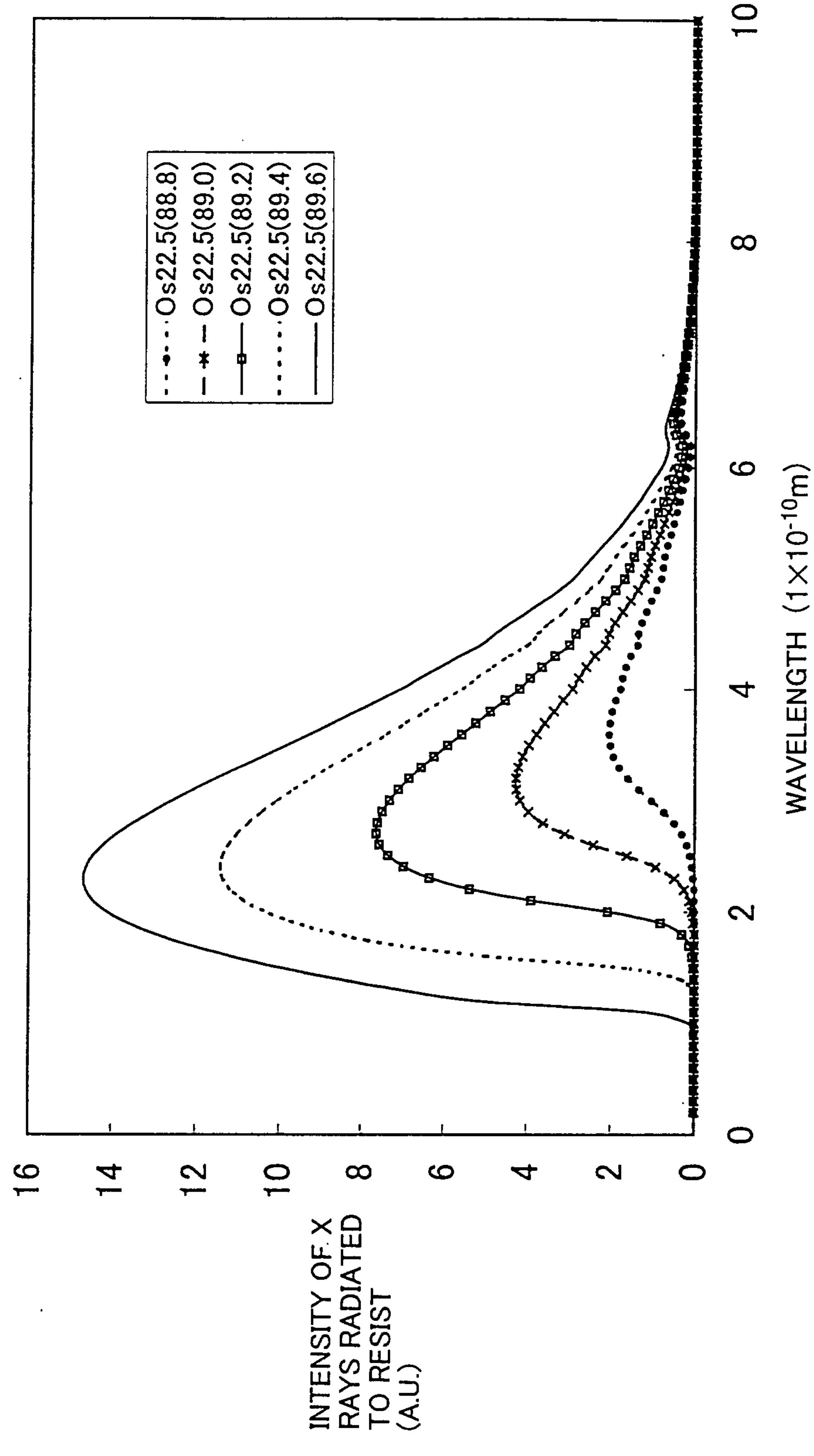
INTENSITY OF X RAYS RADIATED TO RESIST (A.U.)
WAVELENGTH (1×10⁻¹⁰m)
0
2
4
6
8
10
12
14
16
Os22.5(88.8)
Os22.5(89.0)
Os22.5(89.2)
Os22.5(89.4)
Os22.5(89.6)

FIG.22

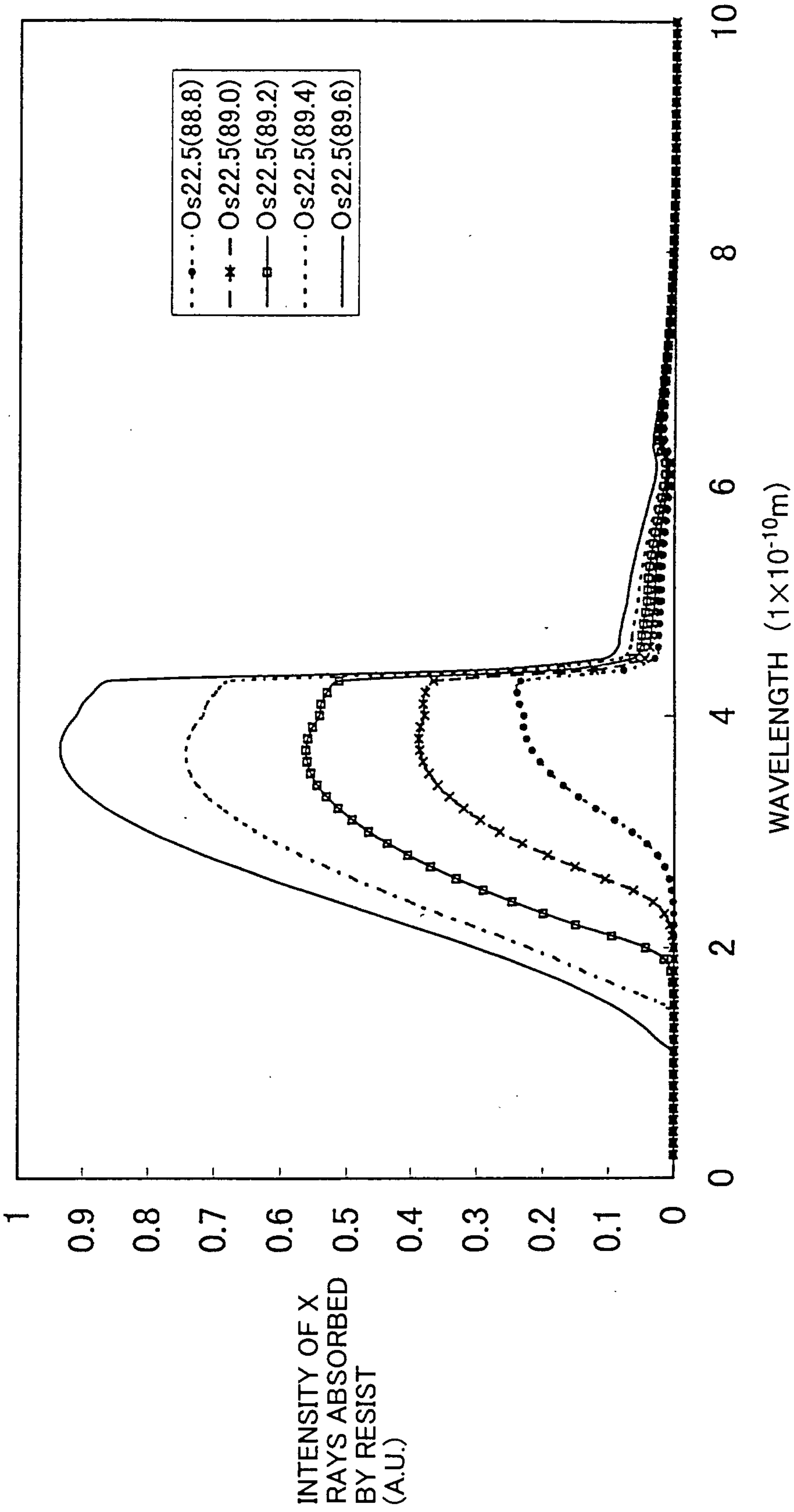
INTENSITY OF X RAYS ABSORBED BY RESIST (A.U.)
1
0.9
0.8
0.7
0.6
0.5
0.4
0.3
0.2
0.1
0
0
2
4
6
8
10
WAVELENGTH (1×10^-10 m)
Os22.5(88.8)
Os22.5(89.0)
Os22.5(89.2)
Os22.5(89.4)
Os22.5(89.6)

FIG.23

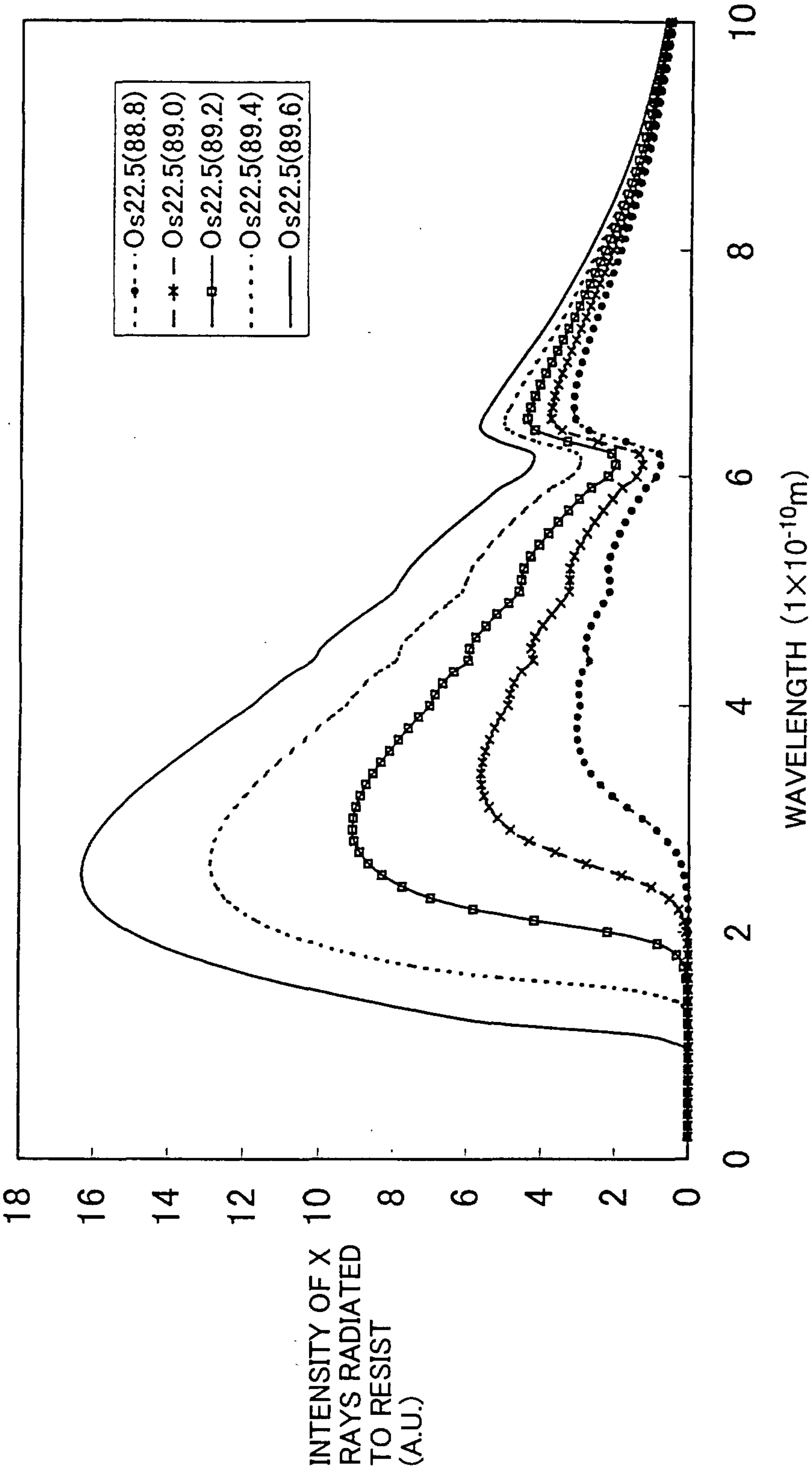

INTENSITY OF X RAYS RADIATED TO RESIST (A.U.)
18
16
14
12
10
8
6
4
2
0
0
2
4
6
8
10
WAVELENGTH ($1 \times 10^{-10}$m)
Os22.5(88.8)
Os22.5(89.0)
Os22.5(89.2)
Os22.5(89.4)
Os22.5(89.6)

FIG.24

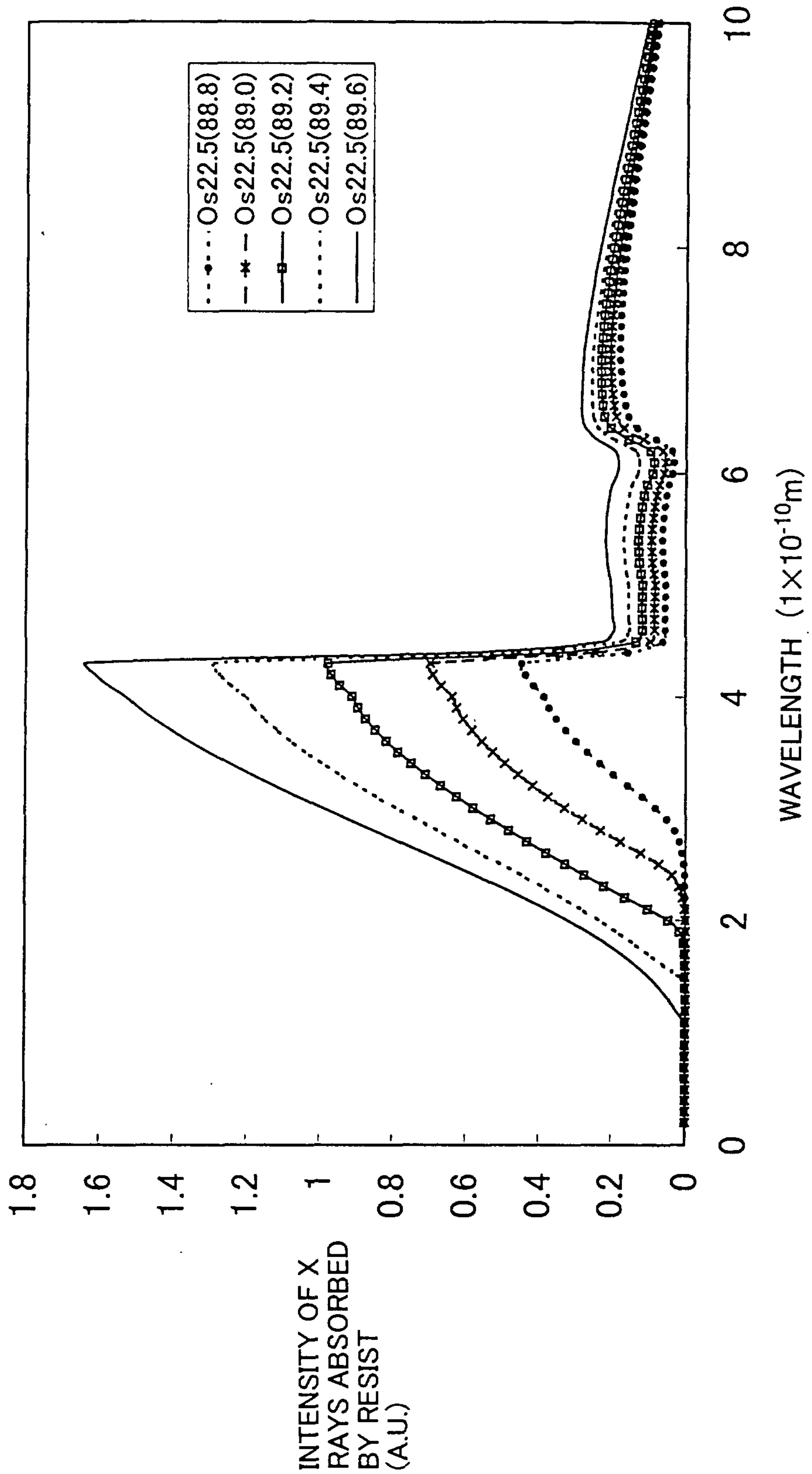
INTENSITY OF X RAYS ABSORBED BY RESIST (A.U.)
1.8
1.6
1.4
1.2
1
0.8
0.6
0.4
0.2
0
0
2
4
6
8
10
WAVELENGTH (1×10⁻¹⁰m)
Os22.5(88.8)
Os22.5(89.0)
Os22.5(89.2)
Os22.5(89.4)
Os22.5(89.6)

FIG.25

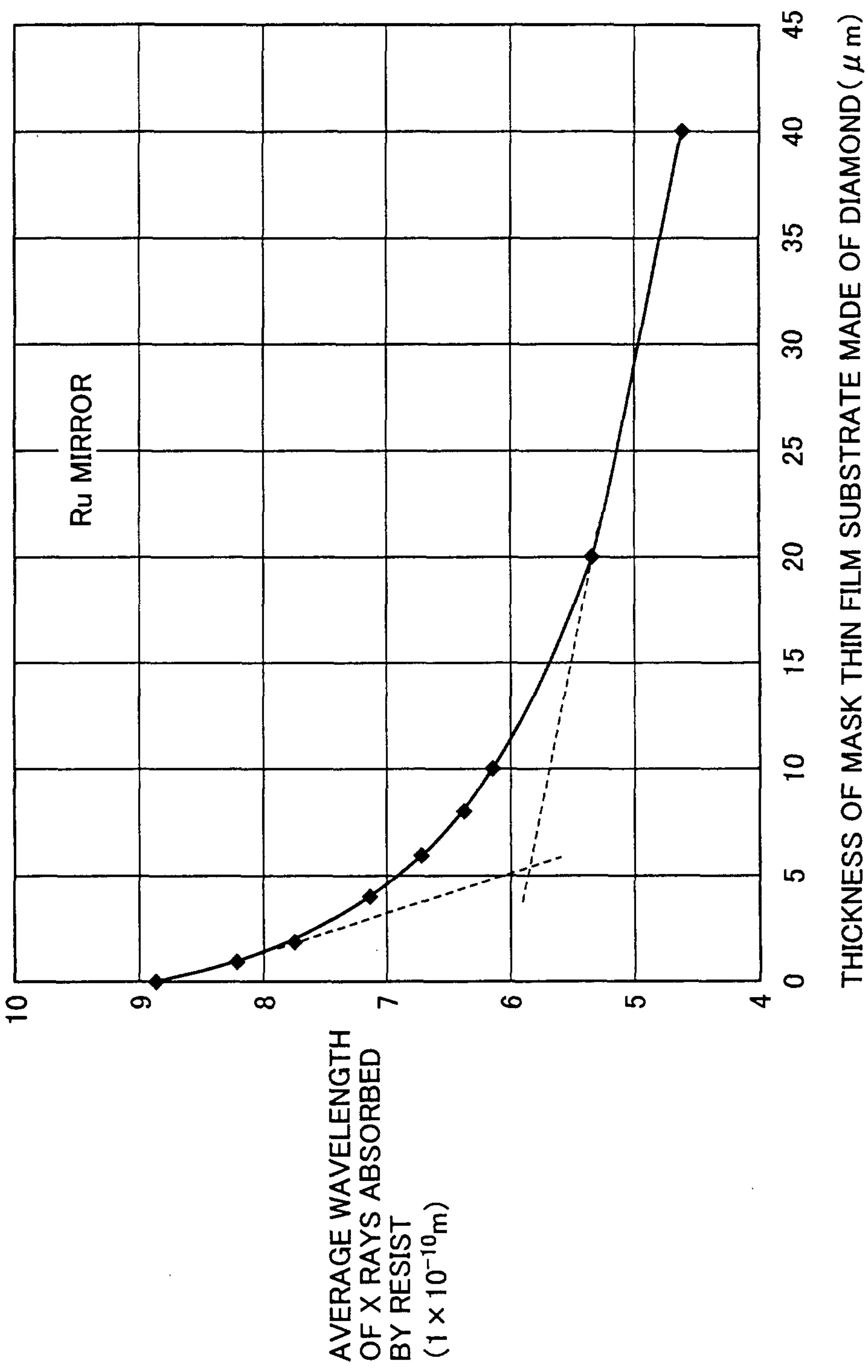
Ru MIRROR
AVERAGE WAVELENGTH OF X RAYS ABSORBED BY RESIST ($1 \times 10^{-10}$m)
THICKNESS OF MASK THIN FILM SUBSTRATE MADE OF DIAMOND ($\mu$m)
10
9
8
7
6
5
4
0
5
10
15
20
25
30
35
40
45

FIG.26

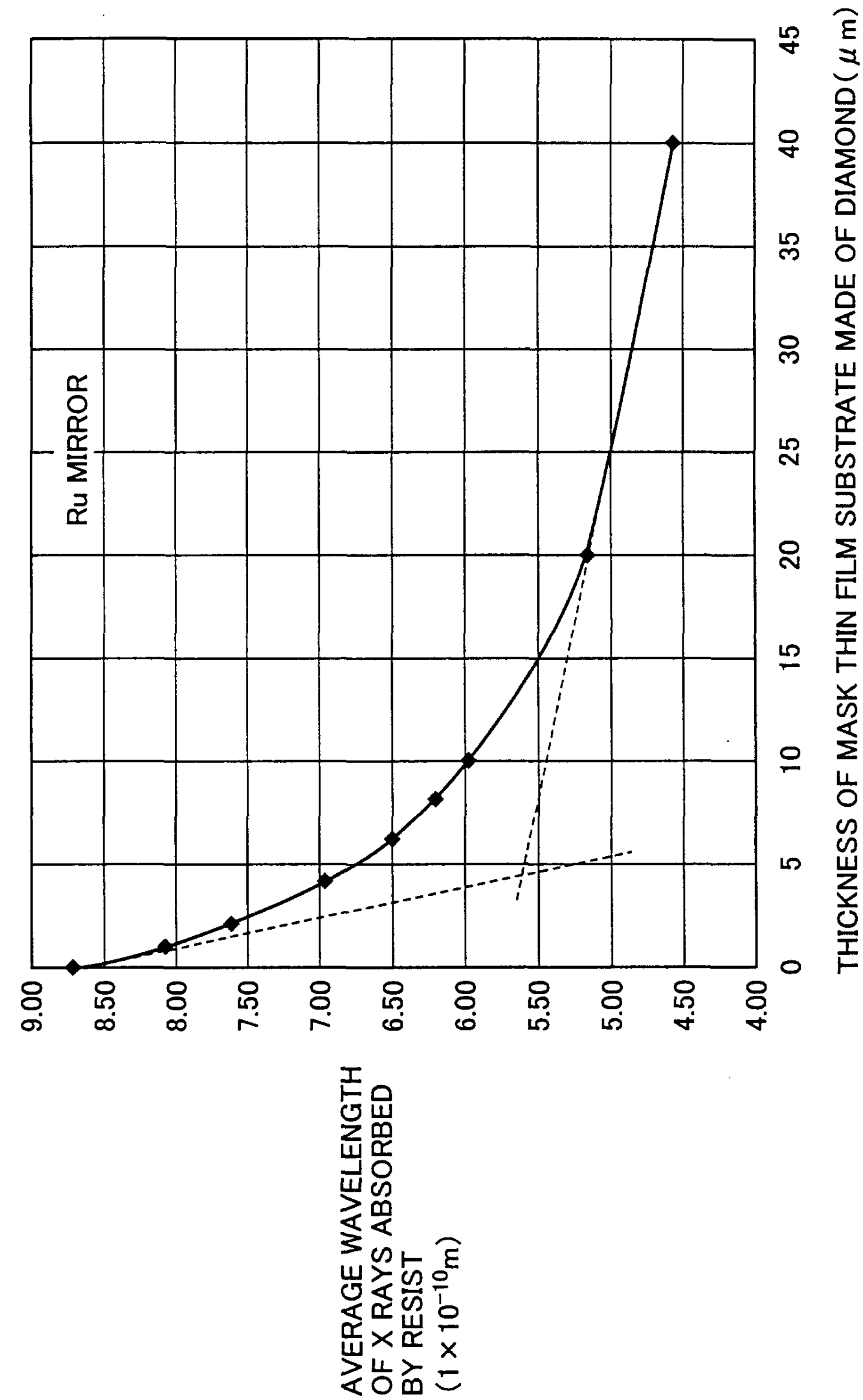
Ru MIRROR
AVERAGE WAVELENGTH OF X RAYS ABSORBED BY RESIST (1 × $10^{-10}$m)
THICKNESS OF MASK THIN FILM SUBSTRATE MADE OF DIAMOND (μm)
9.00
8.50
8.00
7.50
7.00
6.50
6.00
5.50
5.00
4.50
4.00
0
5
10
15
20
25
30
35
40
45

FIG.27

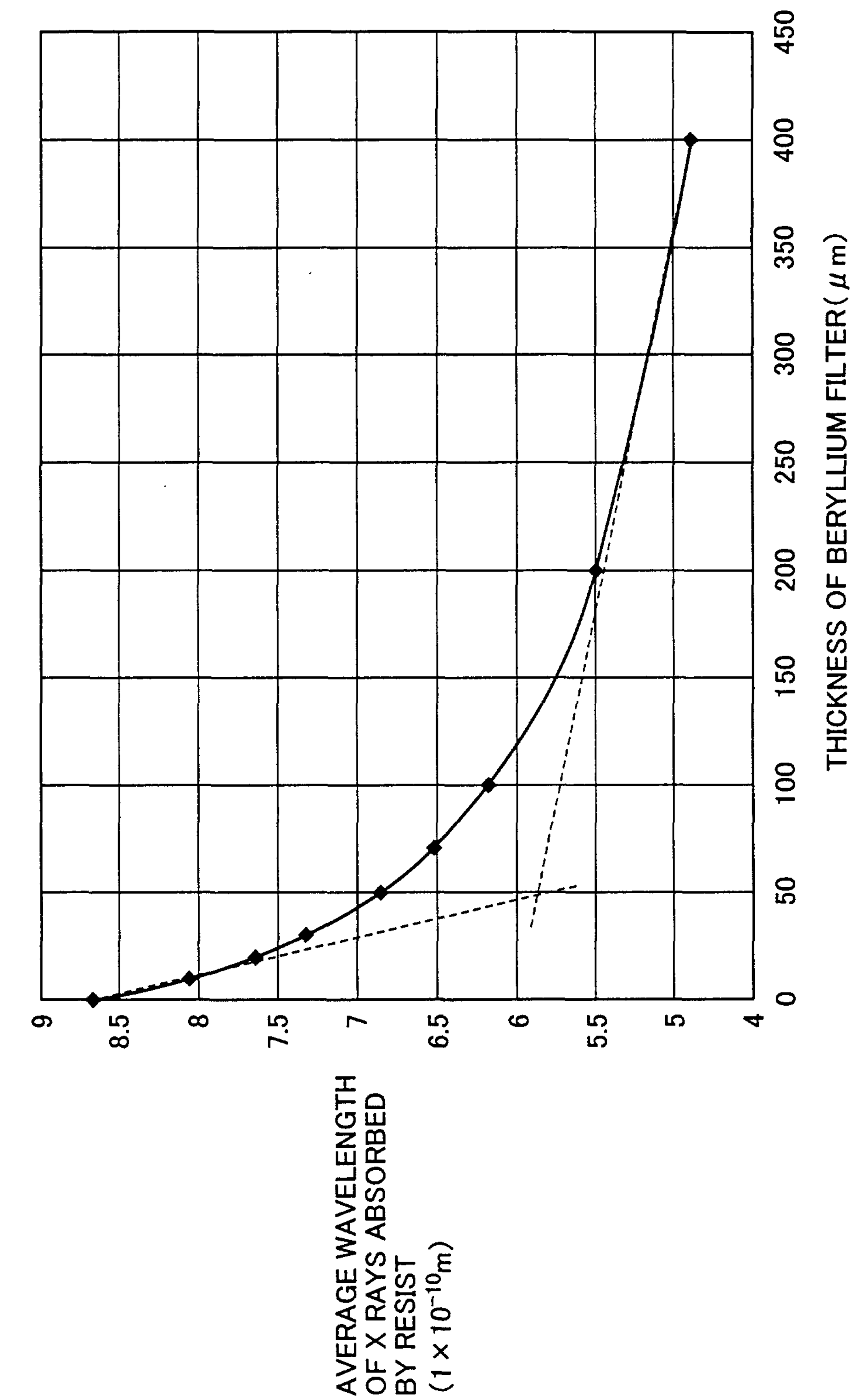
AVERAGE WAVELENGTH
OF X RAYS ABSORBED
BY RESIST
(1×10$^{-10}$m)
9
8.5
8
7.5
7
6.5
6
5.5
5
4
0
50
100
150
200
250
300
350
400
450
THICKNESS OF BERYLLIUM FILTER(μm)

FIG.28

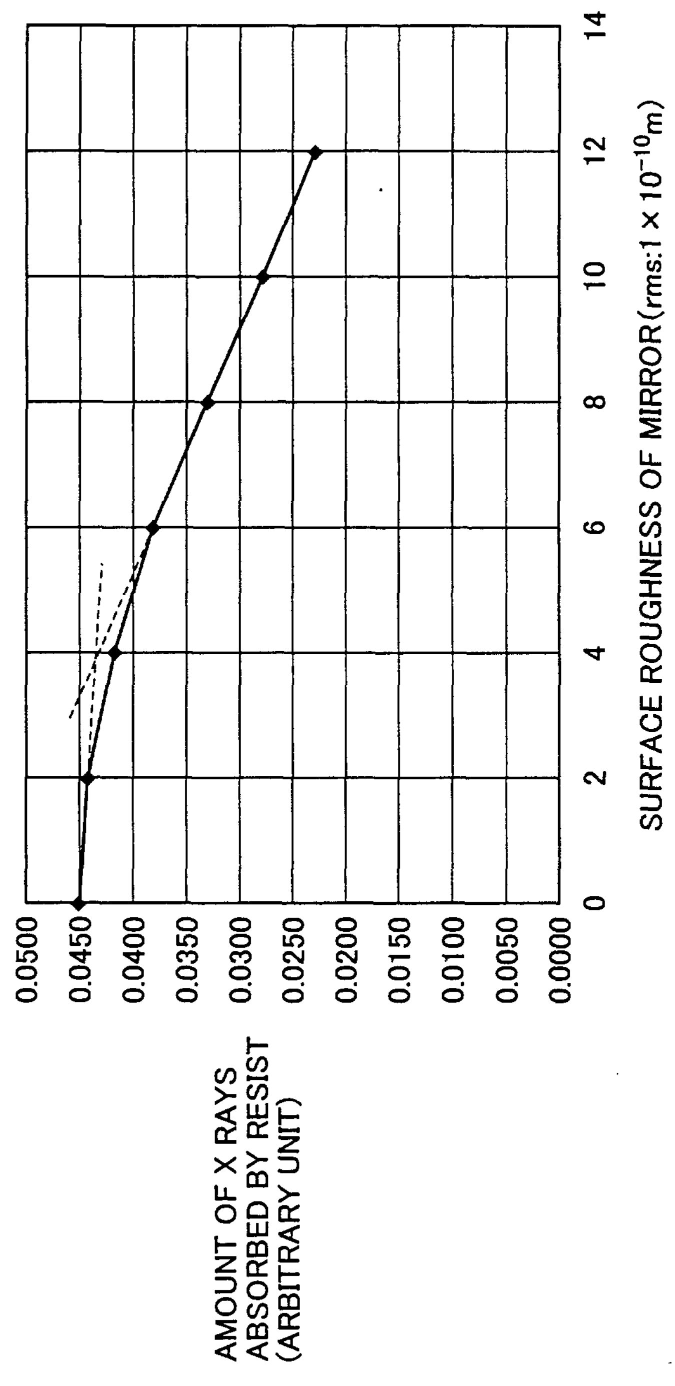
AMOUNT OF X RAYS
ABSORBED BY RESIST
(ARBITRARY UNIT)
0.0500
0.0450
0.0400
0.0350
0.0300
0.0250
0.0200
0.0150
0.0100
0.0050
0.0000
0
2
4
6
8
10
12
14
SURFACE ROUGHNESS OF MIRROR (rms:1 × 10⁻¹⁰m)

FIG.29

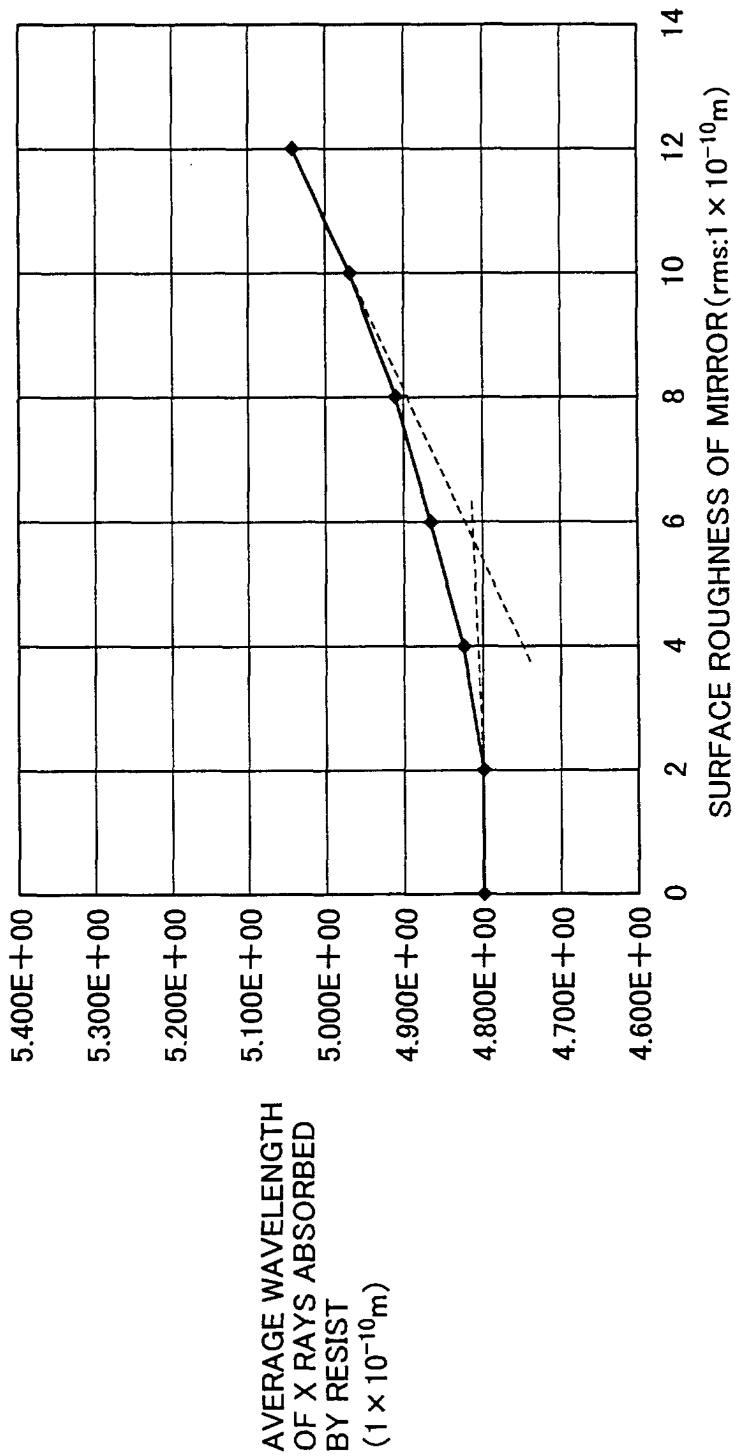
AVERAGE WAVELENGTH OF X RAYS ABSORBED BY RESIST (1 × 10$^{-10}$m)
5.400E+00
5.300E+00
5.200E+00
5.100E+00
5.000E+00
4.900E+00
4.800E+00
4.700E+00
4.600E+00
0
2
4
6
8
10
12
14
SURFACE ROUGHNESS OF MIRROR (rms:1 × 10$^{-10}$m)

FIG.30

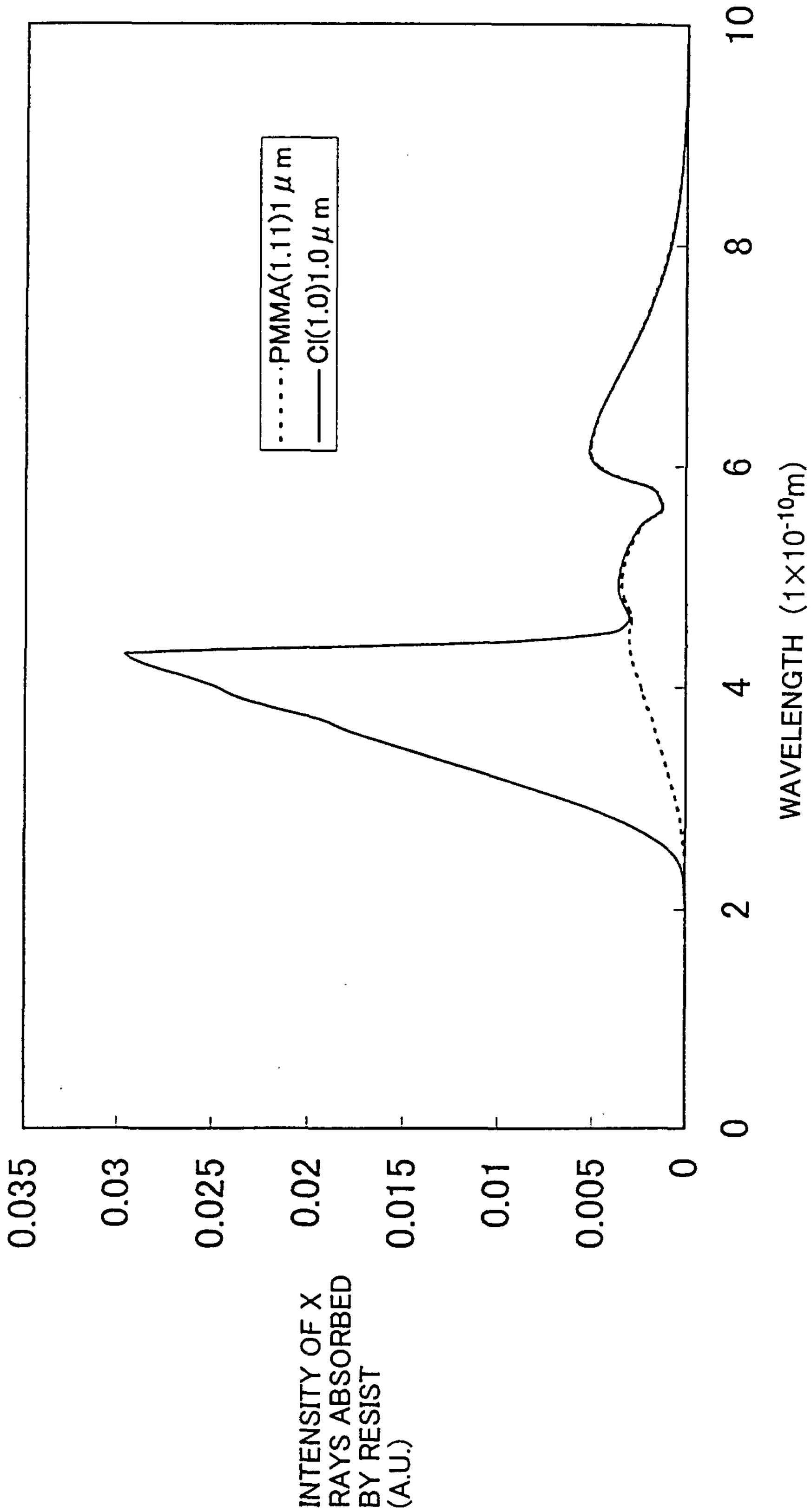
INTENSITY OF X RAYS ABSORBED BY RESIST (A.U.)
0.035
0.03
0.025
0.02
0.015
0.01
0.005
0
0
2
4
6
8
10
WAVELENGTH (1×10$^{-10}$m)
PMMA(1.11)1 μm
CI(1.0)1.0 μm

FIG.31

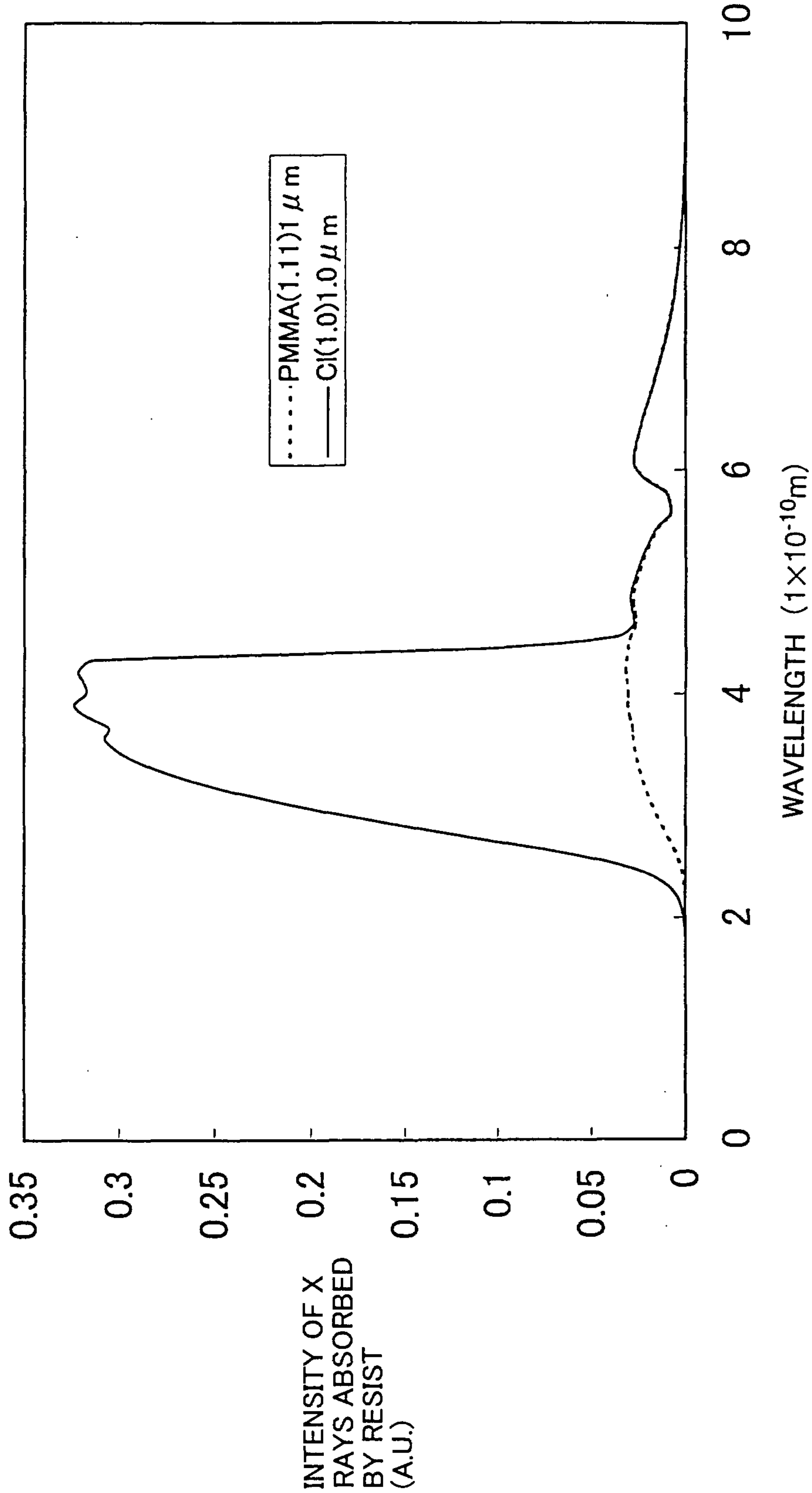
INTENSITY OF X RAYS ABSORBED BY RESIST (A.U.)
0.35
0.3
0.25
0.2
0.15
0.1
0.05
0
0
2
4
6
8
10
WAVELENGTH (1×10^-10 m)
PMMA(1.11)1 μm
CI(1.0)1.0 μm

FIG.32

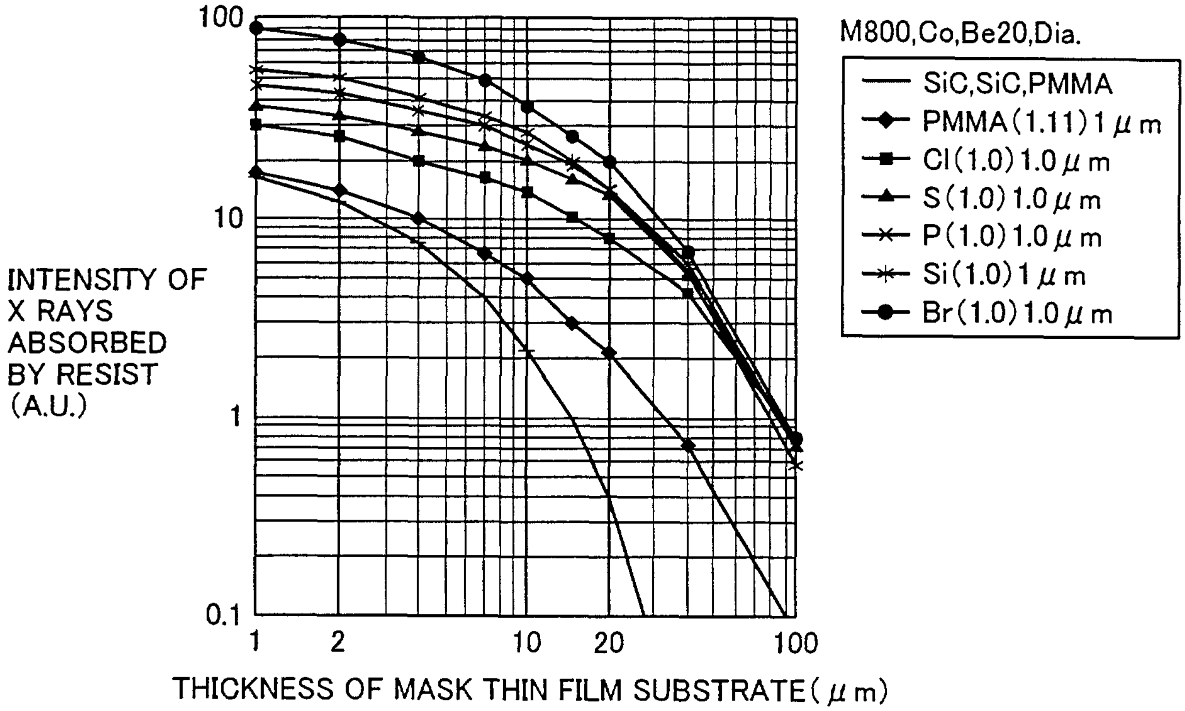
100
10
1
0.1
INTENSITY OF X RAYS ABSORBED BY RESIST (A.U.)
1
2
10
20
100
THICKNESS OF MASK THIN FILM SUBSTRATE (μm)
M800,Co,Be20,Dia.
SiC,SiC,PMMA
PMMA(1.11)1μm
Cl(1.0)1.0μm
S(1.0)1.0μm
P(1.0)1.0μm
Si(1.0)1μm
Br(1.0)1.0μm

FIG.33

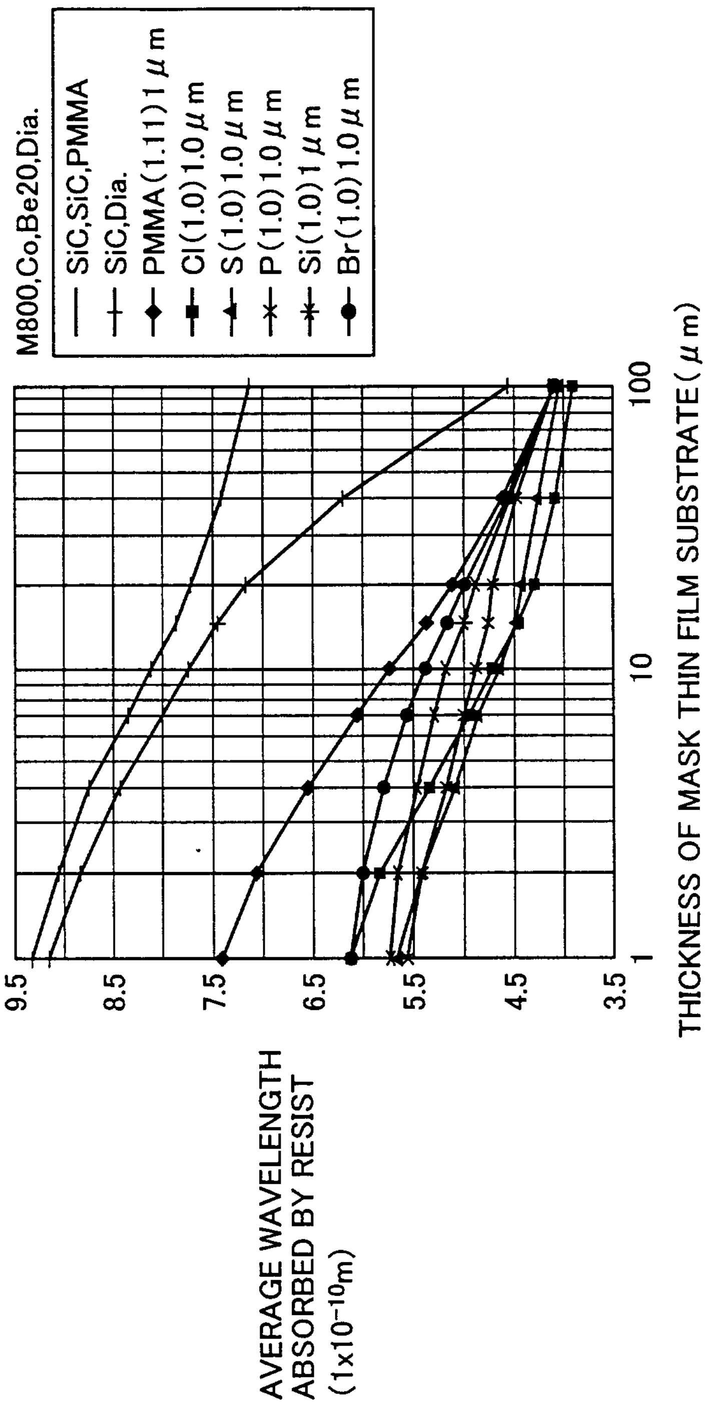
M800,Co,Be20,Dia.
SiC,SiC,PMMA
SiC,Dia.
PMMA(1.11)1 μm
Cl(1.0)1.0 μm
S(1.0)1.0 μm
P(1.0)1.0 μm
Si(1.0)1 μm
Br(1.0)1.0 μm
AVERAGE WAVELENGTH ABSORBED BY RESIST (1x10⁻¹⁰m)
9.5
8.5
7.5
6.5
5.5
4.5
3.5
1
10
100
THICKNESS OF MASK THIN FILM SUBSTRATE(μm)

FIG.34

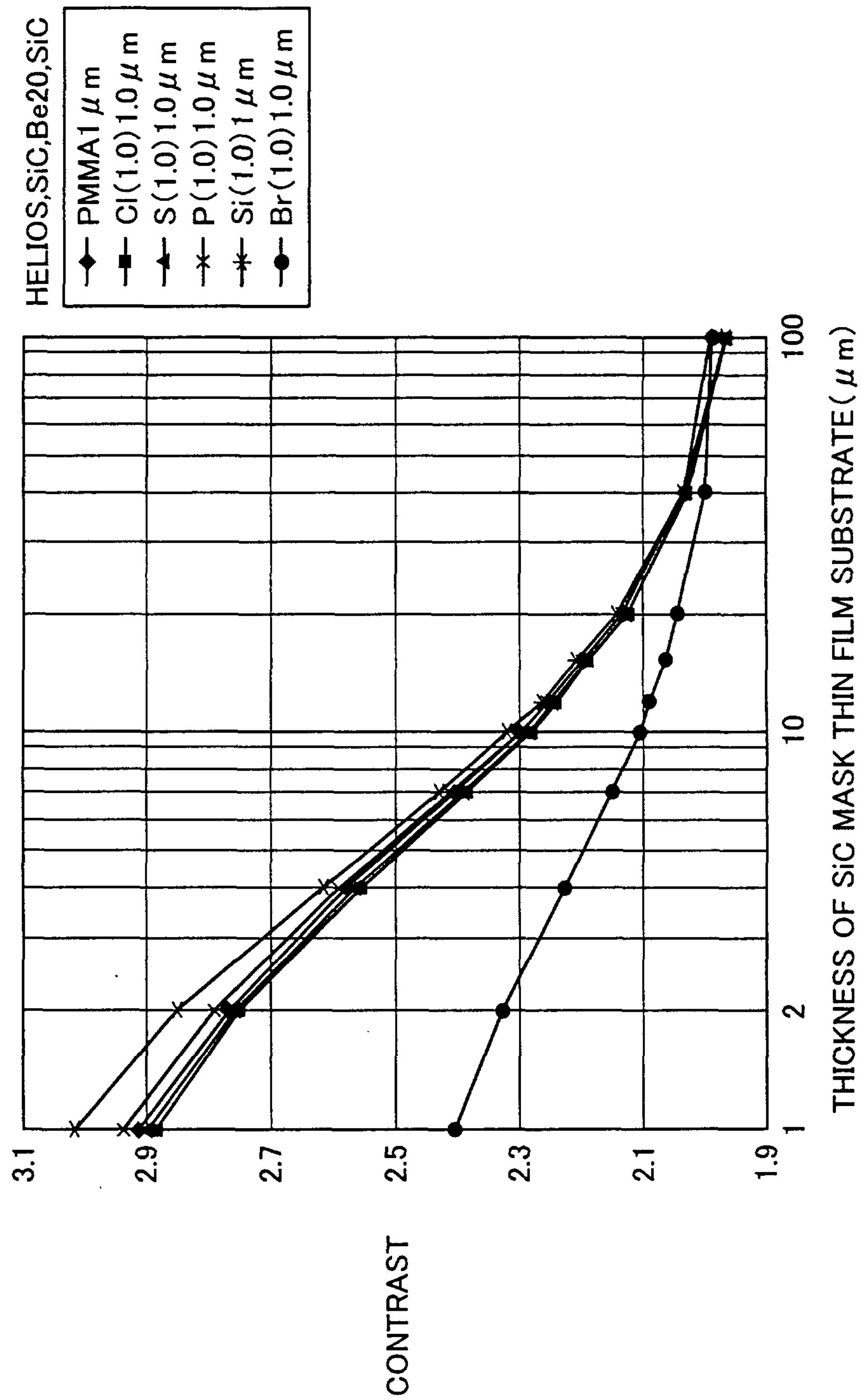
HELIOS,SiC,Be20,SiC
PMMA1 μm
Cl(1.0)1.0 μm
S(1.0)1.0 μm
P(1.0)1.0 μm
Si(1.0)1 μm
Br(1.0)1.0 μm
CONTRAST
3.1
2.9
2.7
2.5
2.3
2.1
1.9
1
2
10
100
THICKNESS OF SiC MASK THIN FILM SUBSTRATE (μm)

FIG.35

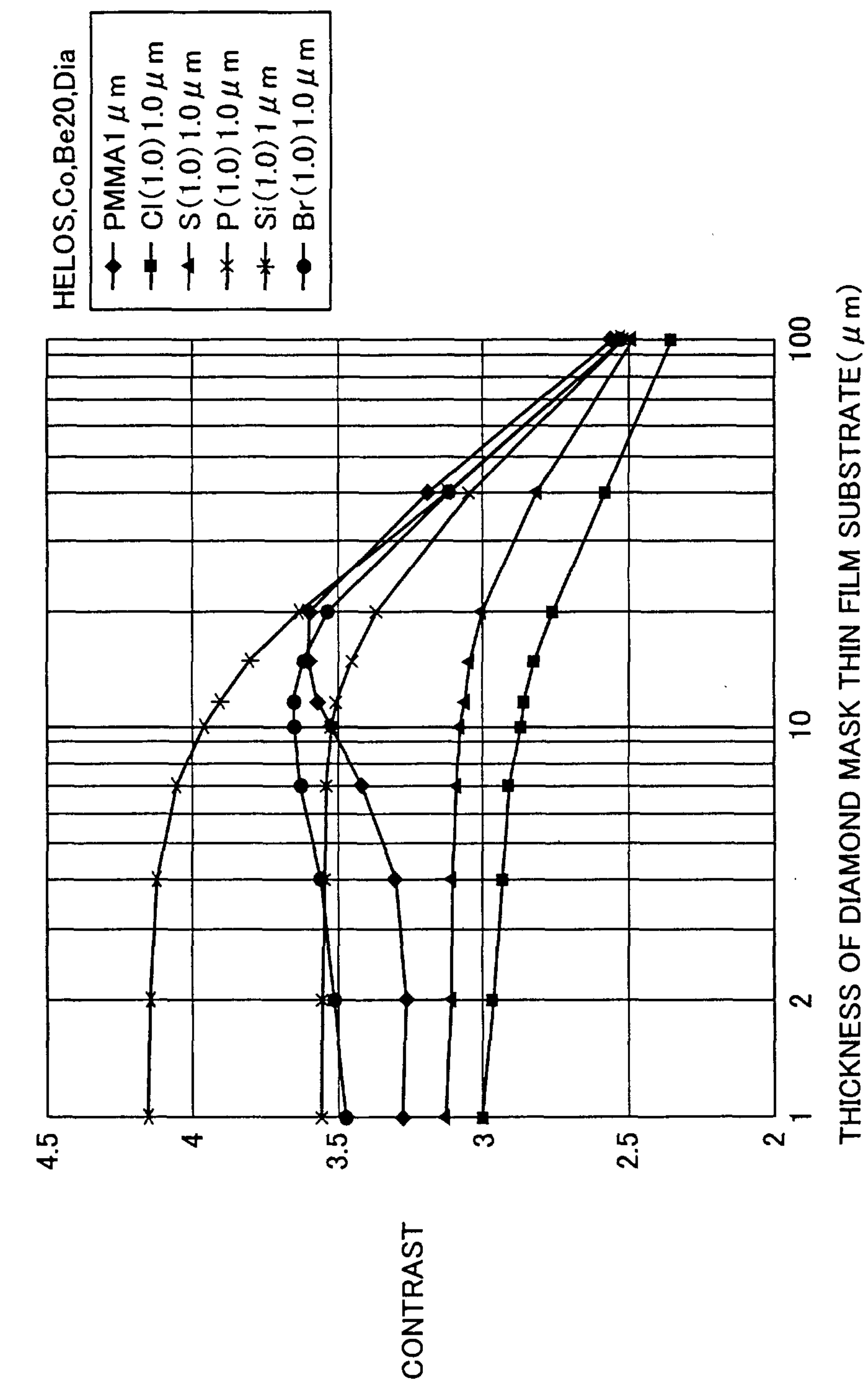
CONTRAST
4.5
4
3.5
3
2.5
2
1
2
10
100
THICKNESS OF DIAMOND MASK THIN FILM SUBSTRATE ( μ m)
HELOS,Co,Be20,Dia
PMMA1 μ m
Cl(1.0)1.0 μ m
S(1.0)1.0 μ m
P(1.0)1.0 μ m
Si(1.0)1 μ m
Br(1.0)1.0 μ m

FIG.36

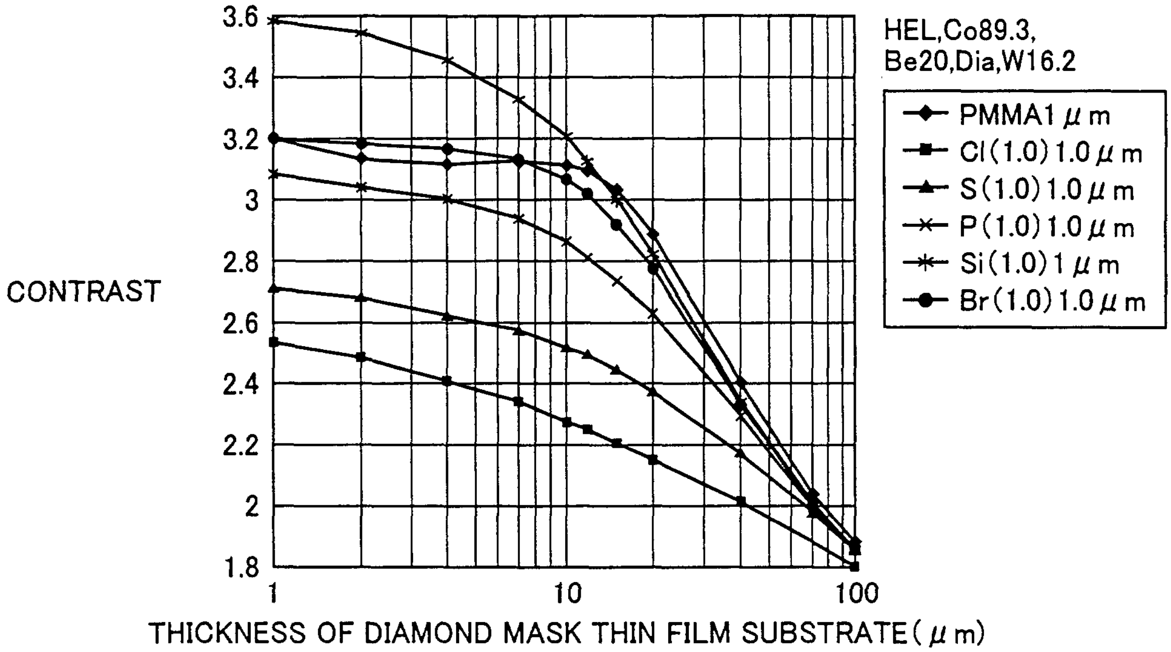
HEL,Co89.3,
Be20,Dia,W16.2
PMMA1 μm
Cl(1.0)1.0 μm
S(1.0)1.0 μm
P(1.0)1.0 μm
Si(1.0)1 μm
Br(1.0)1.0 μm
CONTRAST
3.6
3.4
3.2
3
2.8
2.6
2.4
2.2
2
1.8
1
10
100
THICKNESS OF DIAMOND MASK THIN FILM SUBSTRATE(μm)

FIG.37

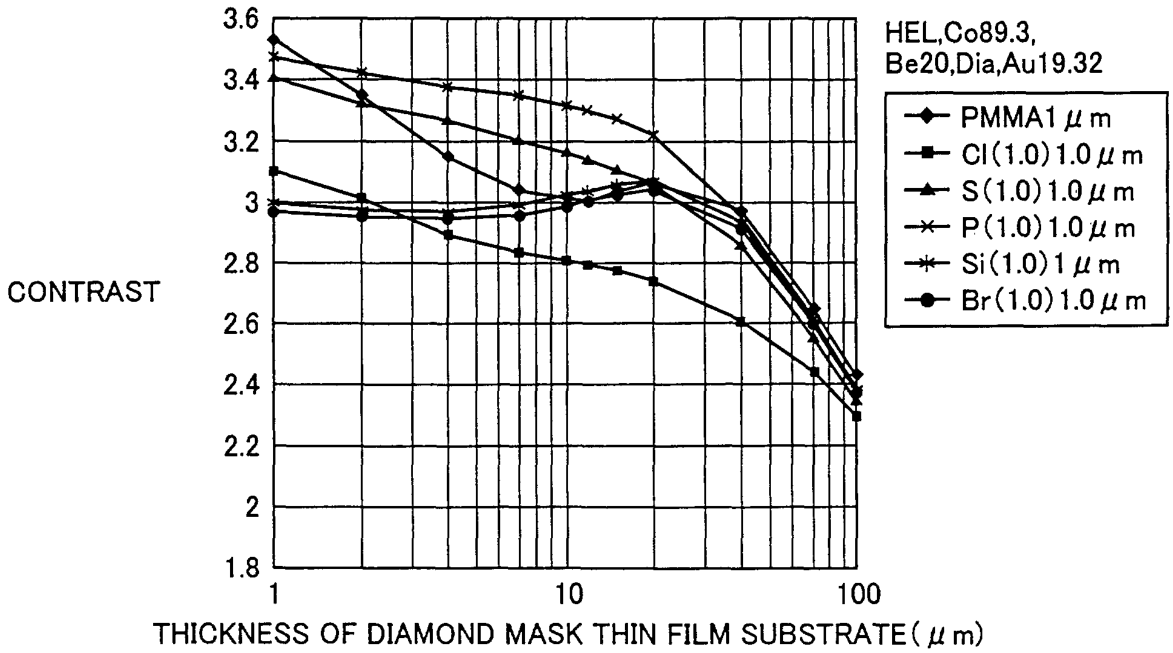
HEL,Co89.3,
Be20,Dia,Au19.32
PMMA1 μm
Cl(1.0)1.0 μm
S(1.0)1.0 μm
P(1.0)1.0 μm
Si(1.0)1 μm
Br(1.0)1.0 μm
CONTRAST
3.6
3.4
3.2
3
2.8
2.6
2.4
2.2
2
1.8
1
10
100
THICKNESS OF DIAMOND MASK THIN FILM SUBSTRATE(μm)

FIG.38

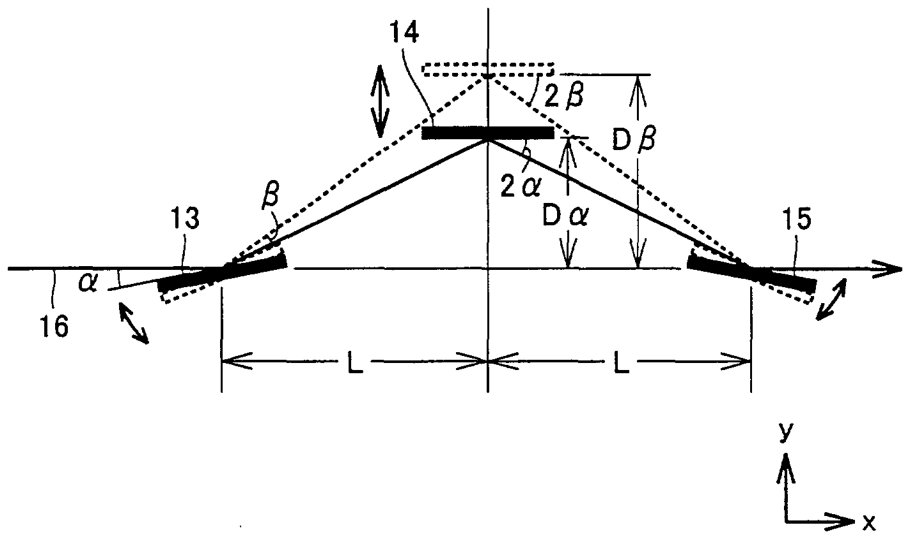


FIG.39

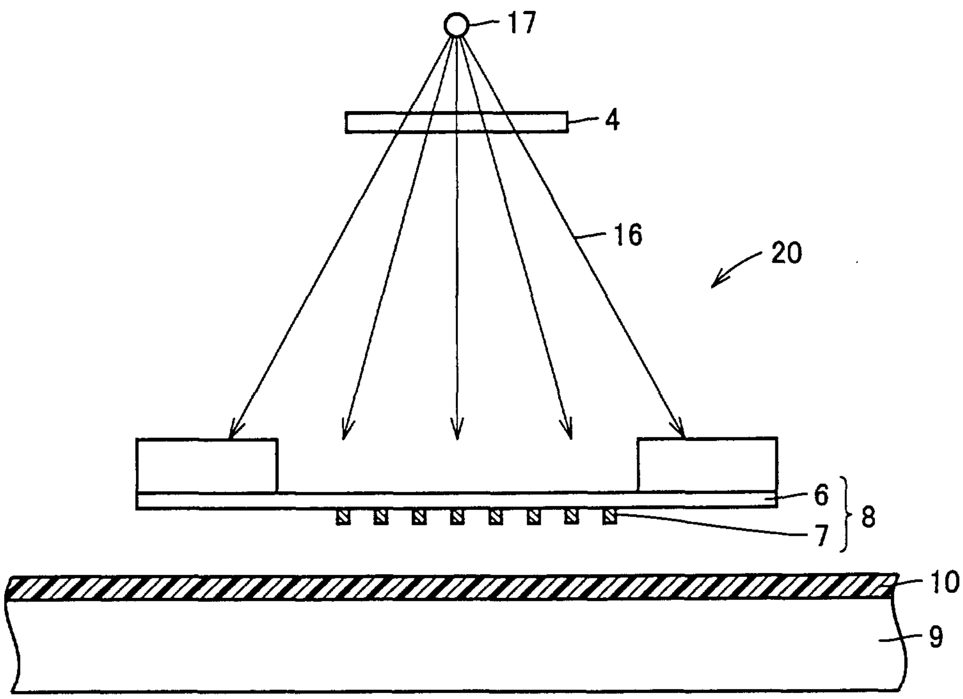

FIG.40

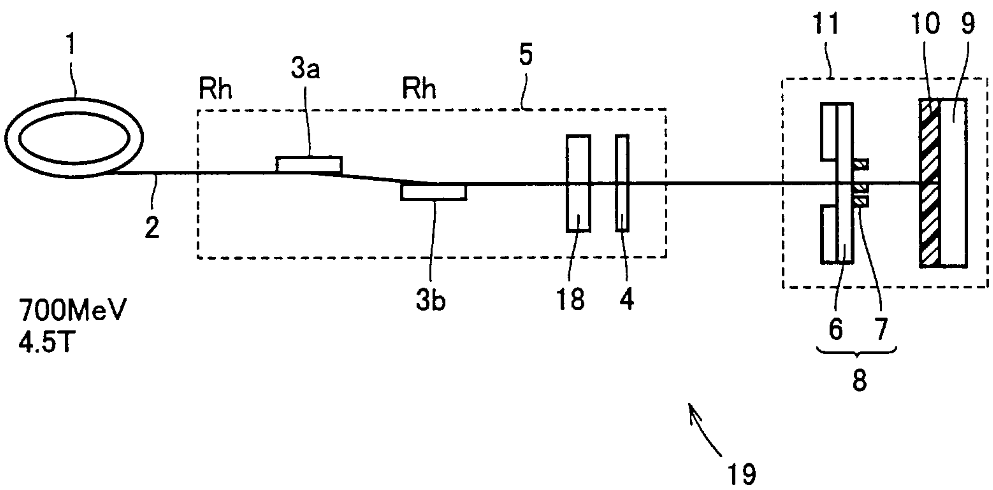

FIG.41

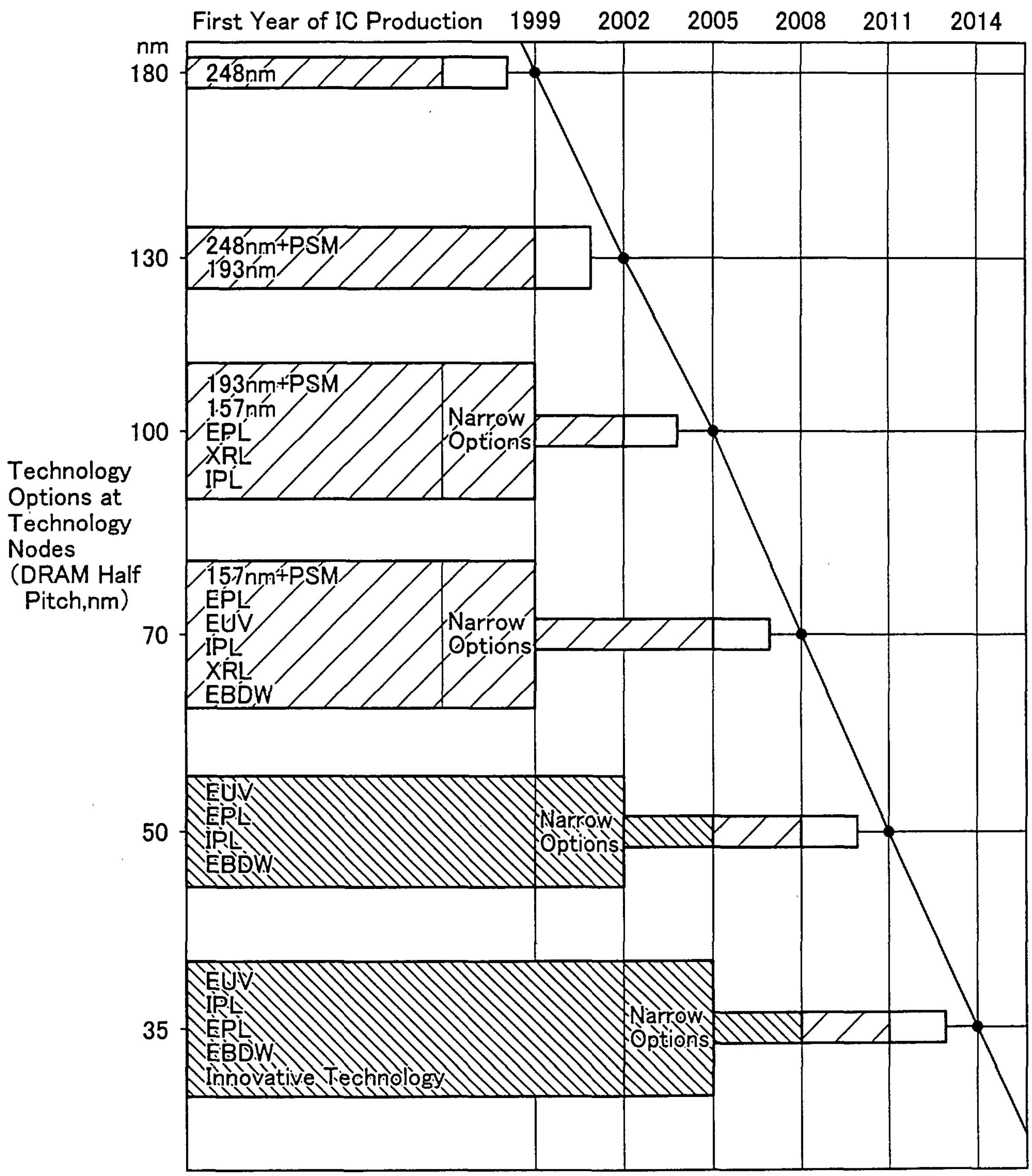
First Year of IC Production
1999
2002
2005
2008
2011
2014
nm
180
130
100
70
50
35
Technology Options at Technology Nodes (DRAM Half Pitch,nm)
248nm
248nm+PSM
193nm
193nm+PSM
157nm
EPL
XRL
IPL
Narrow Options
157nm+PSM
EPL
EUV
IPL
XRL
EBDW
Narrow Options
EUV
EPL
IPL
EBDW
Narrow Options
EUV
IPL
EPL
EBDW
Innovative Technology
Narrow Options

FIG.42

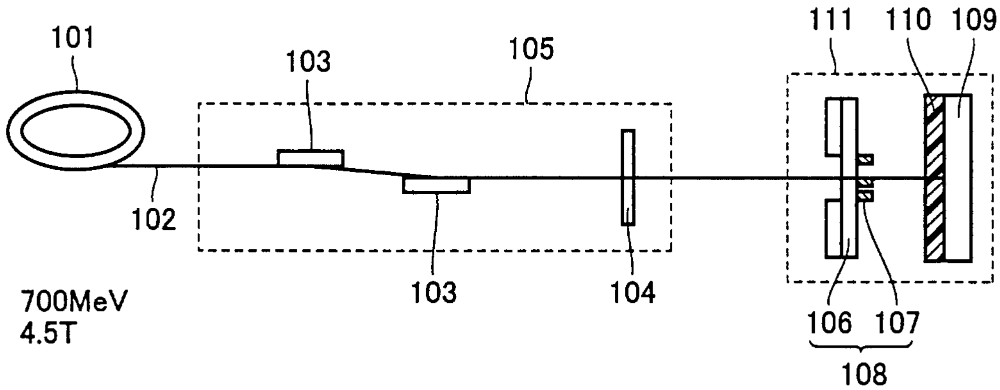

FIG.43

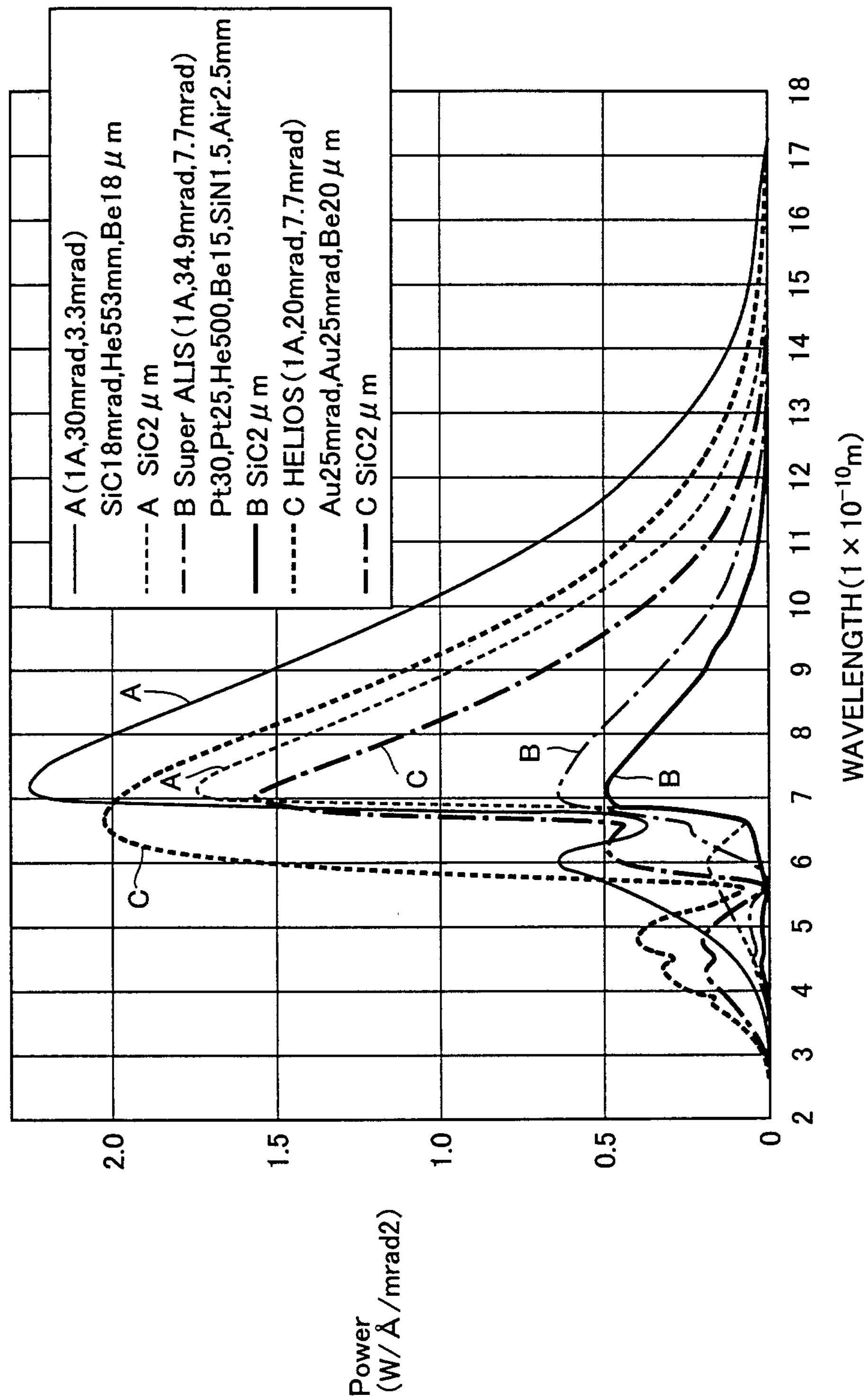
A(1A,30mrad,3.3mrad)
SiC18mrad,He553mm,Be18 μm
A SiC2 μm
B Super ALIS(1A,34.9mrad,7.7mrad)
Pt30,Pt25,He500,Be15,SiN1.5,Air2.5mm
B SiC2 μm
C HELIOS(1A,20mrad,7.7mrad)
Au25mrad,Au25mrad,Be20 μm
C SiC2 μm
Power
(W/ Å /mrad2)
2.0
1.5
1.0
0.5
0
A
A
B
B
C
C
2
3
4
5
6
7
8
9
10
11
12
13
14
15
16
17
18
WAVELENGTH(1×10$^{-10}$m)

FIG.44

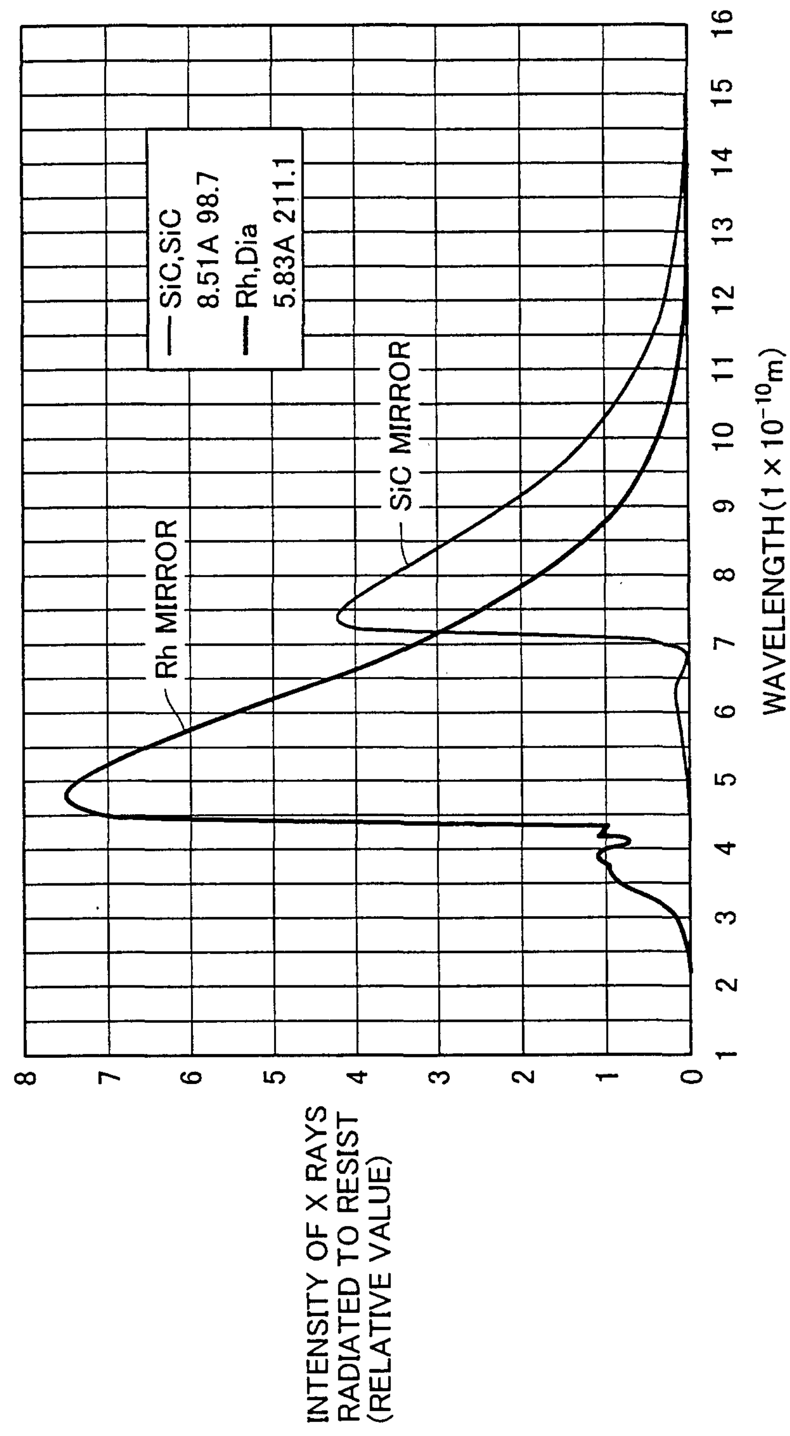
INTENSITY OF X RAYS RADIATED TO RESIST (RELATIVE VALUE)
WAVELENGTH($1 \times 10^{-10}$m)
SiC,SiC
8.51A 98.7
Rh,Dia
5.83A 211.1
Rh MIRROR
SiC MIRROR
0
1
2
3
4
5
6
7
8
9
10
11
12
13
14
15
16

FIG.45

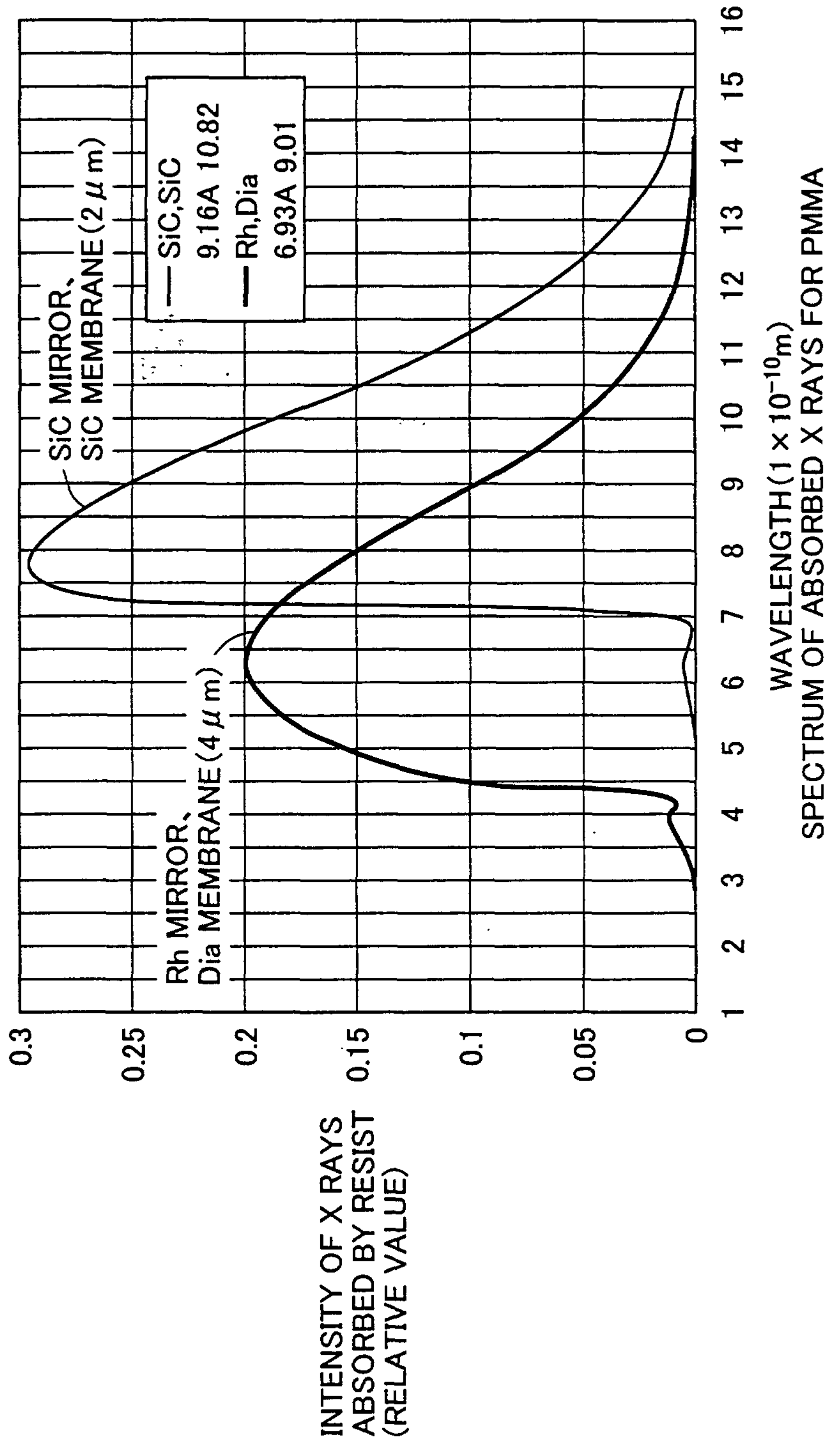
SiC MIRROR,
SiC MEMBRANE (2 μ m)
Rh MIRROR,
Dia MEMBRANE (4 μ m)
SiC,SiC
9.16A 10.82
Rh,Dia
6.93A 9.01
0.3
0.25
0.2
0.15
0.1
0.05
0
1
2
3
4
5
6
7
8
9
10
11
12
13
14
15
16
INTENSITY OF X RAYS
ABSORBED BY RESIST
(RELATIVE VALUE)
WAVELENGTH (1 × 10⁻¹⁰m)
SPECTRUM OF ABSORBED X RAYS FOR PMMA